# EUROPEAN PATENT SPECIFICATION

(11) **EP 3 268 990 B1**
(45) Date of publication and mention of the grant of the patent: **21.12.2022**
(21) Application number: 16709829.2
(22) Date of filing: 26.02.2016
(51) Int. Cl.: H01L 21/683, H01L 21/768, H01L 23/04, H01L 23/08, H01L 23/48, H01L 23/00, H01L 27/146

(54) **IMAGING DEVICE, MANUFACTURING METHOD, AND ELECTRONIC DEVICE**
BILDGEBUNGSVORRICHTUNG, VERFAHREN ZUR HERSTELLUNG UND ELEKTRONISCHE VORRICHTUNG
DISPOSITIF D'IMAGERIE, PROCÉDÉ DE FABRICATION ET DISPOSITIF ÉLECTRONIQUE

(30) Priority: 12.03.2015 JP 2015049719; 24.08.2015 JP 2015164465
(43) Date of publication of application: 17.01.2018
(73) Proprietor: Sony Group Corporation, Tokyo 108-0075 (JP)
(72) Inventor: WAKIYAMA, Satoru, Tokyo 108-0075 (JP); TAGAWA, Yukio, Tokyo 108-0075 (JP)
(74) Representative: MFG Patentanwälte Meyer-Wildhagen Meggle-Freund Gerhard PartG mbB
(86) International application number: PCT/JP2016/001047
(87) International publication number: WO 2016/143288

(56) References cited:
- EP-A2- 2 571 056
- US-A1- 2006 043 438
- US-A1- 2006 197 007
- US-A1- 2010 187 677
- US-A1- 2010 264 503
- US-A1- 2011 233 702
- US-A1- 2012 044 415
- US-A1- 2013 321 680
- US-A1- 2015 056 738

## Description

### Technical Field

The present technology relates to a solid-state image capturing device, a manufacturing method, and an electronic device, and particularly to a solid-state image capturing device, a manufacturing method, and an electronic device for providing a small solid-state image capturing device in a simpler manner.

### Background Art

In the past, there is known a solid-state image capturing device including a pixel section that photoelectrically converts an incoming light and a peripheral circuit unit that performs signal processing. In this solid-state image capturing device, the size of the pixel section is almost fixed by an optical system of a product mounted in the solid-state image capturing device, whereas the peripheral circuit unit is scaled as the process generation evolves, so as to reduce its size and cost.

Also, processing steps include many steps that are performed only for the pixel section as well as steps that are performed only for the peripheral circuit unit. Hence, it is possible that the solid-state image capturing device is manufactured at a lower cost, by manufacturing the pixel section and the peripheral circuit unit on different wafers, which are diced into individual semiconductor elements of their respective optimal sizes, and stacking and joining the semiconductor elements together.

As described above, as a solid-state image capturing device in which the pixel section and the peripheral circuit unit are divided into different elements and the chip on chip (CoC) stacking technology is applied, there is proposed a flip chip structure in which a peripheral circuit semiconductor element of a peripheral circuit unit is mounted on a region outside pixels on a light receiving surface of a sensor semiconductor element for configuring a front side illuminated sensor, (for example, refer to Patent Literature 1).

Also, there is proposed a solid-state image capturing device having a structure that stacks a sensor semiconductor element for configuring a back side illuminated sensor having an electrode on the opposite surface to a light receiving surface, on a peripheral circuit semiconductor element, (for example, refer to Patent Literature 2 and Patent Literature 3).

US 2015/056738 A1 discloses an image sensor and more particularly, to a method of manufacturing an image sensor that may enhance an optical characteristic of a pixel when a bottom emission process is not used.

US 2012/ 044415 A1 discloses an image pickup module and a camera in which the light receiving surface of the image pickup device chip including through-hole electrodes has a good flatness and which can obtain a high quality image.

US 2010/264503 A1 discloses a solid-state imaging device comprising a through-electrode formed on a semiconductor substrate, for example, a camera module.

EP 2 571 056 A2 discloses an apparatus and a method for utilizing and creating a dual-facing camera assembly.

US 2013/321680 A1 discloses a semiconductor device constitutes an image sensing device (a solid-state image sensing device). The semiconductor device includes a first member and a second member. The first member includes an image sensing region that includes an array of photoelectric conversion elements. The second member includes a signal processing region that processes a signal obtained by the image sensing region.

US 2011/233702 A1 discloses a semiconductor device including a first material layer adjacent to a second material layer, a first via passing through the first material layer and extending into the second material layer, and a second via extending into the first material layer, where along a common cross section parallel to an interface between the two material layers, the first via has a cross section larger than that of the second via.

US 2006/197007 A1 discloses a solid-state image pickup device and more particularly to a back-illuminated type CMOS (complementary metal-oxide semiconductor) solid-state image pickup device in which incident light is introduced from the back side of a substrate, an electronic apparatus using such solid-state image pickup device and a method of manufacturing such solid-state image pickup device.

US 2010/187677 A1 discloses a wafer level package, and a method of manufacturing the wafer level package, in which the posts that connect the package to the board are highly resistant to stresses, especially lateral shear stresses.

As described above, in the solid-state image capturing device, there are proposed a structure thai stacks a peripheral circuit semiconductor element on a light receiving surface side of a sensor semiconductor element, as well as a structure that stacks a peripheral circuit semiconductor element on a non-light-receiving surface of a sensor semiconductor element, as the CoC stack structure of the sensor semiconductor element and the peripheral circuit semiconductor element.

### Citation List

### Patent Literature

Patent Literature 1: JP 2010-54799A
Patent Literature 2: JP 5083272B
Patent Literature 3: JP 4940667B

### Summary of Invention

### Technical Problem

However, in the technology described above, it is difficult to obtain a small solid-state image capturing device in a simpler manner.

For example, as for the structure that stacks the peripheral circuit semiconductor element at the light receiving surface side of the sensor semiconductor element, a region for stacking a peripheral circuit, semiconductor element is prepared outside a region of a pixel section that performs photoelectric conversion. In this case, when the sensor semiconductor element is of the front side illumination type, a circuit can be located in the region of the lower side of the peripheral circuit semiconductor element mounting part in the sensor semiconductor element.

However, when the sensor semiconductor element is of the back side illumination type, and a via penetrating a semiconductor layer and connecting a line of the sensor semiconductor element and an electrode of a connection portion of the peripheral circuit semiconductor element is formed directly below a peripheral circuit semiconductor element mounting portion in the sensor semiconductor element, the via part becomes a via dedicated region in which a circuit is not allowed to be located. In this case, the via dedicated region is to be prepared additionally in the sensor semiconductor element, and therefore a small solid-state image capturing device is not obtained. and it is disadvantageous for cost reduction.

Also, in the structure that stacks the peripheral circuit semiconductor element on the non-light-receiving surface of the sensor semiconductor element of the back side illumination type, that is, the surface of the opposite side to the light receiving surface, the peripheral circuit semiconductor element can be locate below the pixel section region of the sensor semiconductor element in order to reduce the size of the sensor semiconductor element.

However, in this case, a support substrate is to be provided on the sensor semiconductor element to secure sufficient strength, and therefore it is difficult to form a penetration via for drawing out an inter-semiconductor-element connection electrode that connects the sensor semiconductor element and the peripheral circuit semiconductor element, in the support substrate, after thinning the support substrate provided at the non-light-receiving surface side of the sensor semiconductor element. That is, the process for forming a penetration via in the support substrate is difficult, and the diameter of the penetration via becomes large.

The present technology is made in view of the above situation, in order to obtain a small solid-state image capturing device in a simpler manner.

### Solution to Problem

According to an embodiment of the present technology, there is provided a back-side illuminated solid-state image capturing device as defined in appended claim 1.

According to another embodiment of the present technology, there is provided a method of manufacturing a back-side illuminated solid-state image capturing device as defined in appended claim 5.

It is noted that the claimed invention relates to the back-side illuminated solid-state image capturing device and the method of manufacturing a back-side illuminated solid-state image capturing device described in relation to FIGS. 1 to 23. Accordingly, any reference in the description to an embodiment, example or aspect in the context of FIGS. 24 to 59 should be understood as a reference to an example that is provided as useful for understanding the claimed invention but without being covered by the scope of the claims. FIGS. 60 and 61 are examples being useful to understand the present invention.

### Advantageous Effects of Invention

According to the first to third embodiments of the present technology, a small solid-state image capturing device is obtained in a simpler manner.

### Brief Description of Drawings

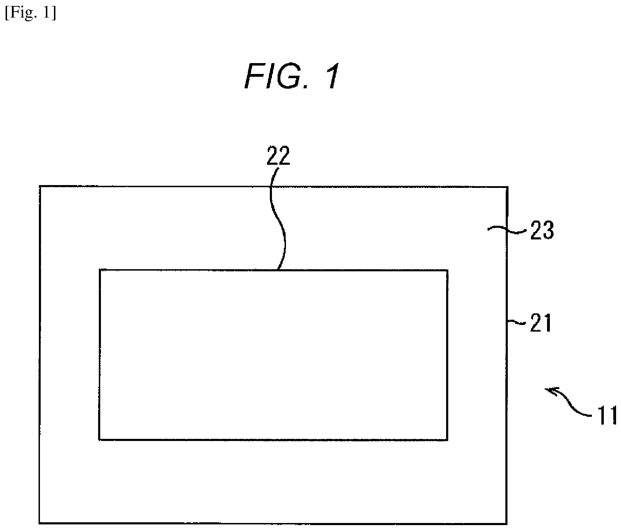

[fig. 1] Fig. 1 is a diagram illustrating an exemplary configuration of a solid-state image capturing device.

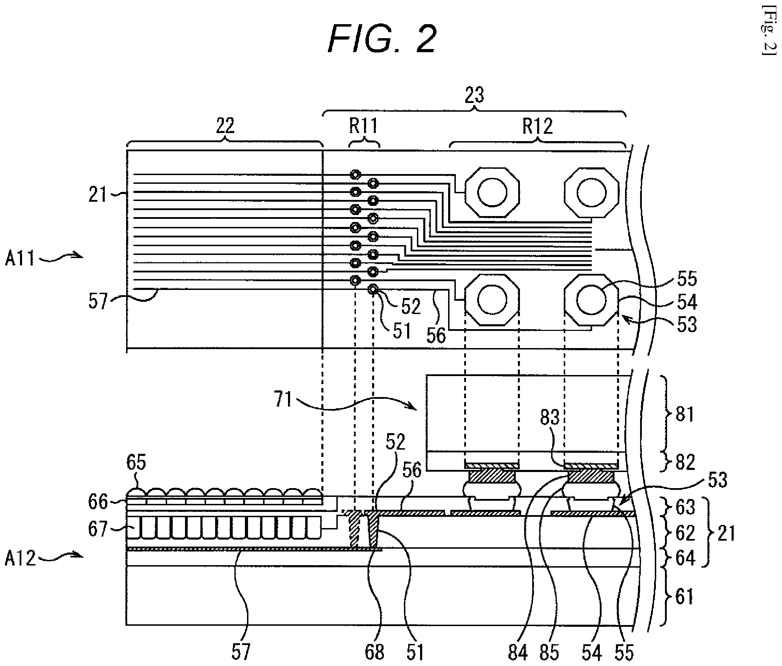

[fig.2] Fig. 2 is a diagram illustrating a more detailed exemplary configuration of a solid-state image capturing device.

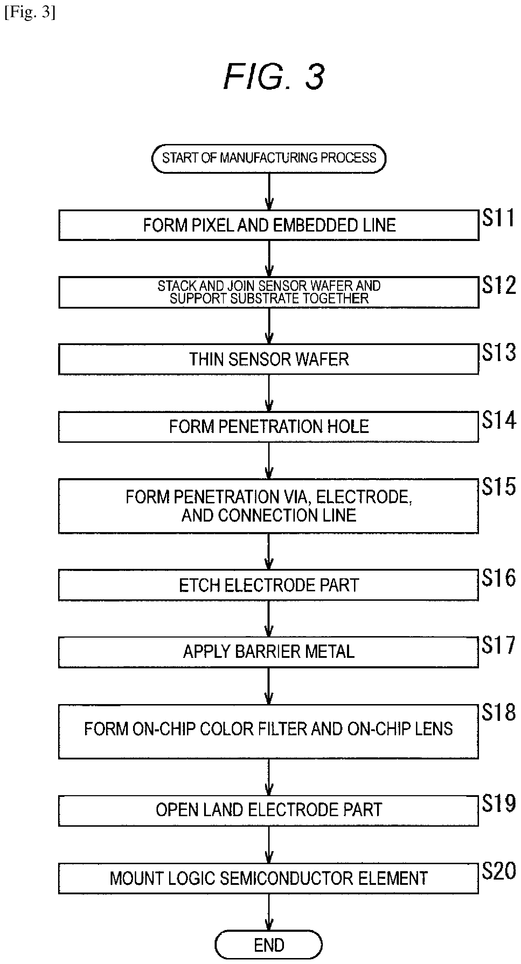

[fig.3] Fig. 3 is a flowchart for describing a manufacturing process.

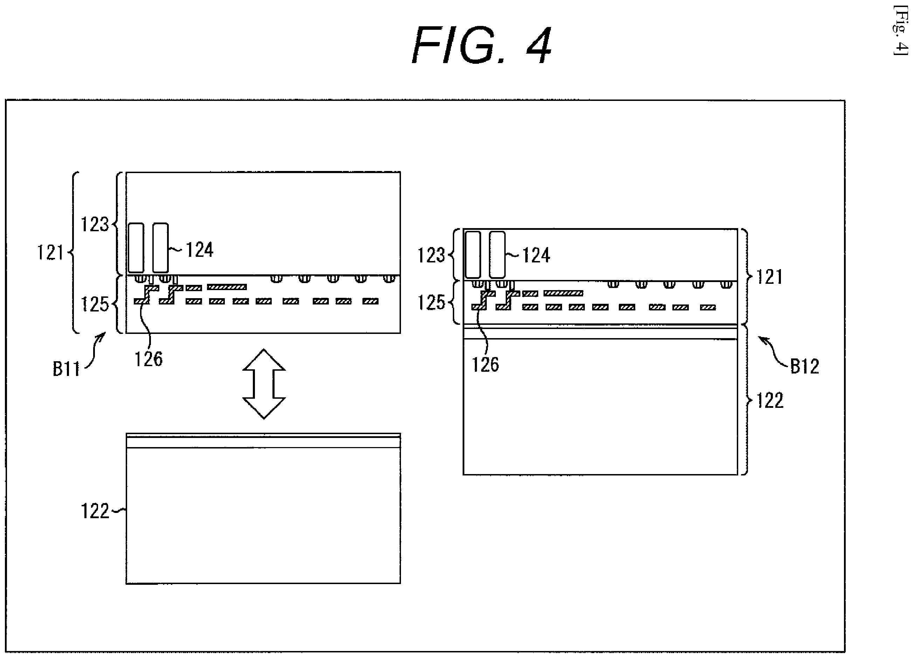

[fig.4] Fig. 4 is a diagram for describing a production process of a solid-state image capturing device.

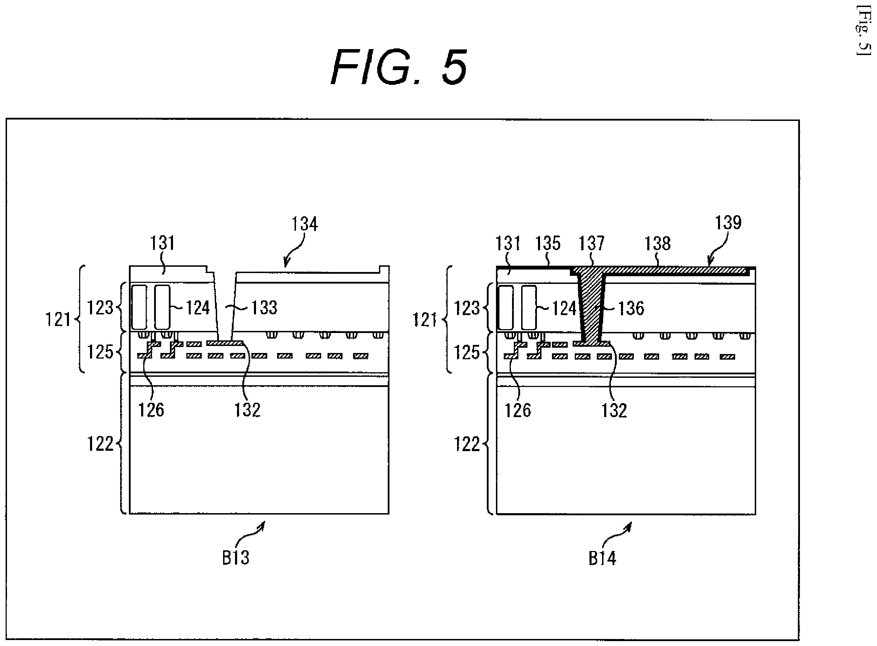

[fig.5] Fig. 5 is a diagram for describing a production process of a solid-state image capturing device.

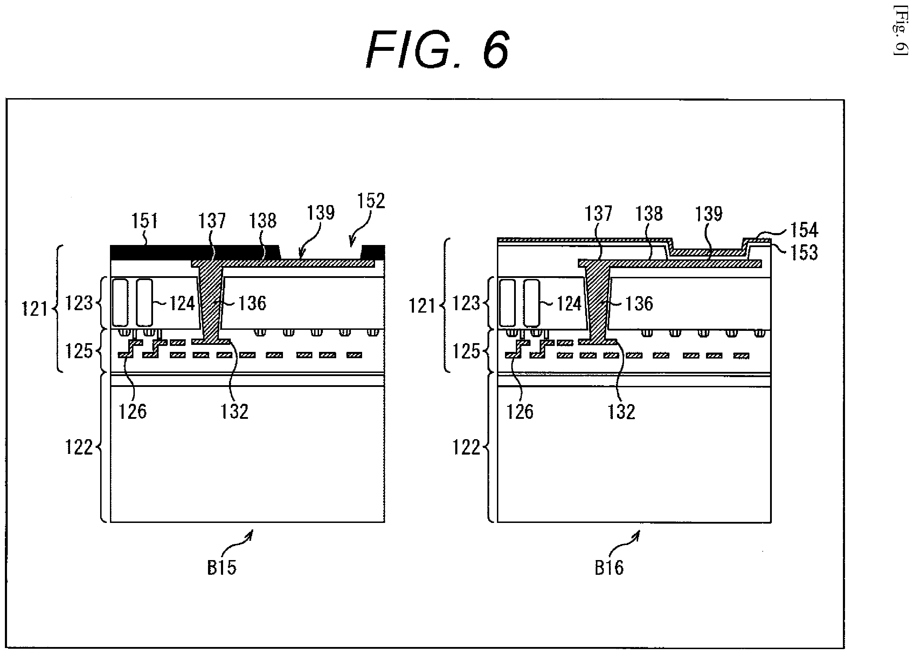

[fig.6] Fig. 6 is a diagram for describing a production process of a solid-state image capturing device.

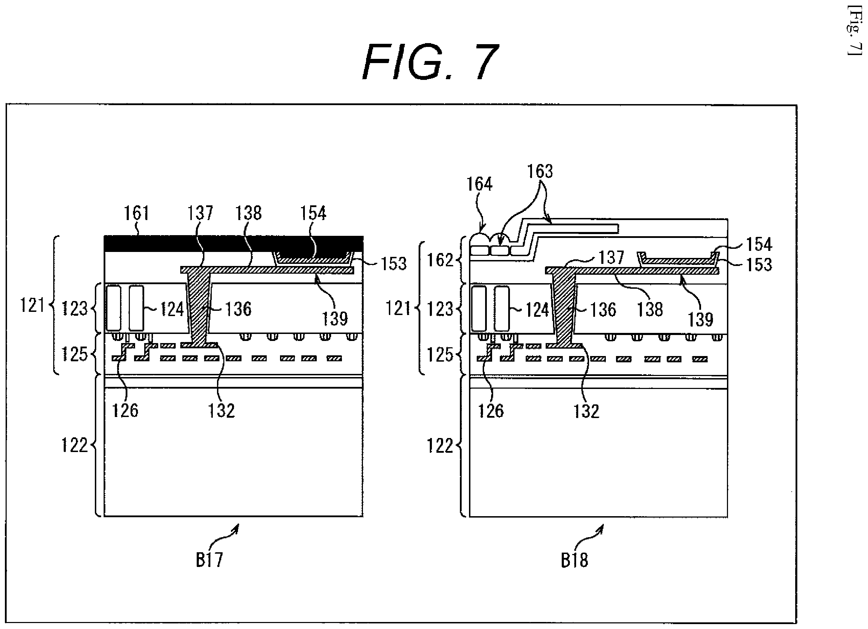

[fig.7] Fig. 7 is a diagram for describing a production process of a solid-state image capturing device.

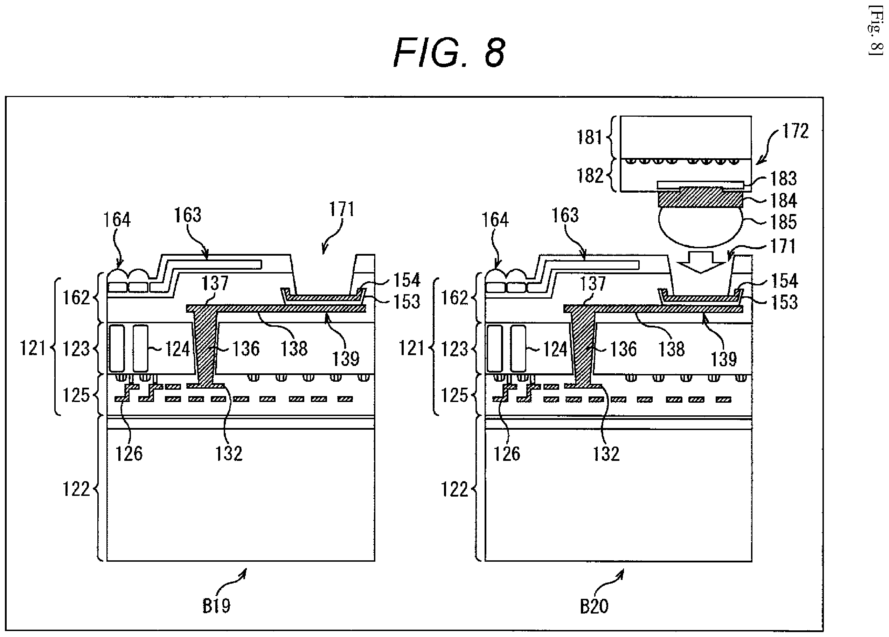

[fig.8] Fig. 8 is a diagram for describing a production process of a solid-state image capturing device.

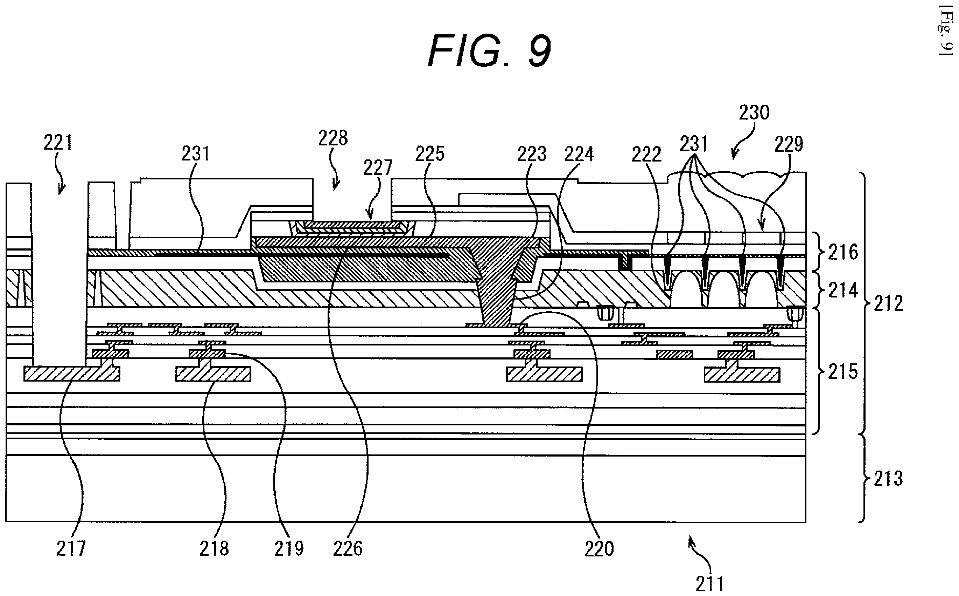

[fig.9]Fig. 9 is a diagram illustrating a more detailed exemplary configuration of a sensor semiconductor element.

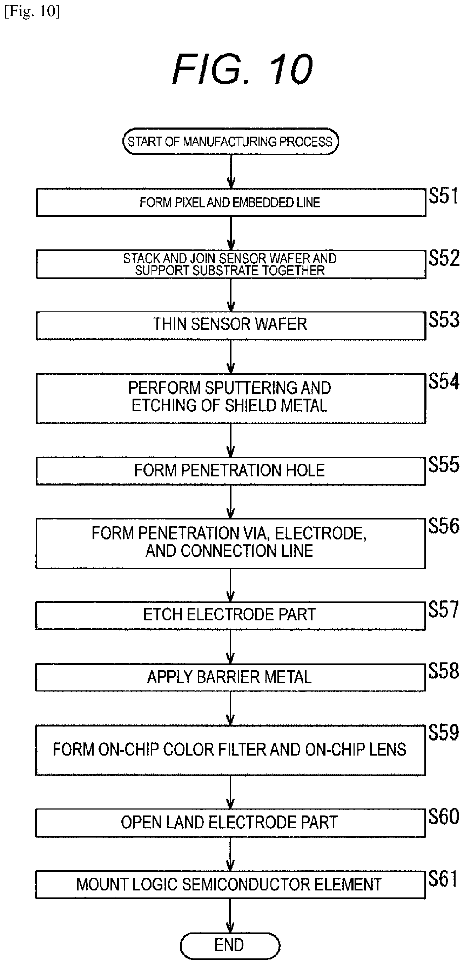

[fig.10] Fig. 10 is a flowchart for describing a manufacturing process.

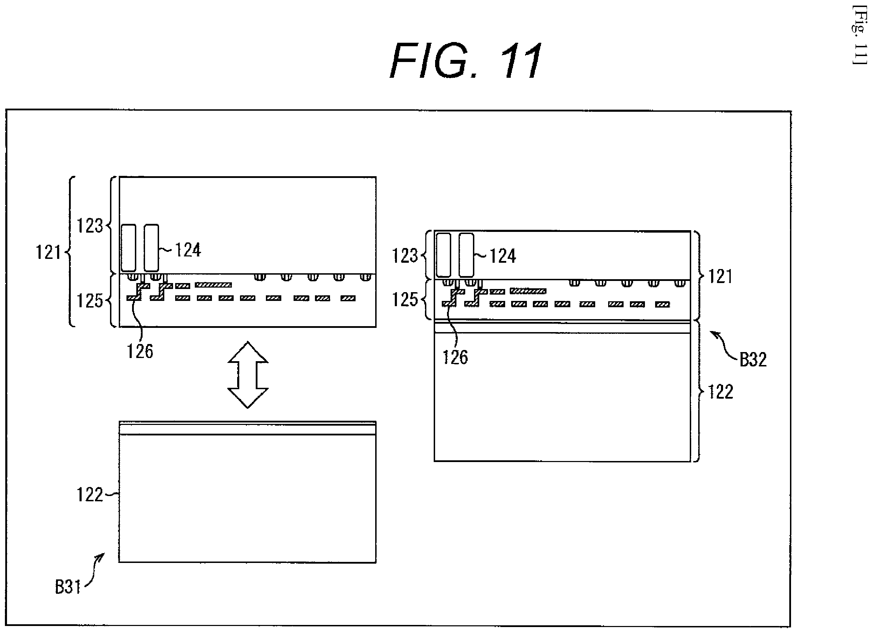

[fig.11]Fig. 11 is a diagram for describing a production process of a solid-state image capturing device.

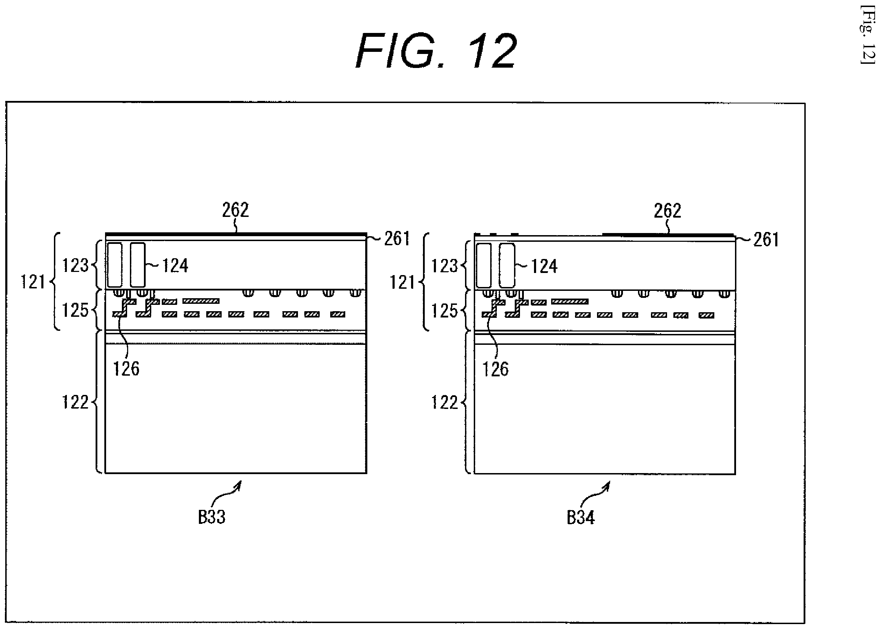

[fig.12]Fig. 12 is a diagram for describing a production process of a solid-state image capturing device.

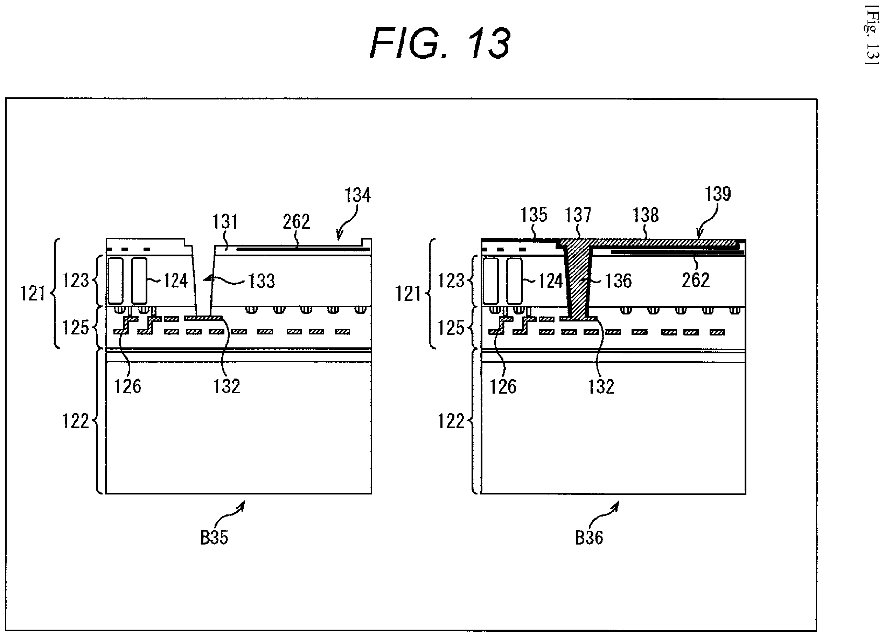

[fig.13]Fig. 13 is a diagram for describing a production process of a solid-state image capturing device.

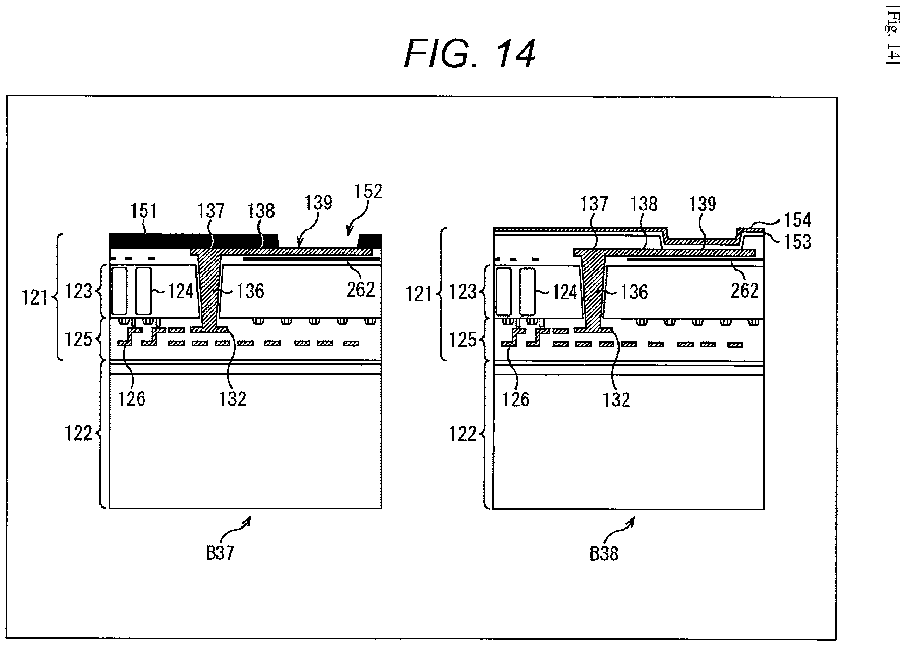

[fig.14]Fig. 14 is a diagram for describing a production process of a solid-state image capturing device.

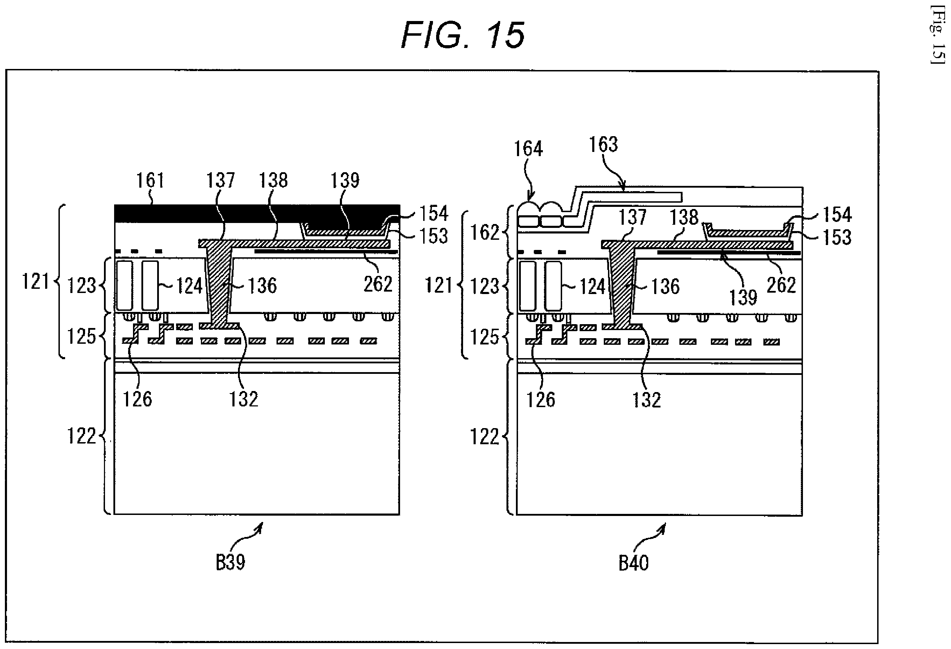

[fig.15]Fig. 15 is a diagram for describing a production process of a solid-state image capturing device.

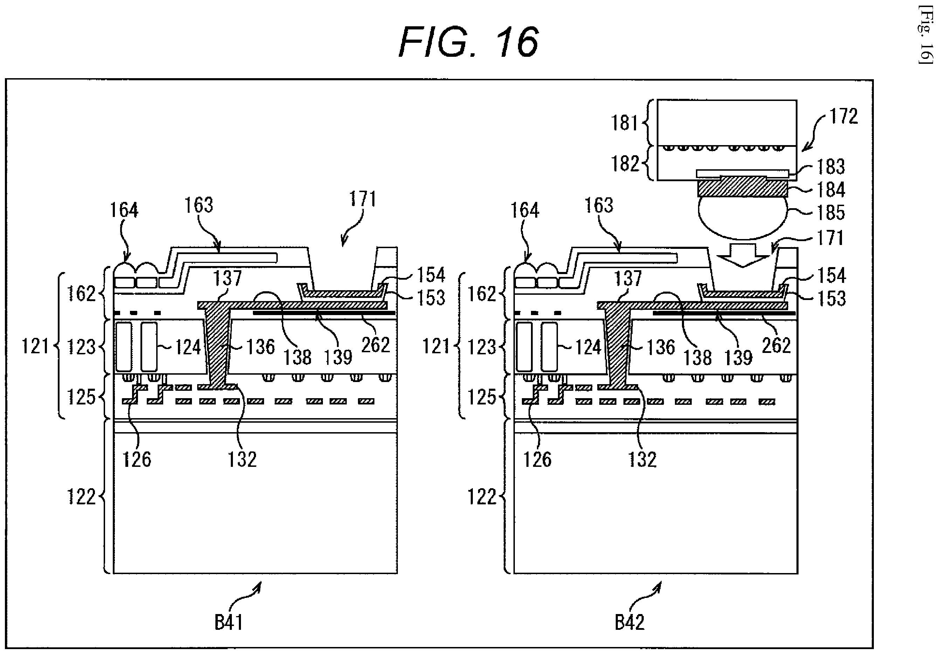

[fig.16]Fig. 16 is a diagram for describing a production process of a solid-state image capturing device.

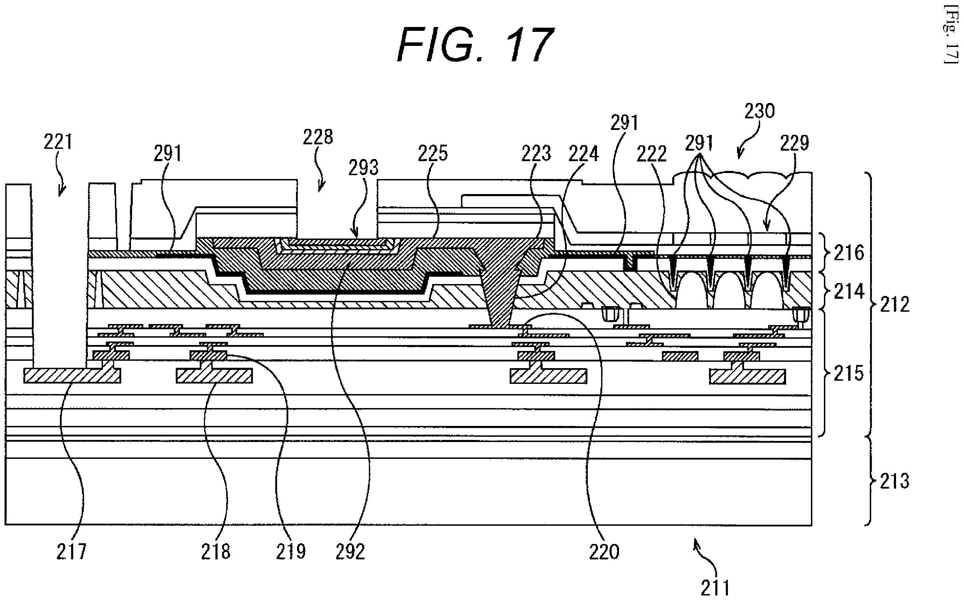

[fig.17]Fig. 17 is a diagram illustrating a more detailed exemplary configuration of a sensor semiconductor element.

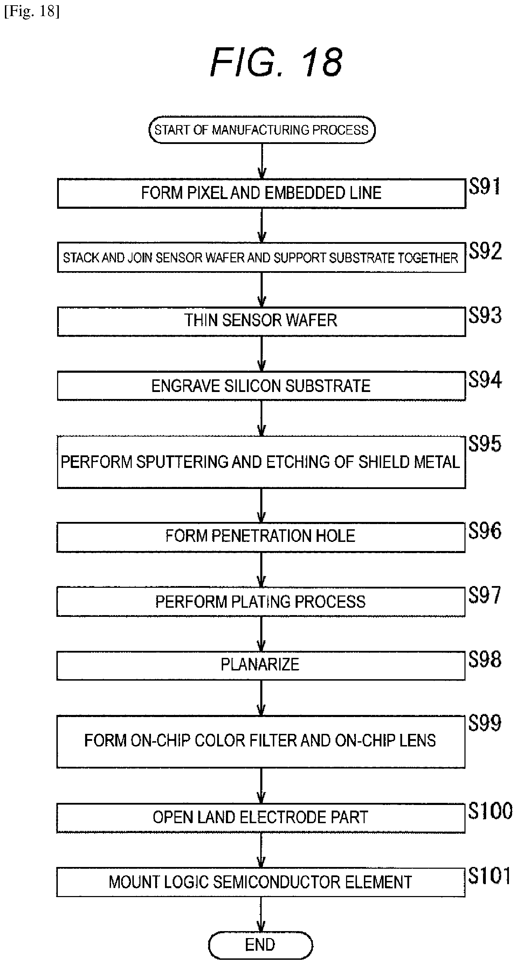

[fig.18]Fig. 18 is a flowchart for describing a manufacturing process.

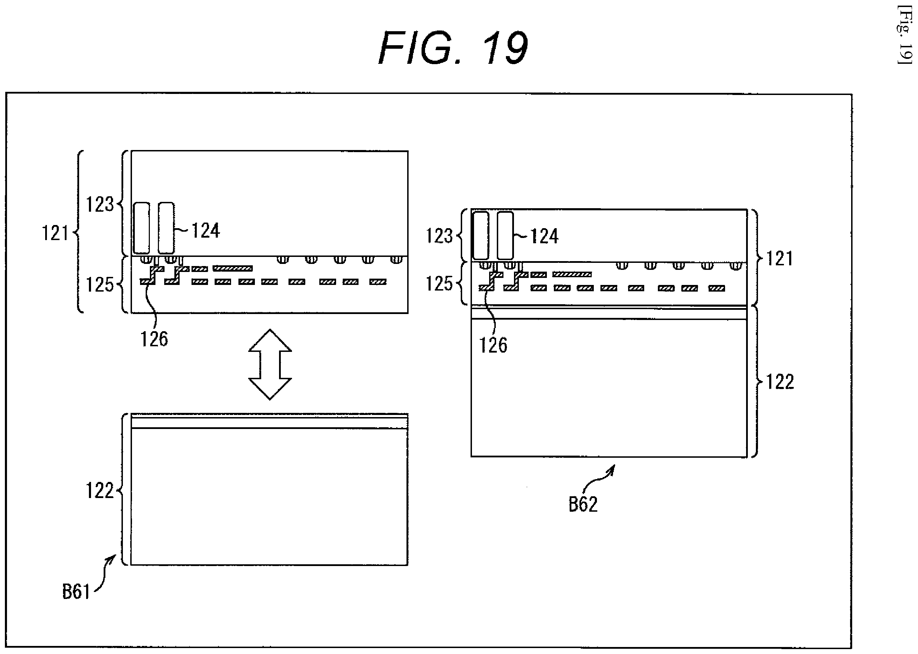

[fig.19]Fig. 19 is a diagram for describing a production process of a solid-state image capturing device.

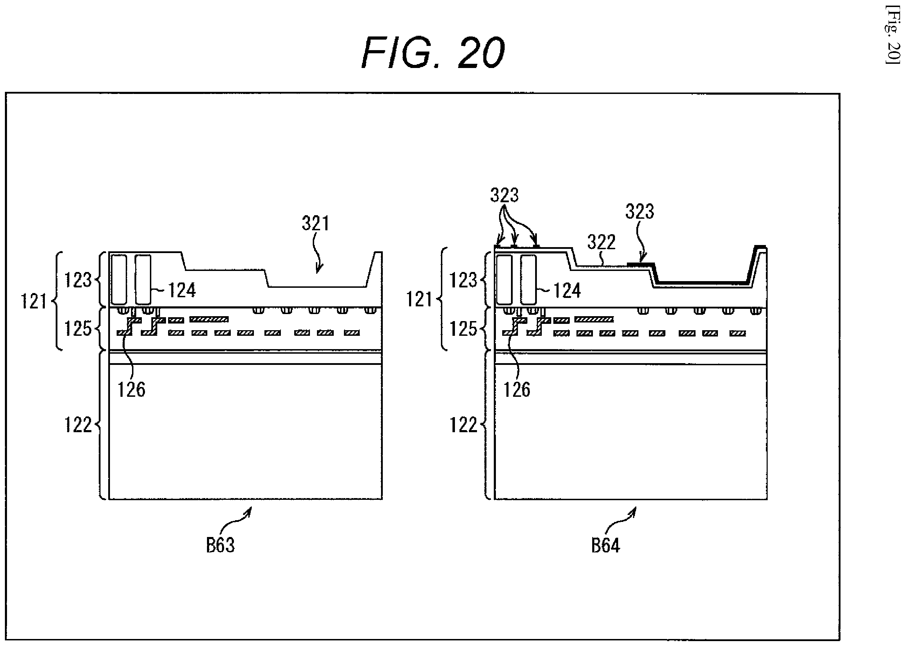

[fig.20]Fig. 20 is a diagram for describing a production process of a solid-state image capturing device.

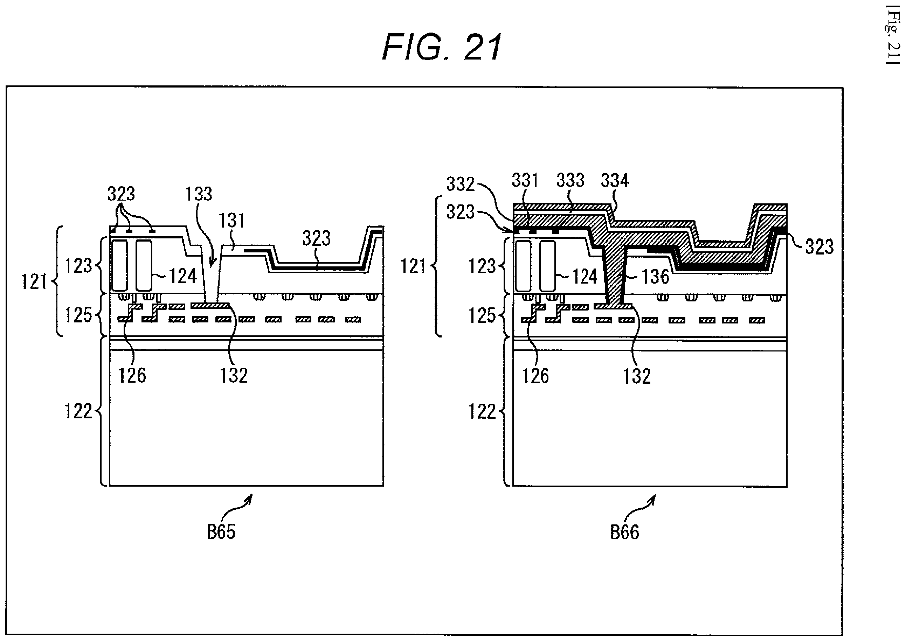

[fig.21]Fig. 21 is a diagram for describing a production process of a solid-state image capturing device.

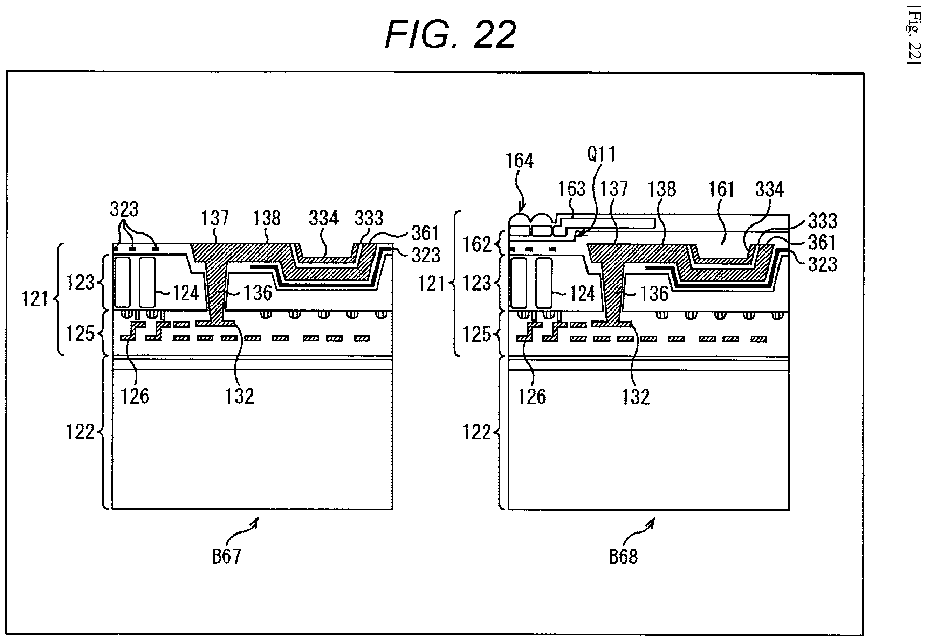

[fig.22]Fig. 22 is a diagram for describing a production process of a solid-state image capturing device.

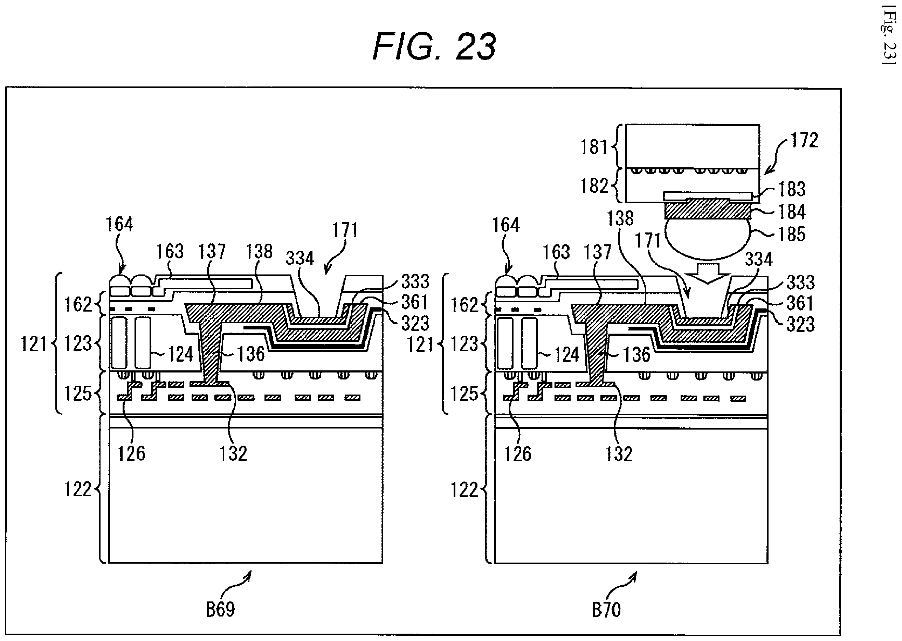

[fig.23]Fig. 23 is a diagram for describing a production process of a solid-state image capturing device.

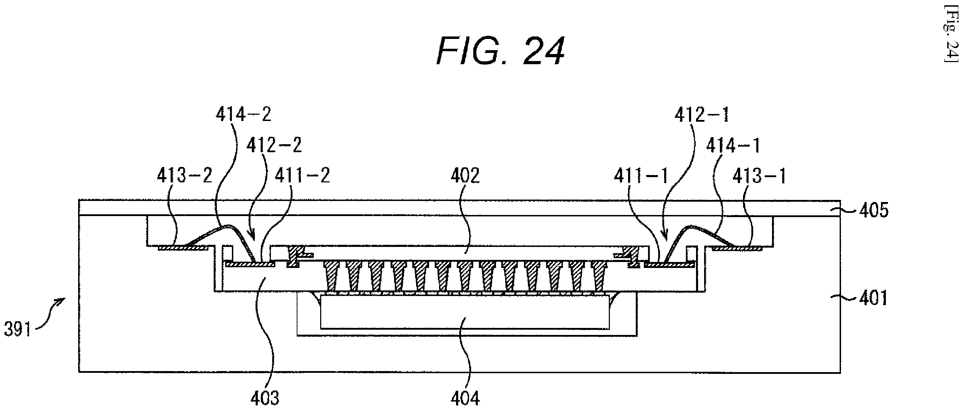

[fig.24]Fig. 24 is a diagram illustrating an exemplary configuration of a solid-state image capturing device.

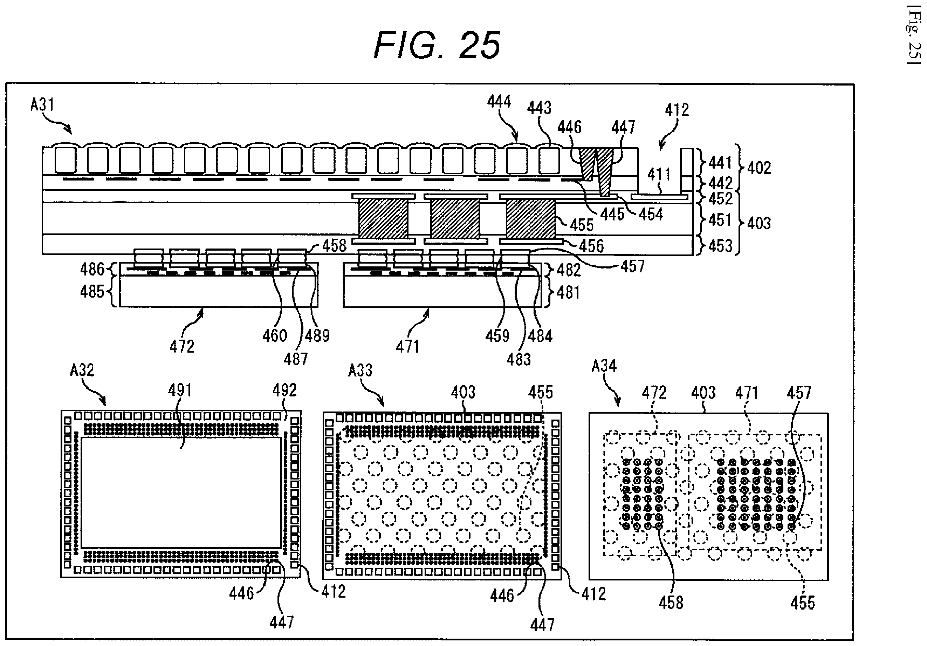

[fig.25]Fig. 25 is a diagram illustrating a more detailed exemplary configuration of a sensor semiconductor element.

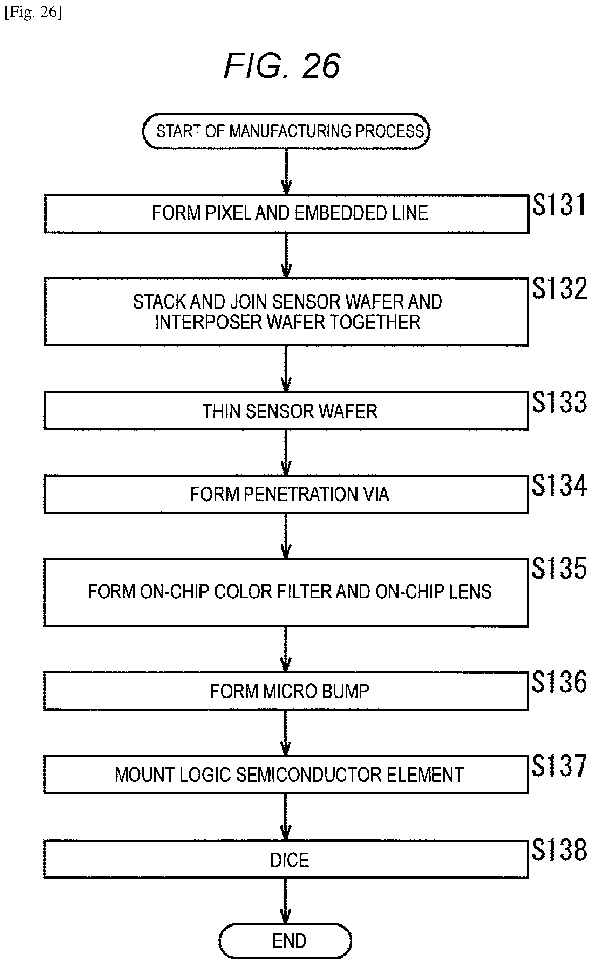

[fig.26]Fig. 26 is a flowchart for describing a manufacturing process.

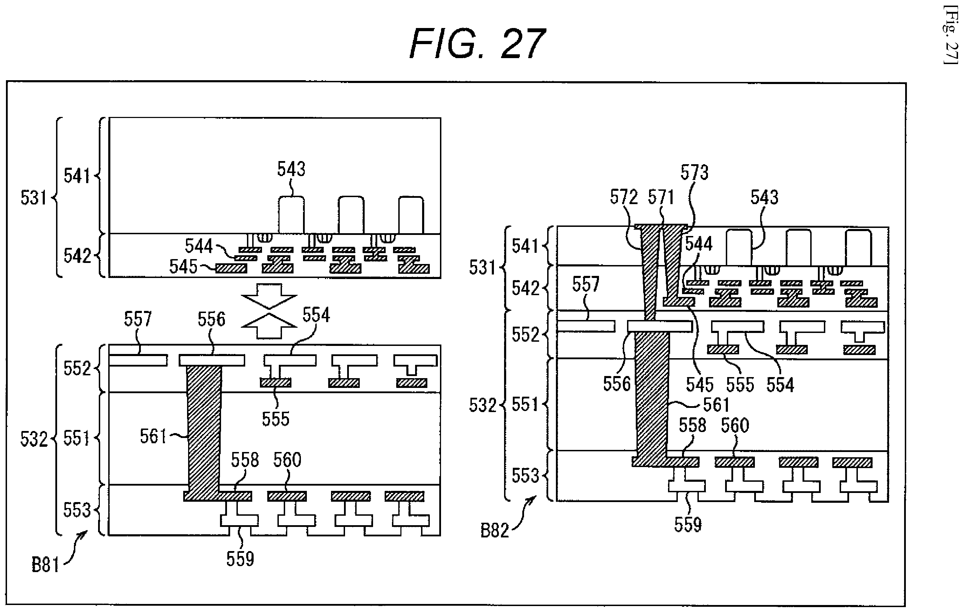

[fig.27]Fig. 27 is a diagram for describing a production process of a solid-state image capturing device.

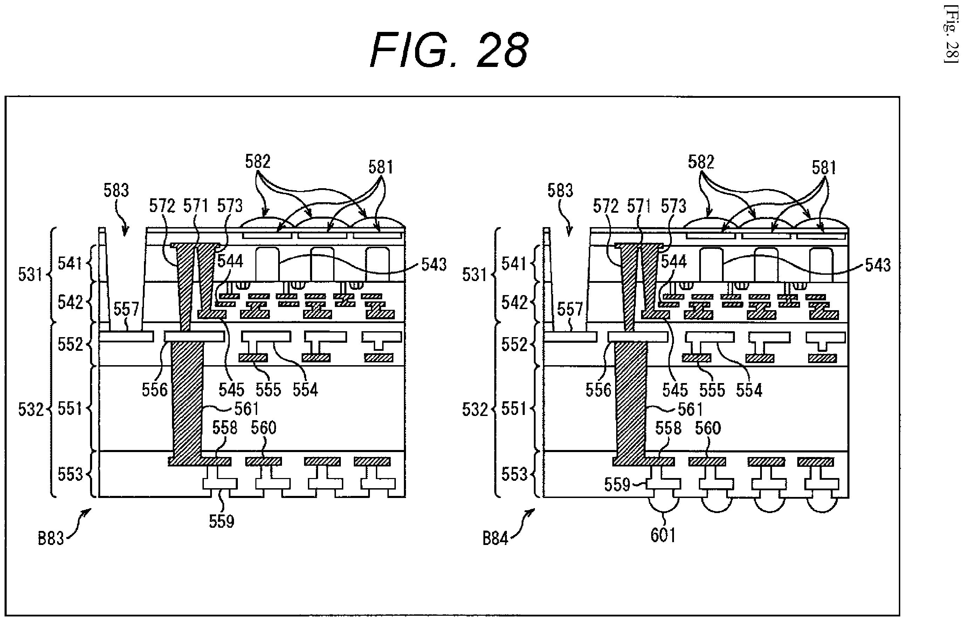

[fig.28]Fig. 28 is a diagram for describing a production process of a solid-state image capturing device.

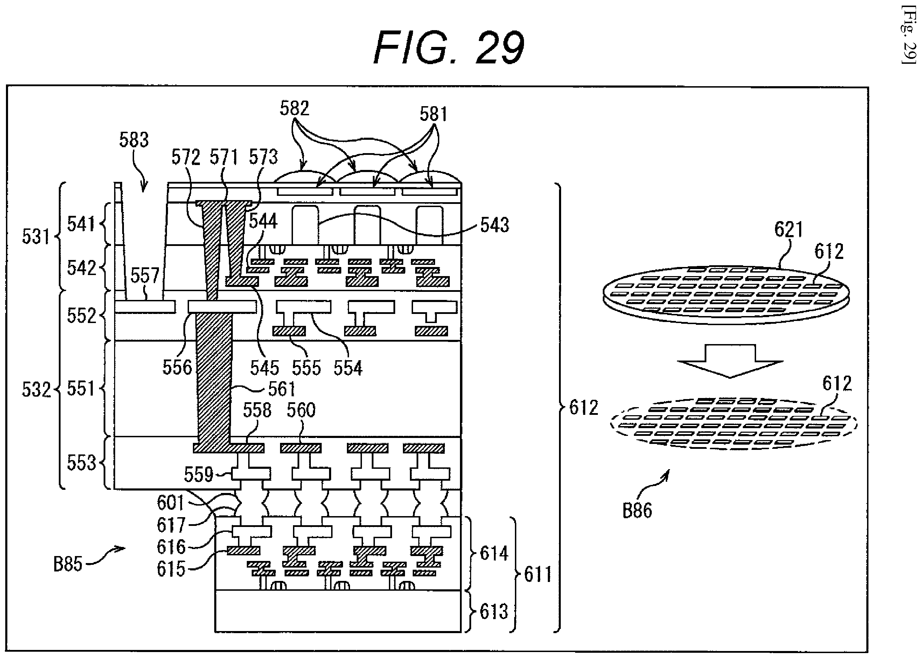

[fig.29]Fig. 29 is a diagram for describing a production process of a solid-state image capturing device.

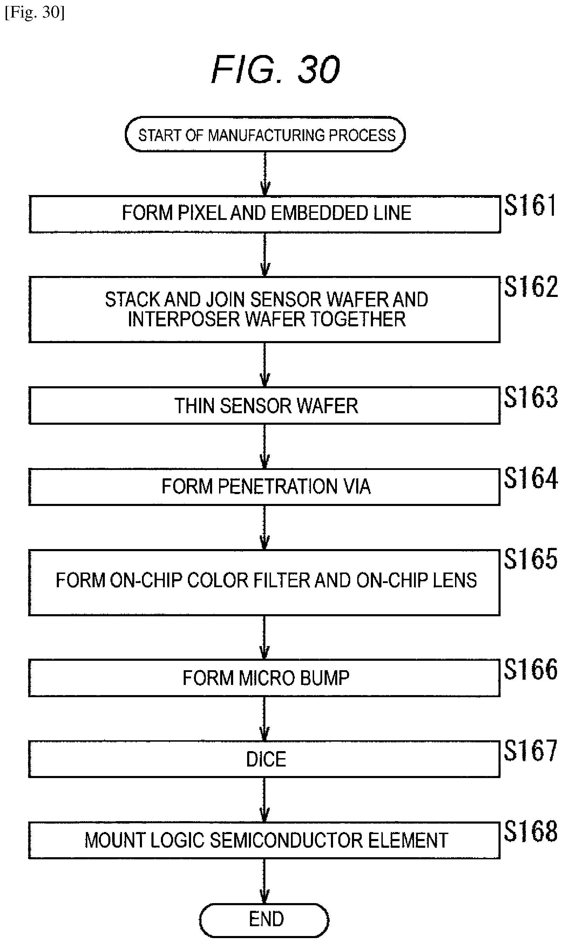

[fig.30]Fig. 30 is a flowchart for describing a manufacturing process.

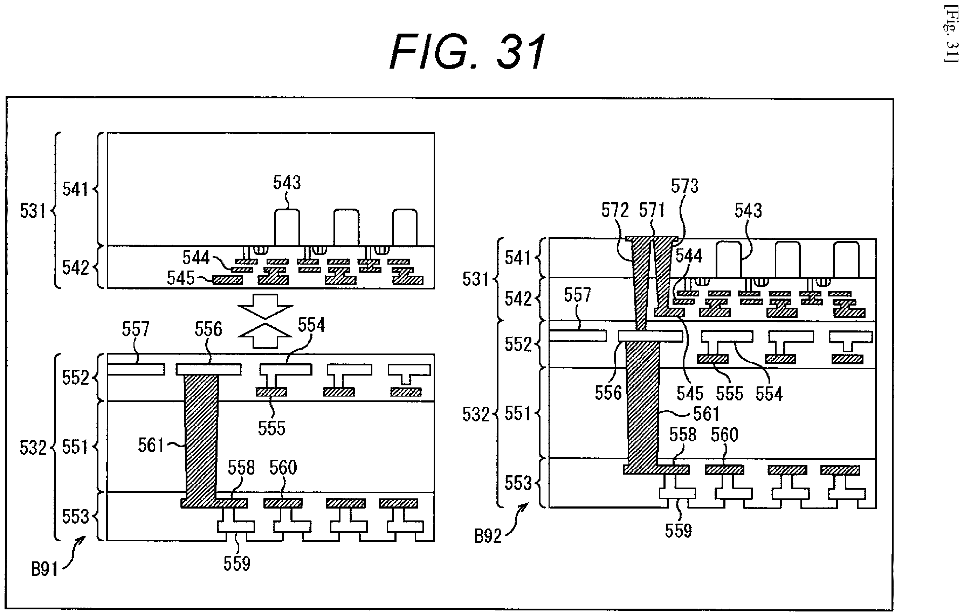

[fig.31]Fig. 31 is a diagram for describing a production process of a solid-state image capturing device.

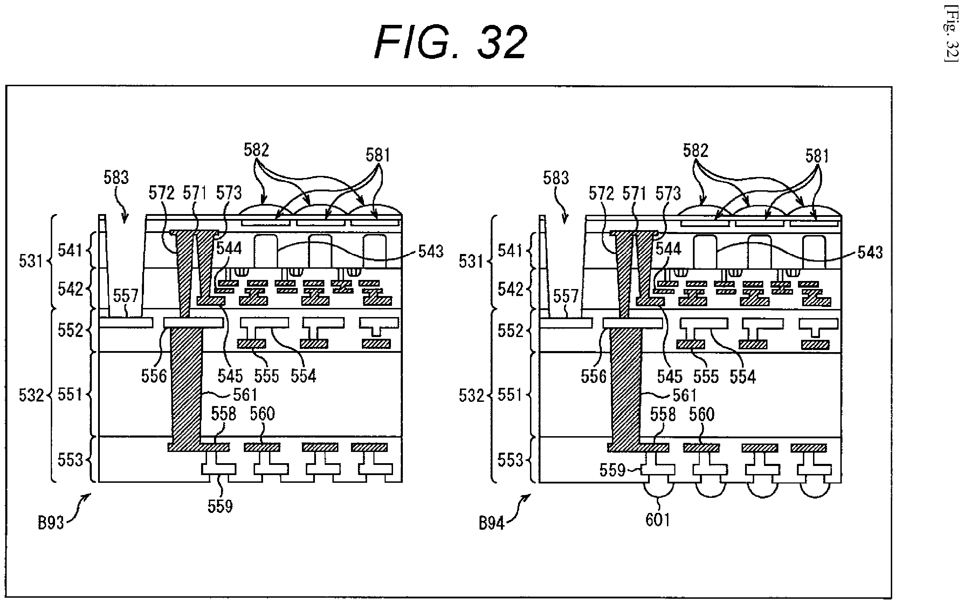

[fig.32]Fig. 32 is a diagram for describing a production process of a solid-state image capturing device.

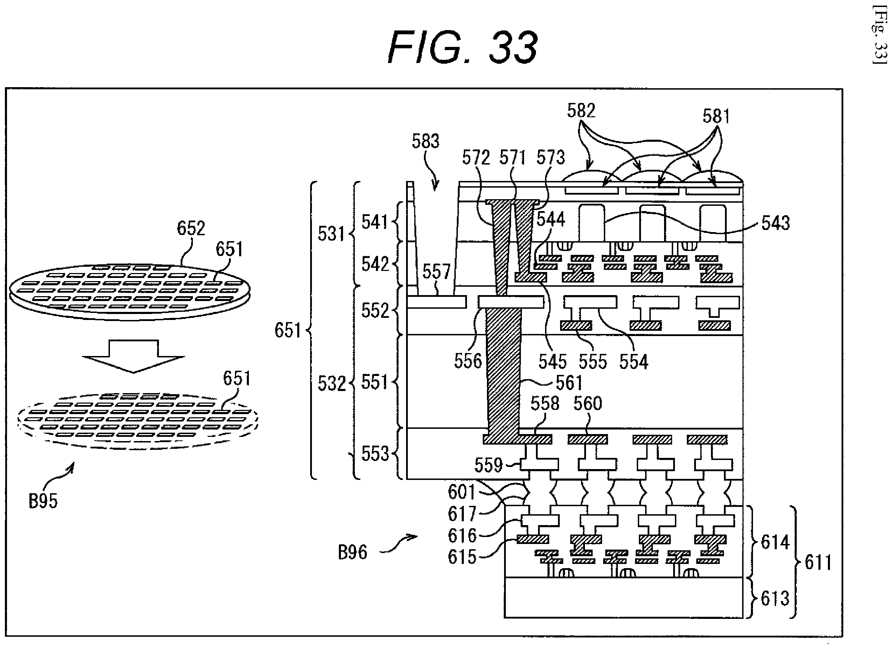

[fig.33]Fig. 33 is a diagram for describing a production process of a solid-state image capturing device.

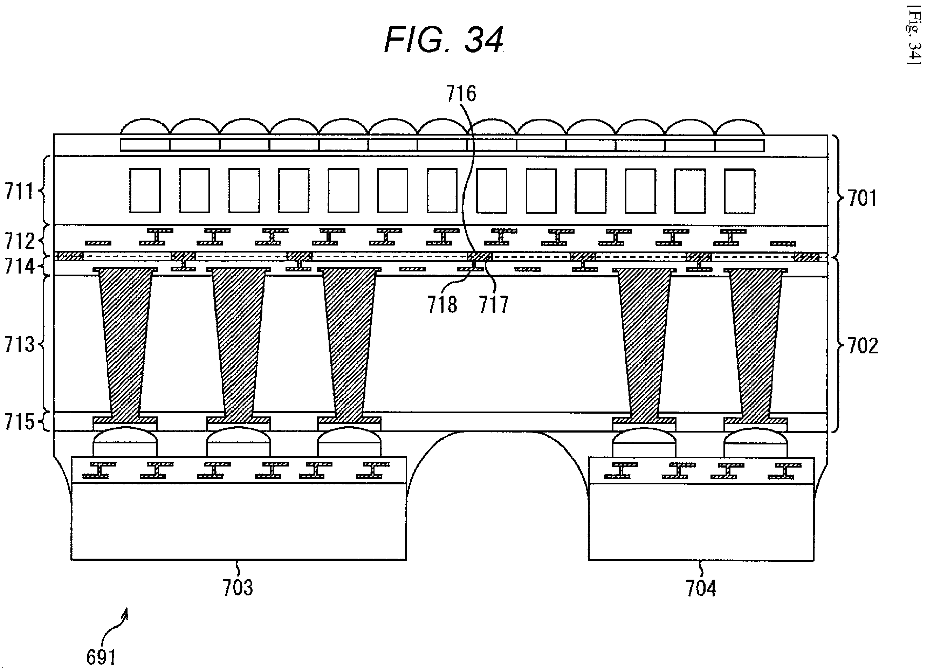

[fig.34]Fig. 34 is a diagram illustrating an exemplary configuration of a solid-state image capturing device.

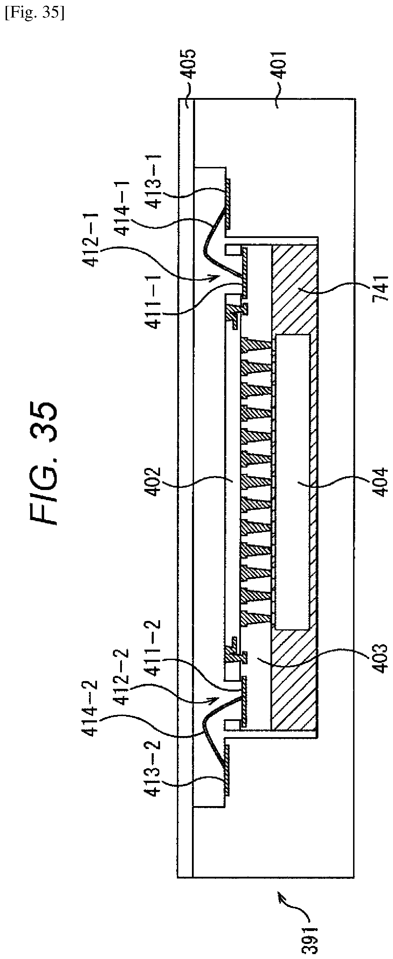

[fig.35]Fig. 35 is a diagram illustrating an exemplary configuration of a solid-state image capturing device.

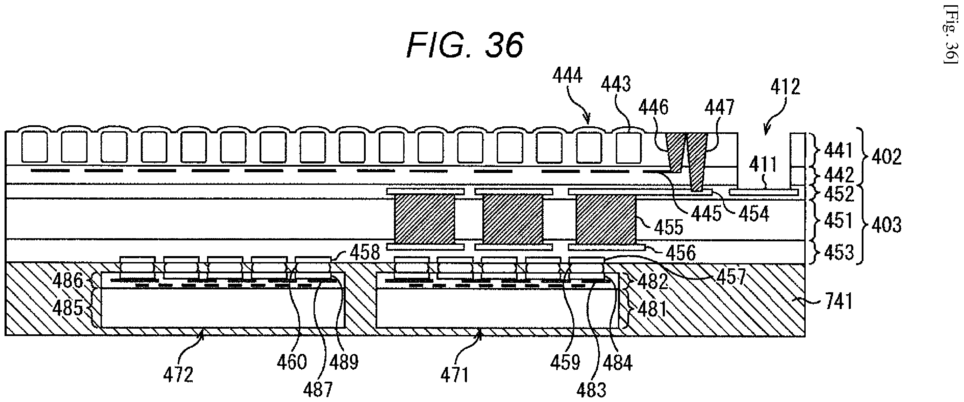

[fig.36]Fig. 36 is a diagram illustrating a more detailed exemplary configuration of a sensor semiconductor element.

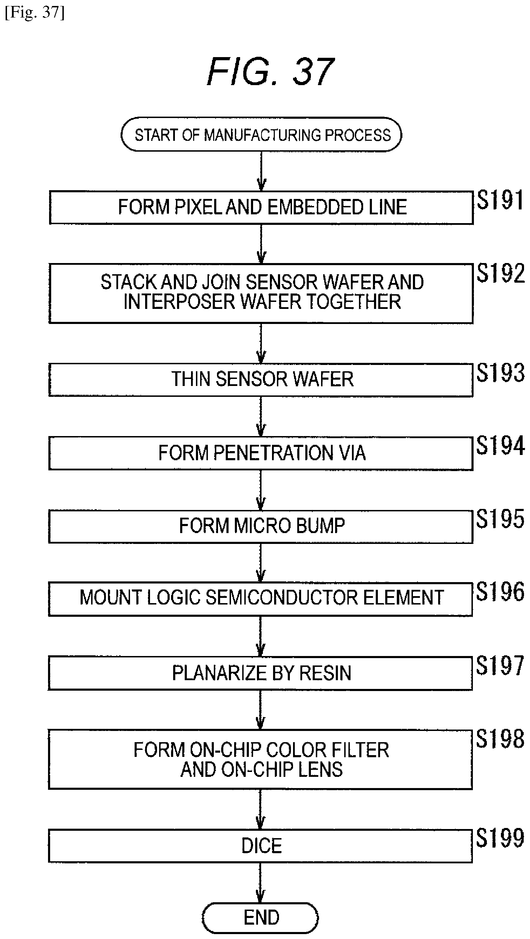

[fig.37]Fig. 37 is a flowchart for describing a manufacturing process.

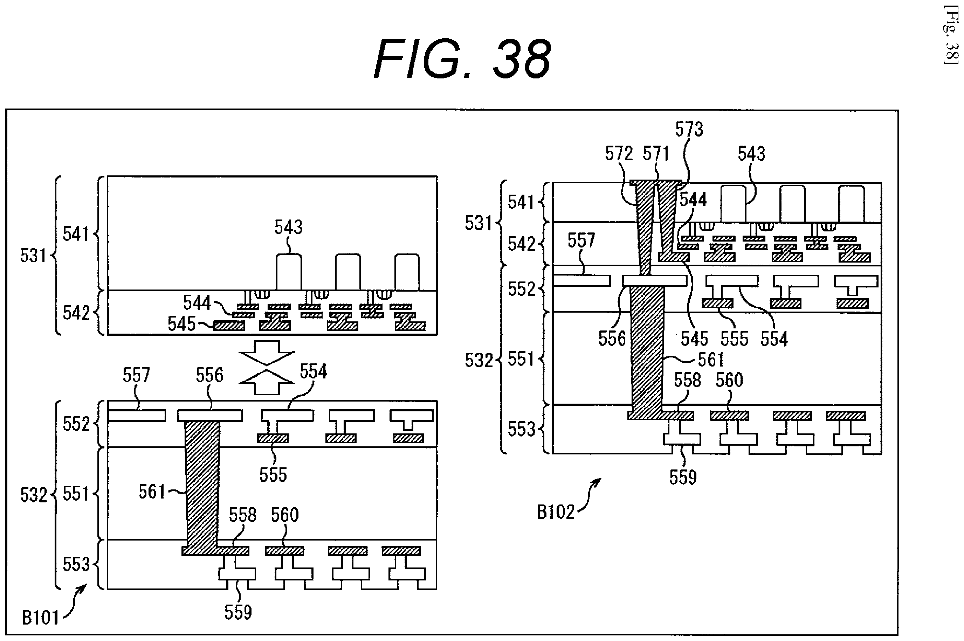

[fig.38]Fig. 38 is a diagram for describing a production process of a solid-state image capturing device.

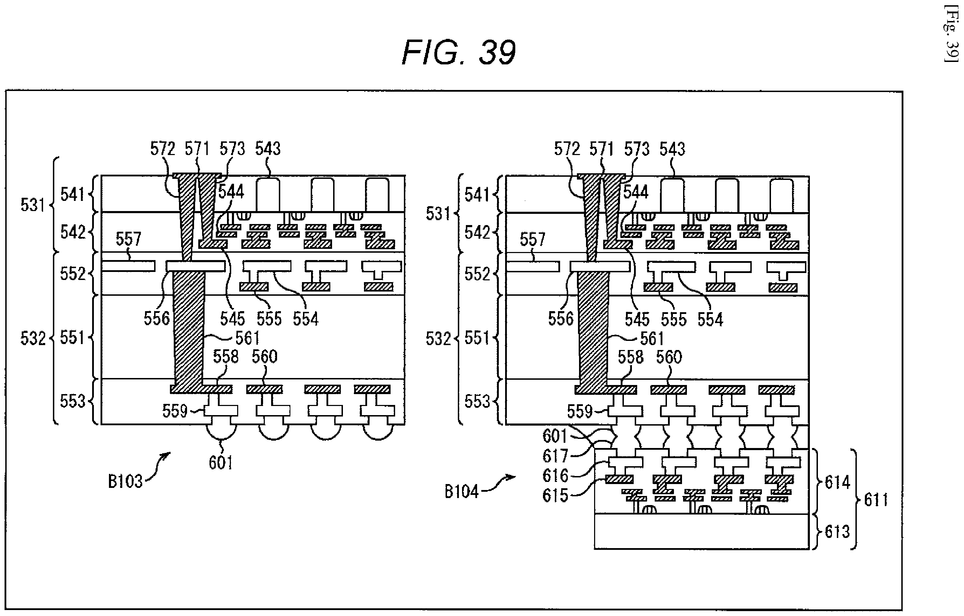

[fig.39]Fig. 39 is a diagram for describing a production process of a solid-state image capturing device.

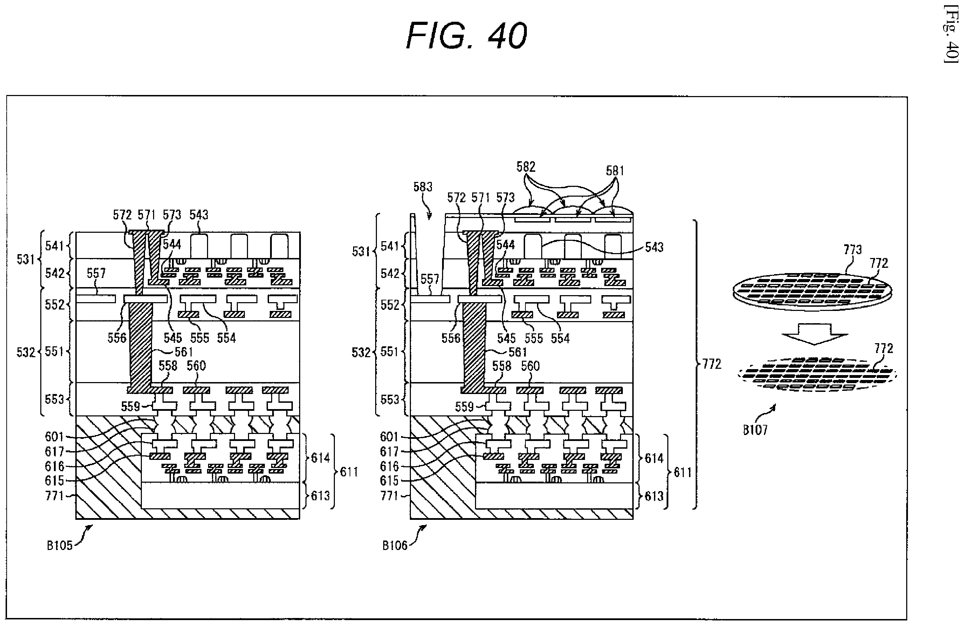

[fig.40]Fig. 40 is a diagram for describing a production process of a solid-state image capturing device.

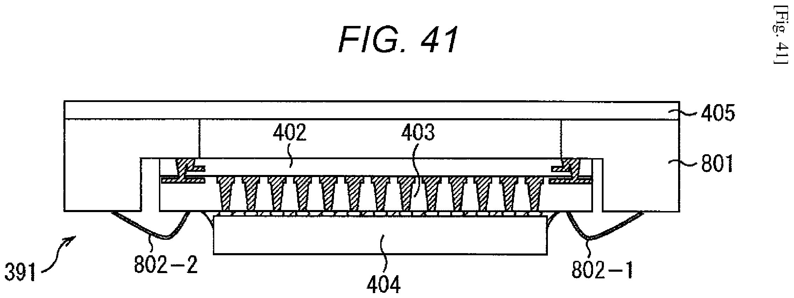

[fig.41]Fig. 41 is a diagram illustrating an exemplary configuration of a solid-state image capturing device.

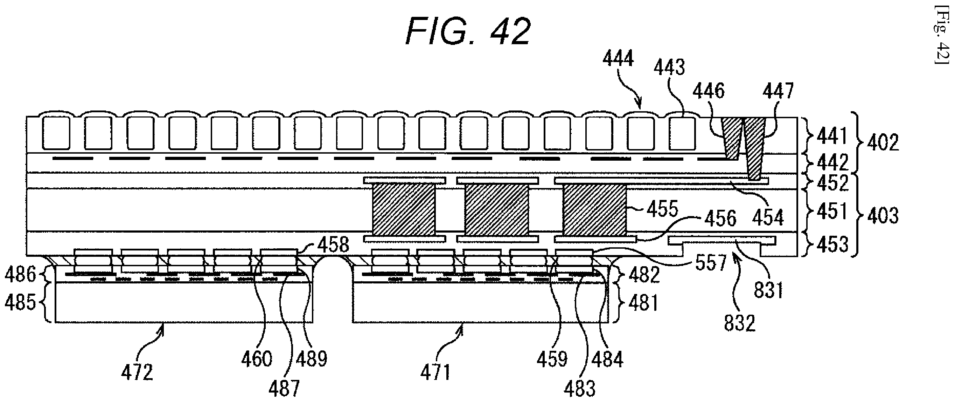

[fig.42]Fig. 42 is a diagram illustrating a more detailed exemplary configuration of a sensor semiconductor element.

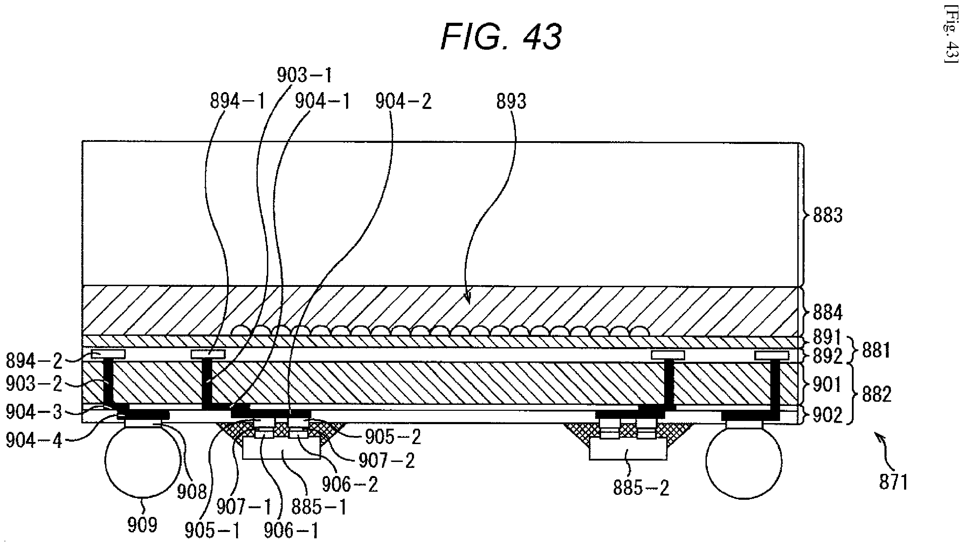

[fig.43]Fig. 43 is a diagram illustrating an exemplary configuration of a solid-state image capturing device.

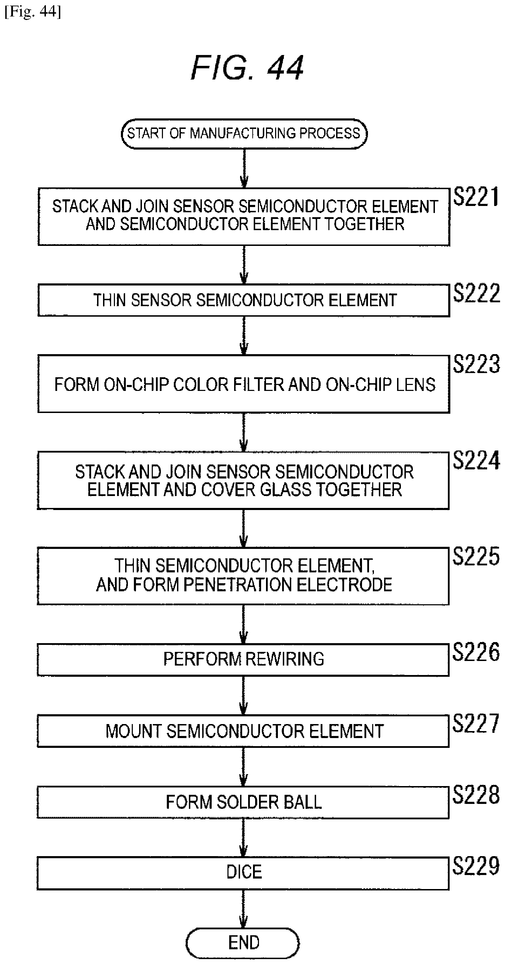

[fig.44]Fig. 44 is a flowchart for describing a manufacturing process.

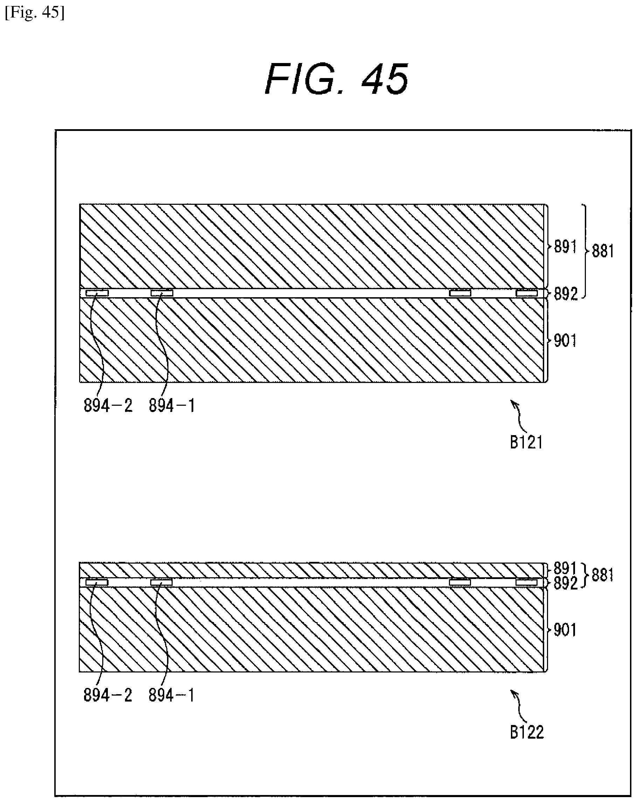

[fig.45]Fig. 45 is a diagram for describing a production process of a solid-state image capturing device.

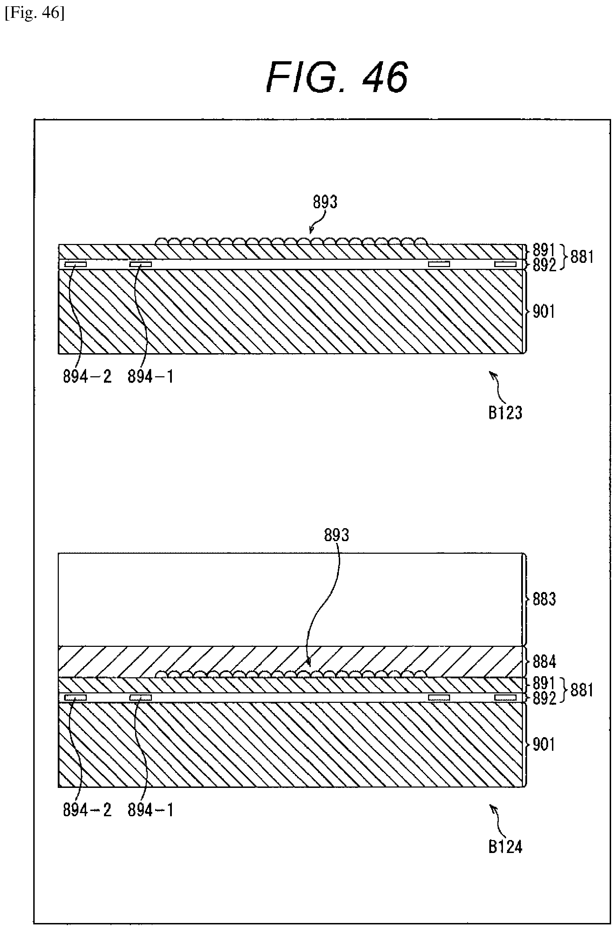

[fig.46]Fig. 46 is a diagram for describing a production process of a solid-state image capturing device.

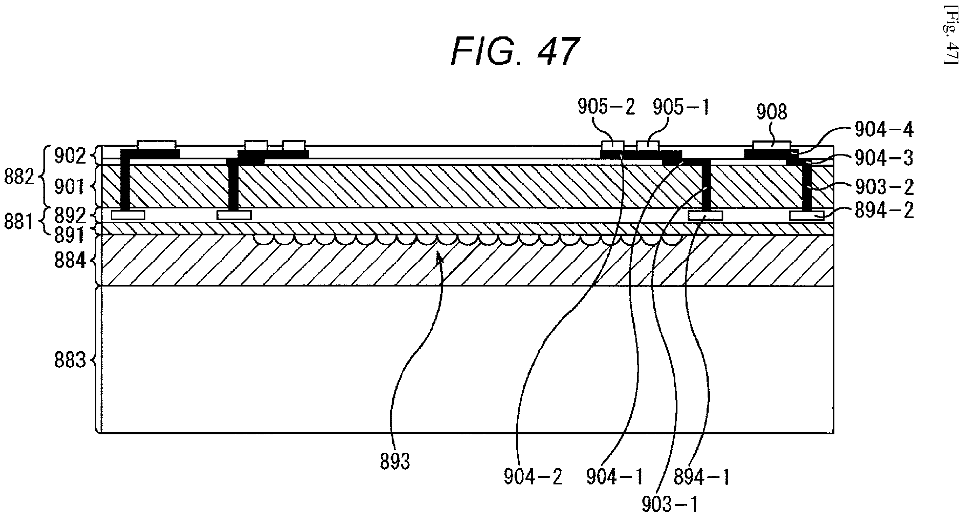

[fig.47]Fig. 47 is a diagram for describing a production process of a solid-state image capturing device.

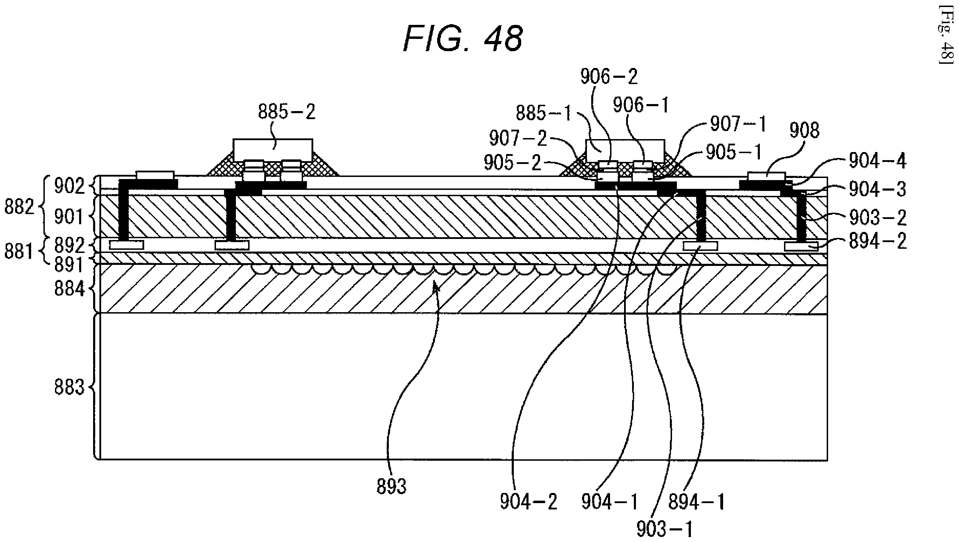

[fig.48]Fig. 48 is a diagram for describing a production process of a solid-state image capturing device.

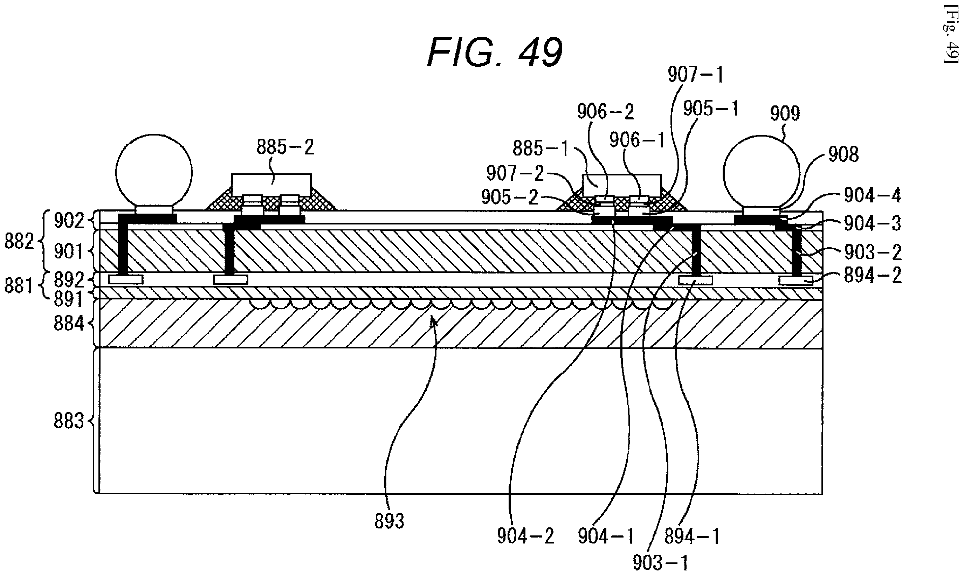

[fig.49]Fig. 49 is a diagram for describing a production process of a solid-state image capturing device.

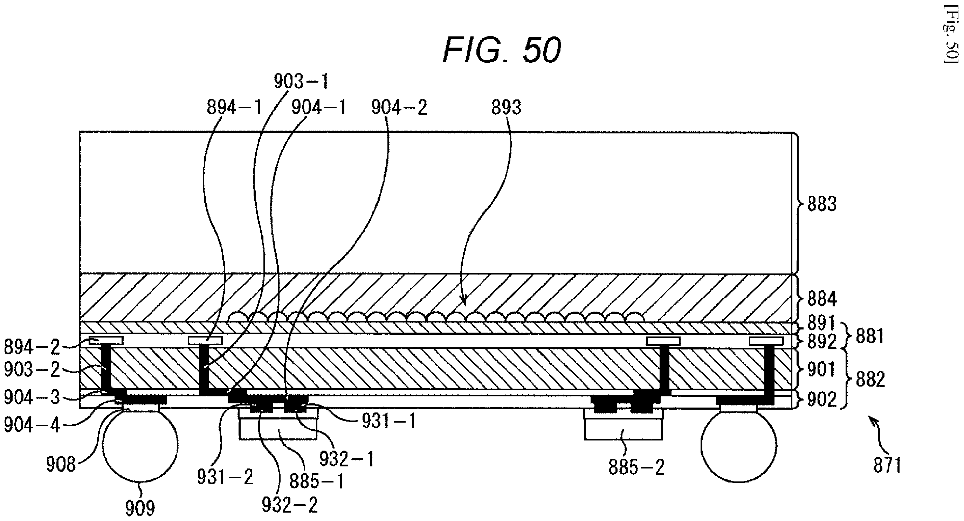

[fig.50]Fig. 50 is a diagram illustrating an exemplary configuration of a solid-state image capturing device.

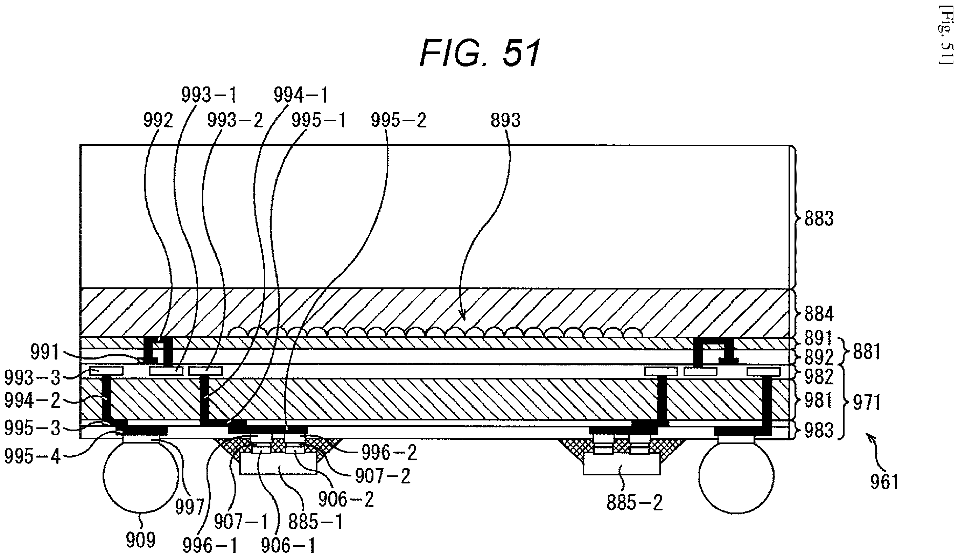

[fig.51] Fig. 51 is a diagram illustrating an exemplary configuration of a solid-state image capturing device.

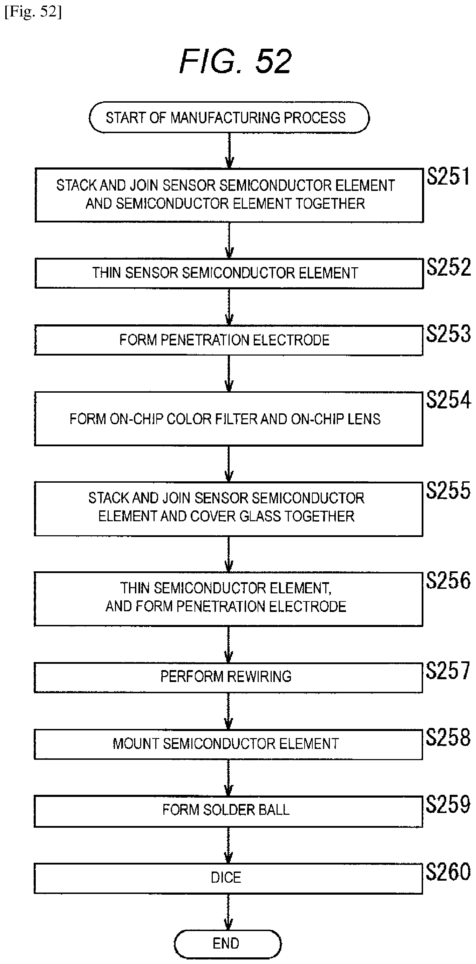

[fig.52]Fig. 52 is a flowchart for describing a manufacturing process.

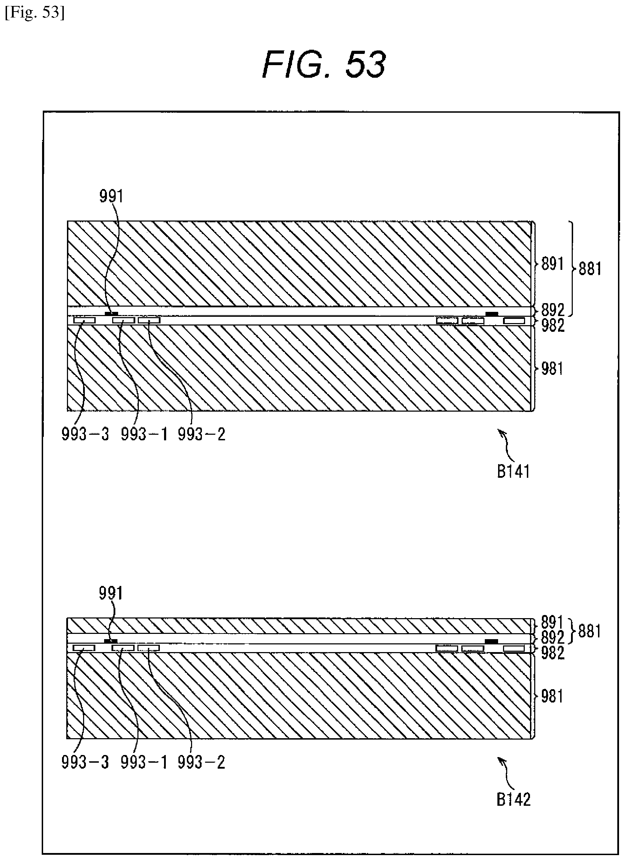

[fig.53]Fig. 53 is a diagram for describing a production process of a solid-state image capturing device.

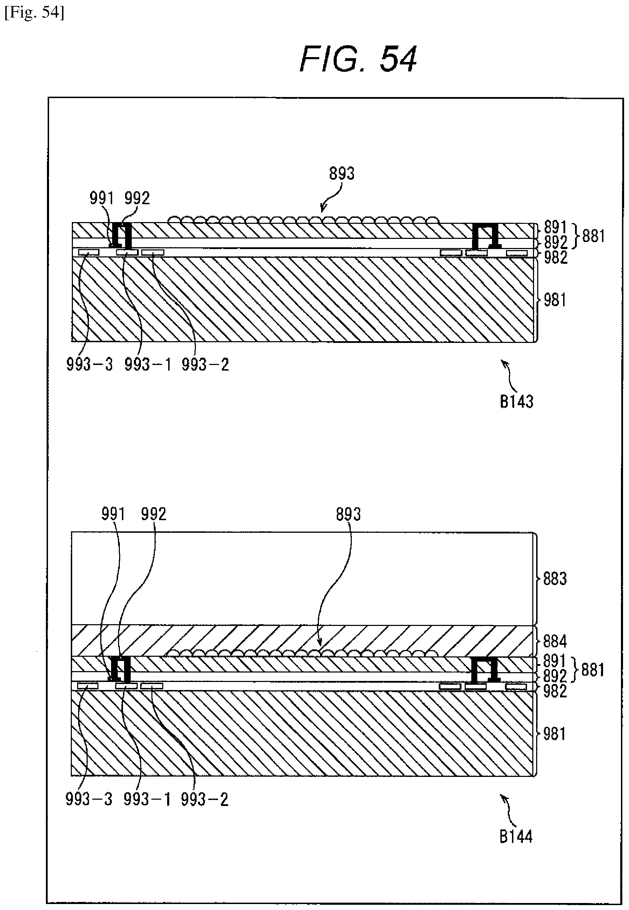

[fig.54]Fig. 54 is a diagram for describing a production process of a solid-state image capturing device.

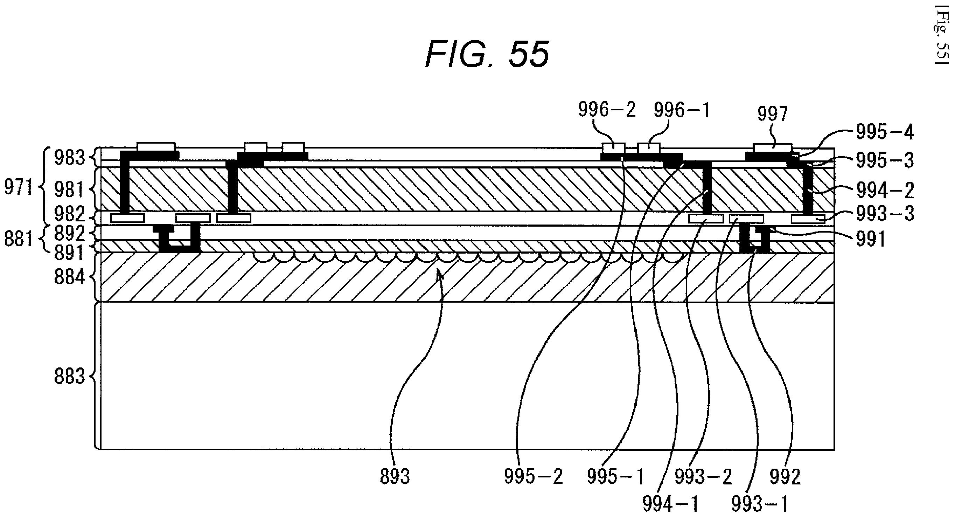

[fig.55]Fig. 55 is a diagram for describing a production process of a solid-state image capturing device.

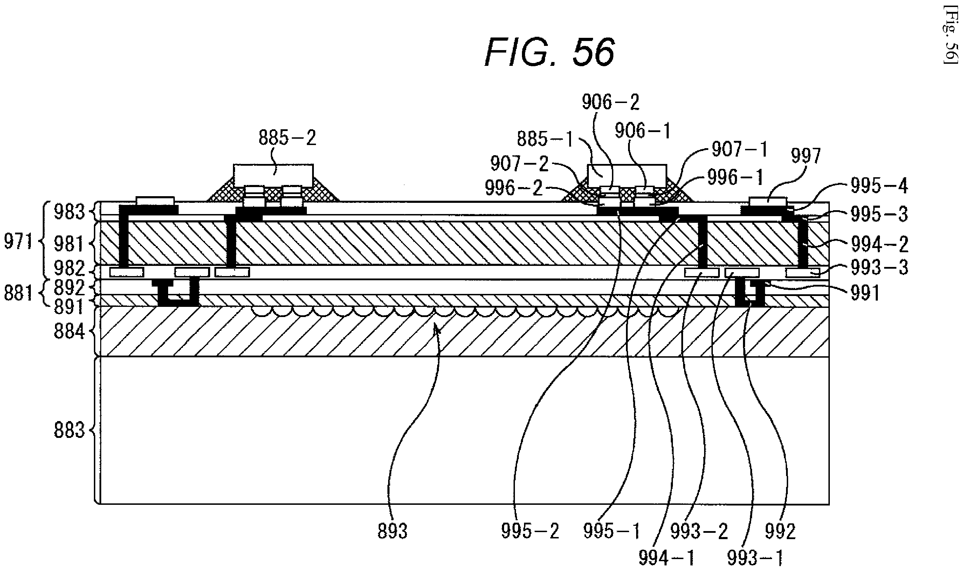

[fig.56]Fig. 56 is a diagram for describing a production process of a solid-state image capturing device.

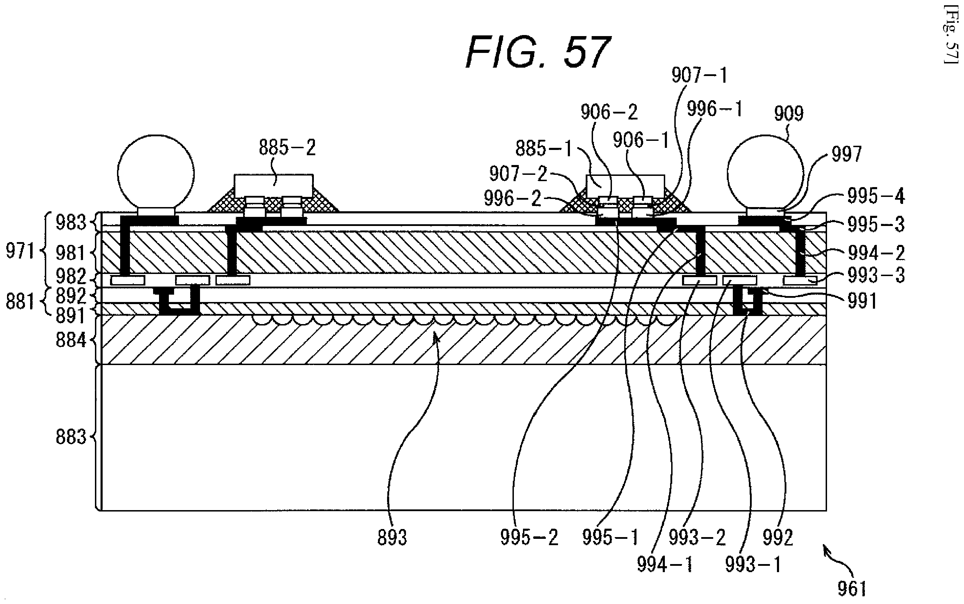

[fig.57]Fig. 57 is a diagram for describing a production process of a solid-state image capturing device.

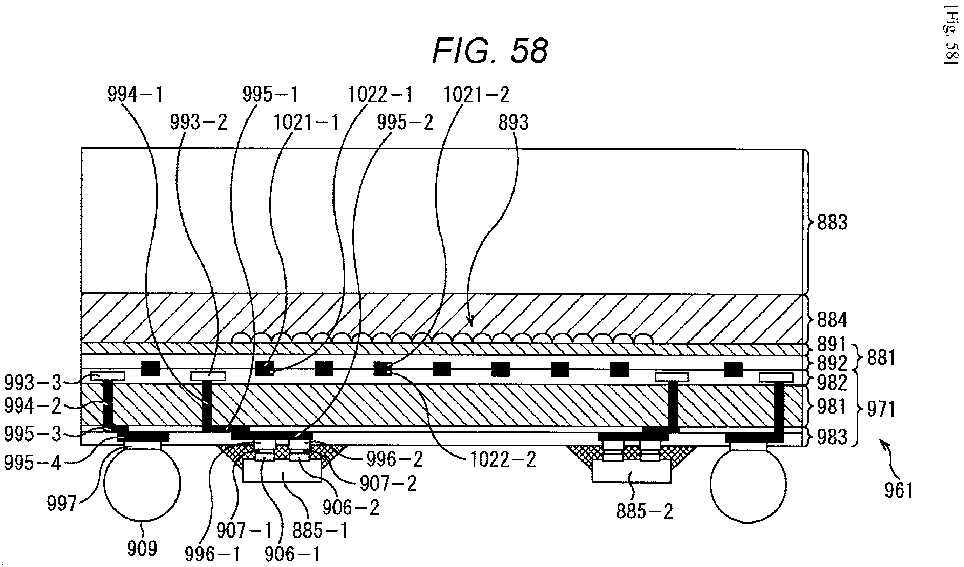

[fig.58]Fig. 58 is a diagram illustrating an exemplary configuration of a solid-state image capturing device.

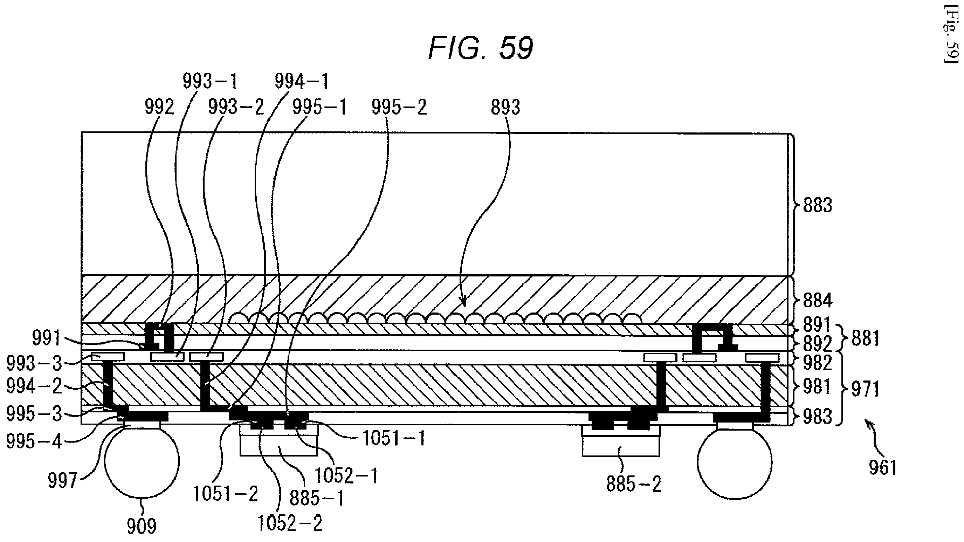

[fig.59]Fig. 59 is a diagram illustrating an exemplary configuration of a solid-state image capturing device.

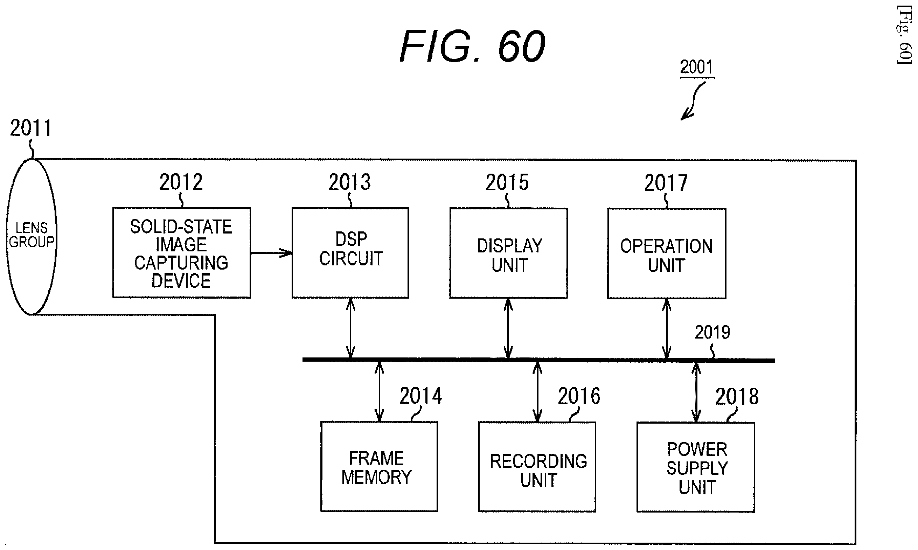

[fig.60] Fig. 60 is a diagram illustrating an exemplary configuration of an image capturing device.

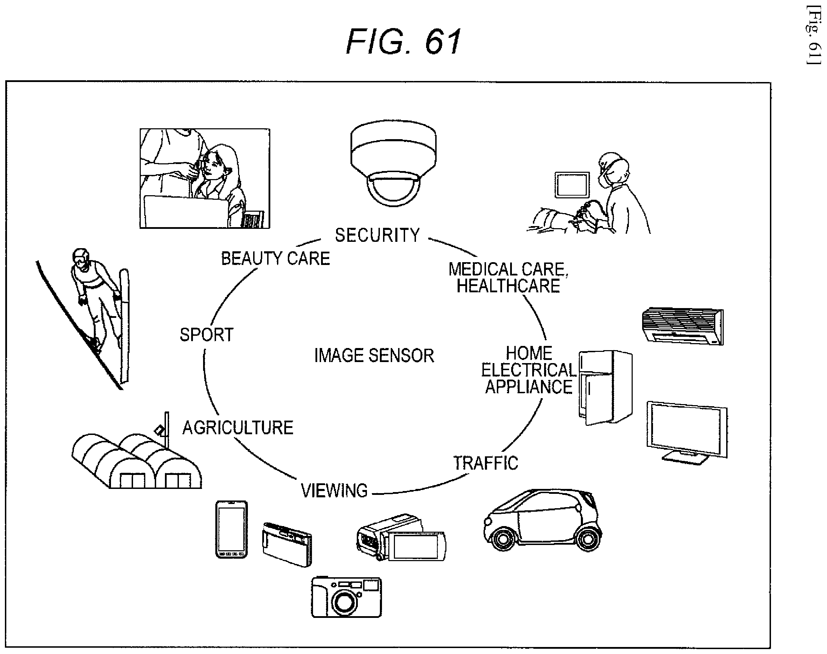

[fig.61]Fig. 61 is a diagram illustrating a use example in which a solid-state image capturing device is used.

### Description of Embodiments

In the following, with reference to drawings, embodiments to which the present technology is applied will be described.

### <First Embodiment>

### <Exemplary Configuration of Solid-State Image Capturing Device>

An embodiment of the present technology provides a small back-side illuminated solid-state image capturing device in a simpler manner, by increasing area efficiency of a semiconductor element by a combination of a penetration via and a land electrode between which their pitches (diameters) are different significantly, and rewiring for connecting between those penetration via and land electrode.

Here, the back-side illuminated solid-state image capturing device is a solid-state image capturing device configured such that a photoelectric conversion element such as a photo diode for receiving a light from a subject is provided between a light receiving surface through which a light from the subject enters (i.e., an on-chip lens that collects a light) and a wiring layer in which lines of transistors for driving each pixel are provided. Conversely, the solid-state image capturing device of the front side illumination type is a solid-state image capturing device structured such that a wiring layer is provided between an on-chip lens and a photoelectric conversion element.

First, an exemplary configuration of the solid-state image capturing device to which an embodiment of the present technology is applied will be described. Fig. 1 is a diagram illustrating the exemplary configuration of one embodiment of the solid-state image capturing device to which an embodiment of the present technology is applied.

A solid-state image capturing device 11 is an image sensor of a back side illumination type including a complementary metal oxide semiconductor (CMOS) image sensor for example, which captures an image by receiving and photoelectrically converting a light from a subject to generate an image signal.

The solid-state image capturing device 11 is a stacked solid-state image capturing device in which an undepicted logic semiconductor element including various types of signal processing circuits for performing signal processing is mounted in a flip chip structure on a sensor semiconductor element 21.

In an effective pixel region 22 of the sensor semiconductor element 21, a plurality of pixels are arranged in matrix. Each pixel includes a photoelectric conversion element that receives and photoelectrically converts a light from a subject, an electric charge accumulating section that accumulates electric charge obtained at the photoelectric conversion element, and a pixel circuit having a plurality of field-effect transistors. Also, the above logic semiconductor element is mounted in a peripheral region 23, which is the region outside the effective pixel region 22 on the sensor semiconductor element 21.

An enlarged part of the solid-state image capturing device 11 is as illustrated in Fig. 2, for example. Note that, in Fig. 2, the diagram indicated by the arrow A11 is a diagram of a part of the solid-state image capturing device 11 seen from the same direction as in Fig. 1. The diagram indicated by the arrow A12 is a cross-sectional view of the part of the solid-state image capturing device 11 indicated by the arrow A11, when seen in the upward direction from below in the drawing. Note that, in the diagram indicated by the arrow A11, the logic semiconductor element mounted on the sensor semiconductor element 21 is not depicted.

In the diagram indicated by the arrow A11, in the drawing of the effective pixel region 22 on the sensor semiconductor element 21, the peripheral region 23 is provided in the right side. This peripheral region 23 includes a region R11 provided with a plurality of penetration vias having a pitch (diameter) of approximately 5 µm, and a region R12 provided with a plurality of land electrodes, having a pitch (diameter) of approximately 40 µm, for mounting the logic semiconductor element.

For example, the region R11 is provided a penetration via 51 having a pitch of approximately 5 µm and penetrating a plurality of layers configuring the sensor semiconductor element 21, and an end of the penetration via 51 is provided with an electrode 52 for line connection. The region R11 is provided with a plurality of same penetration vias as the penetration via 51 in a concentrated manner, together with the penetration via 51.

The region R12 is provided with a land electrode 53 which is a connection portion for mounting the logic semiconductor element. The pitch (width) of this land electrode 53 is approximately 40 µm. The land electrode 53 is an electrode of a land structure including an electrode 54 and a metal layer 55 provided in an upper portion of the electrode 54. The region R12 is provided with a plurality of same land electrodes as the land electrode 53 in a concentrated manner, together with the land electrode 53.

Also, in the peripheral region 23, an electrode provided at an end of each penetration via and an electrode that configures a land electrode are connected by a line. For example, the electrode 52 provided at an end of the penetration via 51 and the electrode 54 that configures the land electrode 53 are connected by a line 56 which is a connection line.

Further, each penetration via provided in the region R11 is connected to a pixel in the effective pixel region 22 by a perpendicular signal line. For example, the electrode provided at the end of the opposite side to the electrode 52 side of the penetration via 51 is connected to one pixel in the effective pixel region 22 by a perpendicular signal line 57. This perpendicular signal line 57 is a signal line for reading a pixel signal from a pixel of a connection destination.

A cross section of this sensor semiconductor element 21 is indicated by the arrow A12. That is, a support substrate 61 is stacked and joined together on the sensor semiconductor element 21. Also, the sensor semiconductor element 21 includes a silicon substrate 62 which is a semiconductor layer, and a wiring layer 63 and a wiring layer 64 provided on both surfaces of the silicon substrate 62.

Also, an on-chip lens and a color filter are provided for each pixel, in such a manner that an on-chip lens 65 that collects a light that enters from a subject and a color filter 66 provided directly below the on-chip lens 65 are provided on the light receiving surface of the sensor semiconductor element 21, i.e., the surface of the upper side in the drawing. Further, a photoelectric conversion element 67 is provided at the directly below part of the on-chip lens 65 and the color filter 66 in the silicon substrate 62. The photoelectric conversion element 67 photoelectrically converts a light that enters via the on-chip lens 65 and the color filter 66. Then, a voltage signal corresponding to the electric charge obtained by photoelectric conversion is output to the perpendicular signal line 57 via a field-effect transistor or the like provided in the silicon substrate 62.

In this example, the perpendicular signal line 57 is provided in the wiring layer 64, and the perpendicular signal line 57 is connected to an electrode 68 provided at an end, at the wiring layer 64 side, of the penetration via 51 penetrating the silicon substrate 62. Also, the electrode 52, the line 56, and the land electrode 53 provided at the end of the wiring layer 63 side of the penetration via 51 are provided together in the wiring layer 63.

Here, the perpendicular signal line 57, the electrode 68, the penetration via 51, the electrode 52, the line 56, and the electrode 54 are formed by a metal such as Cu (copper) for example. Also, the metal layer 55 is made of Ta (tantalum), TaN (tantalum nitride), or the like, for example.

Further, a logic semiconductor element 71 is mounted in a flip chip structure, in the peripheral region 23 at the light receiving surface side of the sensor semiconductor element 21.

The logic semiconductor element 71 includes a silicon substrate 81 and a wiring layer 82 provided on the surface of the silicon substrate 81. The wiring layer 82 is provided with a pad 83 of Al (aluminium) for connecting an undepicted line provided at the wiring layer 82 inner portion and the sensor semiconductor element 21. Also, a bump electrode 84 is formed on the pad 83, and further a micro bump 85 is formed on the electrode 84, and the micro bump 85 and the metal layer 55 are diffusion bonded by formic acid reduction or the like, so that the logic semiconductor element 71 is mounted in a flip chip structure on the sensor semiconductor element 21. Here, the bump electrode 84 is formed of Ni (nickel) for example, and the micro bump 85 is formed of an Sn-based solder such as SnAg (tin-silver).

In this solid-state image capturing device 11, a pixel of the sensor semiconductor element 21 is electrically connected to the logic semiconductor element 71 via the perpendicular signal line 57, the electrode 68, the penetration via 51, the electrode 52, the line 56, and the land electrode 53.

It is conceived that, when the logic semiconductor element 71 is mounted on the sensor semiconductor element 21, the silicon substrate 62 is penetrated directly below the logic semiconductor element 71 in the peripheral region 23, in order to provide a penetration via for connecting the wiring layer 63 and the wiring layer 64, for the purpose of electrically connecting the perpendicular signal line 57 in the wiring layer 64 and the logic semiconductor element 71.

However, in that way, the pitch of the pad 83 for connecting the sensor semiconductor element 21 and the logic semiconductor element 71 is large, and the pitch of the penetration via is also large, and therefore a line is unable to be provided in the part directly below the logic semiconductor element 71 in the silicon substrate 62 and the wiring layer 64. That is, there is no space for providing an element other than the penetration via. This necessitates an additional region for providing a line, and therefore the area efficiency of the sensor semiconductor element 21 decreases, and the size of the sensor semiconductor element 21 is enlarged.

Thus, in the solid-state image capturing device 11, the land electrode 53 of a large pitch (i.e. a wide width) is provided in the wiring layer 63 which is the top layer of the light receiving surface side of the sensor semiconductor element 21, and the penetration via 51 of a smaller pitch (i.e., a narrower width) which penetrates from the same wiring layer 63 as the land electrode 53 to the wiring layer 64 including the perpendicular signal line 57 is provided. Also, in the solid-state image capturing device 11, the logic semiconductor element 71 is mounted on the sensor semiconductor element 21 by one side solder connection process of the micro bump 85 and the land electrode 53, and the perpendicular signal line 57 and the logic semiconductor element 71 are electrically connected by the penetration via 51, the line 56, and the land electrode 53.

In this way, a plurality of penetration vias including the penetration via 51 is provided in a concentrated manner in the region R11 of a part of the peripheral region 23, and with this simple configuration a line is provided at the part directly below the logic semiconductor element 71 in the silicon substrate 62 and the wiring layer 64. Thereby, the area efficiency of the peripheral region 23 is improved, and the sensor semiconductor element 21 is reduced in size.

### <Description of Manufacturing Process>

Subsequently, a manufacturing process in which a manufacturing device manufactures a solid-state image capturing device to which an embodiment of the present technology is applied will be described. That is, in the following, a manufacturing process by a manufacturing device will be described with reference to the flowchart of Fig. 3 and Figs. 4 to 8. Note that the corresponding parts in Figs. 4 to 8 are denoted with the same reference signs, and their description will be omitted as appropriate.

In step S11, the manufacturing device forms a pixel circuit, i.e., a pixel including a photoelectric conversion element and a field-effect transistor, and an embedded line for electrically connecting those pixels, in each region of a plurality of sensor semiconductor elements on the sensor wafer.

In step S12, the manufacturing device stacks and joins the sensor wafer and the support substrate together. Then, in step S13, the manufacturing device thins the sensor wafer.

By the process of these step S11 to step S13, the sensor semiconductor element 121 is stacked and joined on the support substrate 122 as illustrated in Fig. 4.

That is, as indicated by the arrow B11, a part of the sensor wafer becomes a silicon substrate 123 part for configuring a sensor semiconductor element 121, and a plurality of photoelectric conversion elements including the photoelectric conversion element 124 are formed in the silicon substrate 123 in order to form pixels. Then, the wiring layer 125 having a plurality of lines including the line 126 made of Cu is formed on the silicon substrate 123, and the wiring layer 125 part of the sensor semiconductor element 121 and the support substrate 122 are stacked and joined together. Further, as indicated by the arrow B12, the silicon substrate 123 part of the sensor semiconductor element 121 is thinned (reduced in thickness).

Here, the silicon substrate 123 and the wiring layer 125 of the sensor semiconductor element 121 correspond to the silicon substrate 62 and the wiring layer 64, respectively, of the sensor semiconductor element 21 illustrated in Fig. 2, and the support substrate 122 corresponds to the support substrate 61 illustrated in Fig. 2.

In step S14, the manufacturing device etches the silicon substrate, and forms penetration holes and electrode grooves, and in step S15, the manufacturing device fills a conductor such as Cu in the penetration hole parts and the electrode grooves to form penetration vias, electrodes, and connection lines.

Thereby, as illustrated in Fig. 5 for example, a penetration via for electrically connecting two wiring layers provided on the surfaces that are opposite to each other of a silicon substrate 123, an electrode provided in a penetration via end part, and a connection line connected to the electrode are formed.

That is, as indicated by the arrow B13 of Fig. 5, an insulating film 131 is formed on the surface of the opposite side to the wiring layer 125 side in the silicon substrate 123. Then, the layer including the insulating film 131 becomes a wiring layer corresponding to the wiring layer 63 in Fig. 2.

Thereafter, the insulating film 131 and the silicon substrate 123 are etched partially. As a result, a penetration hole 133 that penetrates the silicon substrate 123 and reaches the Cu electrode 132 formed in the wiring layer 125, as well as a groove 134 of an electrode and a connection line for connecting to the semiconductor element such as the logic semiconductor element, are formed.

Further, as indicated by the arrow B14, an insulating film 135 is formed on the insulating film 131 part, the penetration hole 133, the groove 134 of connection line and electrode, and a plating process is performed with Cu at the parts of the penetration hole 133 and the groove 134. Also, the surface of the Cu plating part is polished (planarized) by chemical mechanical polish (CMP) or the like, in order to form a penetration via 136, an electrode 137, a connection line 138, and an electrode 139.

These penetration via 136 to electrode 139 correspond to the penetration via 51, the electrode 52, the line 56, and the electrode 54 in Fig. 2. The penetration via 136 to electrode 139 are an inter-substrate line for electrically connecting the sensor wafer having a plurality of sensor semiconductor elements 121 thereon to a semiconductor element such as a logic semiconductor element.

Note that, here, one penetration via 136 is depicted in the silicon substrate 123, but a plurality of penetration vias are actually provided in a concentrated manner in a predetermined region of the silicon substrate 123.

In step S16, the manufacturing device forms an insulating film on a connection line part and an electrode part connected to a penetration via and etches the electrode part in the insulating film, and in step S17 the manufacturing device applies a barrier metal to the part exposed by etching.

Thereby, for example, as indicated by the arrow B15 of Fig. 6, an insulating film 151 is further formed on the part of the insulating film, the electrode 137, the connection line 138, and the electrode 139 formed on the surface of the opposite side to the wiring layer 125 side in the silicon substrate 123. Then, the part at which the land electrode is formed in the insulating film 151, that is the part of the electrode 139, is opened by etching to form an opening 152.

Further, as indicated by the arrow B16, a barrier metal such as Ta and TaN is applied on the insulating film 151 and the part of the electrode 139 exposed by the opening 152 in order to form a metal layer 153, and a plating process is performed with Cu on the metal layer 153 in order to form a Cu metal layer 154.

In step S18, the manufacturing device forms an on-chip color filter and an on-chip lens.

Specifically, as indicated by the arrow B17 of Fig. 7 for example, a part of the metal layer 153 and the metal layer 154 is removed by polishing such as CMP, in order to form a land electrode including the electrode 139, the metal layer 153, and the metal layer 154. This land electrode corresponds to the land electrode 53 illustrated in Fig. 2. In particular, the electrode 139 corresponds to the electrode 54 of Fig. 2, and the metal layer 153 and the metal layer 154 correspond to the metal layer 55 of Fig. 2.

Thereafter, an insulating film 161 is formed on the part of the insulating film and the metal layer 154 formed on the surface of the opposite side to the wiring layer 125 side in the silicon substrate 123.

Also, as indicated by the arrow B18, the region of the pixel part in the insulating film 161 is etched to provide a step, in order to form a wiring layer 162 ultimately. This wiring layer 162 corresponds to the wiring layer 63 illustrated in Fig. 2.

Then, an on-chip color filter 163 is formed for each pixel at the step part, and a resin is further applied to the on-chip color filter 163 part and the insulating film 161 part in order to form an on-chip lens 164.

In step S19, after forming an opening in the land electrode part in the sensor semiconductor element, the manufacturing device dices the sensor wafer into a plurality of sensor semiconductor elements, and in step S20 the manufacturing device mounts the logic semiconductor element on each sensor semiconductor element obtained by the division.

For example, as indicated by the arrow B 19 of Fig. 8, the land electrode part in the wiring layer 162, that is the part of the metal layer 154, is opened so as to be exposed in order to form an opening 171, and thereafter the sensor wafer is separated into each sensor semiconductor element. That is, the sensor wafer is diced into the sensor semiconductor elements 121.

Then, as indicated by the arrow B20, a logic semiconductor element 172 is mounted in a flip chip structure, i.e., is stacked in a CoC structure on the metal layer 154 part of the sensor semiconductor element 121, in the opening 171. Note that, in the present specification, connecting the diced elements to each other is referred to as stacking in a CoC structure. In this example, the logic semiconductor element 172 includes a silicon substrate 181 and a wiring layer 182, and an Al pad 183 is provided in the wiring layer 182. Also, a bump electrode 184 is formed in the pad 183, and a micro bump 185 is formed on the electrode 184. When mounting the logic semiconductor element 172 on the sensor semiconductor element 121, the micro bump 185 and the metal layer 154 are diffusion bonded.

The land electrode including the electrode 139, the metal layer 153, and the metal layer 154 for mounting the logic semiconductor element 172 has a larger pitch (diameter) as compared with the penetration via 136, and this land electrode is provided on the layer (the most front surface) closest to the logic semiconductor element 172 in the sensor semiconductor element 121. Hence, a line is located in the part directly below the land electrode in the silicon substrate 123 and the wiring layer 125 of the sensor semiconductor element 121, in order to reduce the size of the sensor semiconductor element 121.

Also, as the logic semiconductor element 172 is mounted (connected) by the land electrode of the sensor semiconductor element 121 side, bump formation is unnecessary at the sensor semiconductor element 121 side, for the purpose of mounting the logic semiconductor element 172 after forming the on-chip lens 164. Thus, dusts generated by the bump formation do not adhere to the sensor semiconductor element 121, so as to improve the yield of the solid-state image capturing device.

Note that the silicon substrate 181 to micro bump 185 of the logic semiconductor element 172 correspond to the silicon substrate 81 to micro bump 85 illustrated in Fig. 2.

In this way, the logic semiconductor element is mounted on the sensor semiconductor element to form the solid-state image capturing device, when the manufacturing process ends.

As described above, the manufacturing device provides a penetration via of a narrower (smaller) width in the silicon substrate of the sensor semiconductor element, and provides a land electrode of a wider (larger) width in the wiring layer connected to the penetration via and closest to the logic semiconductor element in and the sensor semiconductor element, and mounts a logic semiconductor element on the land electrode.

In this way, the area efficiency of the sensor semiconductor element is improved with a simple configuration including a penetration via of a smaller width and a land electrode of a larger width, in order to obtain a small solid-state image capturing device.

Wafer to wafer stacking, which stacks and joins wafers together accurately and connects wafers with a narrow pitch, is not capable of stacking wafers of different sizes, whereas CoC stacking is capable of stacking semiconductor elements of optimal sizes one on another. However, in the CoC stacking, it is difficult to connect the semiconductor elements to each other with a narrow pitch, and the sensor semiconductor element side is to be provided with a penetration via penetrating the silicon substrate and the wiring layer with the same pitch as the electrode for connecting to the semiconductor element that is stacked and joined together.

Thus, in an embodiment of the present technology, the support substrate is stacked and joined on the sensor semiconductor element, and a penetration via of a narrow pitch is provided to penetrate the silicon substrate, and the penetration via is connected to the land electrode closest to the logic semiconductor element of the sensor semiconductor element. Then, the logic semiconductor element is connected to the land electrode, in order to allow the sensor semiconductor element and the logic semiconductor element to be an optimal semiconductor element size, and in order to connect the sensor semiconductor element and the logic semiconductor element electrically with a narrow pitch.

### <More Detailed Exemplary Configuration of Sensor Semiconductor Element>

Also, the land electrode vicinity part in the sensor semiconductor element of the solid-state image capturing device described above may be configured as illustrated in Fig. 9 for example in more detail.

In the example of Fig. 9, a support substrate 213 is stacked and joined by the plasma bonding or the like on a sensor semiconductor element 212 for configuring a solid-state image capturing device 211. Also, the sensor semiconductor element 212 includes a silicon substrate 214, and a wiring layer 215 and a wiring layer 216 including one or a plurality of layers which are provided on the surfaces of both sides of the silicon substrate 214.

In the wiring layer 215, an Al pad electrode 217 for electrically connecting to an outside of the sensor semiconductor element 212, an Al line 218, a Cu line 219, and a Cu electrode 220 are formed. In particular, the part of the pad electrode 217 is opened by an opening 221, and this part of the pad electrode 217 is connected to the outside by wire bonding.

Also, a plurality of photoelectric conversion elements including a photoelectric conversion element 222 are provided inside the silicon substrate 214, and a pixel is configured by a pixel circuit including a photoelectric conversion elements, a field-effect transistors, etc. Further, the silicon substrate 214 is provided with a penetration via 224 penetrating the silicon substrate 214 and connecting an electrode 223 provided in the wiring layer 216 and the electrode 220 provided in the wiring layer 215. This penetration via 224 corresponds to the penetration via 51 of Fig. 2.

In the wiring layer 216, a line 225 is connected to the electrode 223 provided at an end of the penetration via 224, and an electrode 226 is connected to an end of the line 225. Here, the electrode 223, the line 225, and the electrode 226 are formed of Cu in the same wiring layer 216, and these electrode 223, line 225, and electrode 226 correspond to the electrode 52, the line 56, and the electrode 54 of Fig. 2.

Further, in the wiring layer 216, a metal layer 227 including a layer of a plurality of metals such as Cu, Ta, and TaN is formed in the electrode 226, and the electrode 226 and the metal layer 227 form a land electrode corresponding to the land electrode 53 of Fig. 2. The metal layer 227 part configuring the land electrode is opened by the opening 228, and a logic semiconductor element is mounted by a bump at this opening 228.

Also, in the sensor semiconductor element 212, an on-chip color filter 229 is provided at the upper side in the drawing of the photoelectric conversion element such as the photoelectric conversion element 222, and an on-chip lens 230 is provided at the upper side in the drawing of the on-chip color filter 229.

Further, the wiring layer 216 is provided with shield metals 231 made of a metal such as W (tungsten). This shield metal 231 is a metal layer that provides a noise shielding function by electrically separating the silicon substrate 214 and the wiring layer 216 from each other and functions as a shading plate that shields a light from the outside.

In particular, the shield metal 231 is partially opened at the part between the on-chip color filter 229 and the photoelectric conversion element in the shield metal 231, so that the light that enters into the photoelectric conversion element from the outside is prevented from entering into another photoelectric conversion element adjacent to the photoelectric conversion element. Also, in the land electrode part, the shield metal 231 is provided between the silicon substrate 214 and the land electrode including the electrode 226 and the metal layer 227, in order to perform noise shielding shading. That is, the part other than the photoelectric conversion element that configures the pixel is shaded by the shield metal 231, in order to prevent the light from the outside from entering into the silicon substrate 214.

### <Description of Manufacturing Process>

Next, with reference to the flowchart of Fig. 10 and Figs. 11 to 16, a manufacturing process by the manufacturing device for manufacturing a solid-state image capturing device corresponding to the solid-state image capturing device 211 illustrated in Fig. 9 will be described. Note that the corresponding parts in Figs. 11 to 16 are denoted with the same reference signs, and their description will be omitted as appropriate. Also, in Figs. 11 to 16, the corresponding parts in one of Figs. 4 to 8 are denoted with the same reference signs, and their description will be omitted as appropriate.

In step S51, the manufacturing device forms a pixel and an embedded line in the region of each of a plurality of sensor semiconductor elements on the sensor wafer. Then, in step S52, the manufacturing device stacks and joins the sensor wafer and the support substrate together, and in step S53, the manufacturing device thins the sensor wafer. In these step S51 to step S53, the same processes as step S11 to step S13 of Fig. 3 are performed.

That is, as indicated by the arrow B31 of Fig. 11, the photoelectric conversion element 124 are formed on the silicon substrate 123 to form a pixel, and the wiring layer 125 including the Cu line 126 is formed on the silicon substrate 123. Then, the wiring layer 125 part of the sensor semiconductor element 121 and the support substrate 122 are stacked and joined together. Further, as indicated by the arrow B32, the silicon substrate 123 part of the sensor semiconductor element 121 is thinned (reduced in thickness).

Returning to the description of the flowchart of Fig. 10, in step S54 the manufacturing device performs sputtering and etching of the shield metal on the surface of the logic semiconductor element side of the silicon substrate in the sensor semiconductor element.

Specifically, as indicated by the arrow B33 of Fig. 12 for example, an insulating film 261 is formed on the surface of the opposite side to the support substrate 122 in the silicon substrate 123, and further a metal such as W is applied to the insulating film 261 part by sputtering, in order to form a shield metal 262. This shield metal 262 corresponds to the shield metal 231 in Fig. 9.

Also, as indicated by the arrow B34 of Fig. 12, a part of the shield metal 262 is removed by etching. Specifically, the pixel part of the shield metal 262 is removed, so that a light from the outside enters into each photoelectric conversion element such as the photoelectric conversion element 124, for example.

In step S55, the manufacturing device etches the silicon substrate, and forms penetration holes and electrode grooves, and in step S56, the manufacturing device fills a conductor in the penetration hole parts and the electrode grooves to form penetration vias, electrodes, and connection lines.

For example, as indicated by the arrow B35 of Fig. 13, the insulating film 131 is formed on the surface of the opposite side to the wiring layer 125 side in the silicon substrate 123, and thereafter the insulating film 131 and the silicon substrate 123 are etched partially. As a result, the penetration hole 133 that penetrates the silicon substrate 123 and reaches the electrode 132, and the groove 134 of connection line and electrode are formed.

Further, as indicated by the arrow B36, the insulating film 135 is formed on the insulating film 131 part, the penetration hole 133, and the groove 134 of connection line and electrode, and a plating process is performed with Cu on the part of the penetration hole 133 and the groove 134. Also, the Cu plating part front surface is planarized by CMP or the like, in order to form the penetration via 136, the electrode 137, the connection line 138, and the electrode 139.

Returning to the flowchart of Fig. 10, the penetration via or the like is formed, and thereafter the processes of step S57 to step S61 are performed to complete the manufacturing process. These process are same as the processes of step S16 to step S20 of Fig. 3, and therefore their detailed description will be omitted.

In these steps S57 to S61, as indicated by the arrow B37 of Fig. 14 for example, the insulating film 151 is further formed on the insulating film, the electrode 137, the connection line 138, and the part of the electrode 139 formed on the surface of the opposite side to the wiring layer 125 side in the silicon substrate 123. Then, the part of the electrode 139 is opened by etching to form the opening 152.

Further, as indicated by the arrow B38, a barrier metal such as Ta and TaN is applied on the insulating film 151 and the part of the electrode 139 exposed by the opening 152 in order to form a metal layer 153, and a plating process is performed with Cu on the metal layer 153 in order to form a Cu metal layer 154.

Also, as indicated by the arrow B39 of Fig. 15, a part of the metal layer 153 and the metal layer 154 is removed by polishing such as CMP, and the land electrode including the electrode 139, the metal layer 153, and the metal layer 154 is formed. Thereafter, the insulating film 161 is formed on the part of the insulating film and the metal layer 154 of the silicon substrate 123.

Further, as indicated by the arrow B40, the region of the pixel part in the insulating film 161 is etched to form a step, so that the layer stacked and provided on the upper side in the drawing of the silicon substrate 123 becomes the wiring layer 162. Then, the on-chip color filter 163 is formed for each pixel on the step part of the insulating film 161, and a resin is further applied to the on-chip color filter 163 part and the insulating film 161 part to form the on-chip lens 164.

Thereafter, as indicated by the arrow B41 of Fig. 16, the land electrode part in the wiring layer 162 (i.e., the part of the metal layer 154) is opened so as to be exposed to form the opening 171, and each sensor semiconductor element is separated from the sensor wafer.

Then, as indicated by the arrow B42, the logic semiconductor element 172 is mounted in a flip chip structure, i.e., is stacked in a CoC structure on the metal layer 154 part, in the opening 171. When mounting the logic semiconductor element 172, the micro bump 185 and the metal layer 154 are diffusion bonded.

In this way, the logic semiconductor element is mounted on the sensor semiconductor element to form a solid-state image capturing device, when the manufacturing process ends.

As described above, the manufacturing device provides a penetration via of a narrower (smaller) width in the silicon substrate of the sensor semiconductor element, and provides a land electrode of a wider (larger) width in the wiring layer connected to the penetration via and closest to the logic semiconductor element in and the sensor semiconductor element, and mounts a logic semiconductor element on the land electrode.

In this way, the area efficiency of the sensor semiconductor element is improved with a simple configuration including a penetration via of a smaller width and a land electrode of a larger width, in order to obtain a small solid-state image capturing device.

### <Exemplary Variant 1 of First Embodiment>

### <Exemplary Configuration of Sensor Semiconductor Element>

Note that, in the configuration of the sensor semiconductor element 212 of the solid-state image capturing device 211 illustrated in Fig. 9, the surface part of the upper side in the drawing of the land electrode on which the logic semiconductor element is mounted, that is the part of the metal layer 227, is positioned at the upper side in the drawing than the line 225 and the electrode 223 connected to the land electrode. That is, the land electrode protrudes upward in the drawing relative to the top face of the line 225 and the electrode 223.

If there is a step of the land electrode part relative to the line 225 and the electrode 223, it is difficult to apply resin material evenly on the wiring layer 216, when forming the on-chip lens 230.

Thus, the silicon substrate 214 may be engraved to form an appropriate groove and thereafter a land electrode, in order to eliminate the step between the land electrode and the line 225 and the electrode 223, so that the resin material is applied more evenly. In that case, the sensor semiconductor element 212 is configured as illustrated in Fig. 17, for example. Note that, in Fig. 17, the corresponding parts in Fig. 9 are denoted with the same reference signs, and their description will be omitted as appropriate.

In the sensor semiconductor element 212 illustrated in Fig. 17, a part of the silicon substrate 214 is engraved to form a groove, and the shield metal 291 and the electrode 292 corresponding to the shield metal 231 and the electrode 226 of Fig. 9 is formed. Then, the metal layer 293 corresponding to the metal layer 227 of Fig. 9 is formed on the upper portion of the electrode 292 in the wiring layer 216, and the land electrode including the electrode 292 and the metal layer 293 is configured.

In this example, the top face of the land electrode (i.e., the top face of the metal layer 293) and the top face of the line 225 and the electrode 223 are included in the same flat surface. That is, the groove formed by engraving the silicon substrate 214 reduces the step of the land electrode relative to the line 225 and the electrode 223. Hence, when forming the on-chip lens by applying the insulating film and the resin material on the top face of the land electrode, the line 225, and the electrode 223, the resin material can be applied evenly.

### <Description of Manufacturing Process>

Next, with reference to the flowchart of Fig. 18 and Figs. 19 to 23, a manufacturing process by the manufacturing device for manufacturing a solid-state image capturing device corresponding to the solid-state image capturing device 211 illustrated in Fig. 17 will be described. Note that the corresponding parts in Figs. 19 to 23 are denoted with the same reference signs, and their description will be omitted as appropriate. Also, in Figs. 19 to 23, the corresponding parts in one of Figs. 11 to 16 are denoted with the same reference signs, and their description will be omitted as appropriate.

In step S91, the manufacturing device forms a pixel and an embedded line in the region of each of a plurality of sensor semiconductor elements on the sensor wafer. Then, in step S92, the manufacturing device stacks and joins the sensor wafer and the support substrate together, and in step S93, the manufacturing device thins the sensor wafer. In these step S91 to step S93, the same processes as step S11 to step S13 of Fig. 3 are performed.

That is, as indicated by the arrow B61 of Fig. 19, the photoelectric conversion element 124 are formed on the silicon substrate 123 to form a pixel, and the wiring layer 125 is formed on the silicon substrate 123. Then, the wiring layer 125 part of the sensor semiconductor element 121 and the support substrate 122 are stacked and joined together. Further, as indicated by the arrow B62, the silicon substrate 123 part of the sensor semiconductor element 121 is thinned (reduced in thickness).

Returning to the description of the flowchart of Fig. 18, in step S94, the manufacturing device engraves the surface of the opposite side to the support substrate side in the silicon substrate by etching or the like, in order to form a groove for reducing the above step of the land electrode part.

In step S95, the manufacturing device performs sputtering and etching of the shield metal on the surface of the silicon substrate in which the groove is formed in the process of step S94.

For example, as indicated by the arrow B63 of Fig. 20, a groove 321 is formed by engraving, by etching or the like, a part of the surface of the opposite side to the support substrate 122 in the silicon substrate 123, by the process of step S94 and step S95.

Further, as indicated by the arrow B64, an insulating film 322 is formed on the surface part of the silicon substrate 123 and the groove 321 part formed in the surface. Further, metal such as W is applied to the insulating film 322 part by sputtering in order to form a shield metal 323, and a part of the shield metal 323 is removed by etching.

For example, the pixel part of the shield metal 323 is removed to allow a light from the outside to enter into each photoelectric conversion element such as the photoelectric conversion element 124, and the part for providing the penetration via penetrating the silicon substrate 123 in the shield metal 323 is removed.

The shield metal 323 formed in this way corresponds to the shield metal 291 in Fig. 17.

In step S96, the manufacturing device etches the silicon substrate and forms the penetration hole, and in step S97 the manufacturing device performs a plating process on the penetration hole part and the shield metal part.

For example, as indicated by the arrow B65 of Fig. 21, the insulating film 131 is formed on the part of the shield metal 323 provided on the surface of the opposite side to the wiring layer 125 side in the silicon substrate 123. Thereafter, the region of a part of the insulating film 131 and the silicon substrate 123 is etched, in order to form the penetration hole 133 that penetrates the silicon substrate 123 and reaches the electrode 132.

Also, as indicated by the arrow B66, an insulating film 331 is further formed on the insulating film 131 part and the penetration hole 133 part, and a plating process is performed with Cu on the part of the insulating film 331. Thereby, a metal layer 332 is formed of Cu, and a part of this metal layer 332, that is the part of the penetration hole 133, becomes the penetration via 136.

Further, a barrier metal such as Ta and TaN is thereafter applied on the metal layer 332 part in order to form a metal layer 333, and a plating process is performed with Cu on the metal layer 333 in order to form a Cu metal layer 334.

In step S98, the manufacturing device polishes and planarizes, by CMP or the like, the metal layer formed by the process of step S97, in order to form an electrode and a connection line.

Then, the processes of step S99 to step S101 are thereafter performed to complete the manufacturing process. These processes are same as the processes of step S18 to step S20 of Fig. 3, and therefore their detailed description will be omitted.

In step S98 to step S101, first, a part of the metal layer 332 to the metal layer 334 illustrated in Fig. 21 are polished by CMP or the like to be planar. Thereby, as indicated by the arrow B67 of Fig. 22, at the part of the metal layer 332, there are formed the electrode 137 provided at the end of the penetration via 136, the connection line 138 connected to the electrode 137, and the electrode 361 provided at the end of the connection line 138. Also, on the electrode 361, the remaining part that is not removed by planarization in the metal layer 333 and the metal layer 334 becomes the metal layer for configuring the land electrode.

These electrode 137, connection line 138, and electrode 361 correspond to the electrode 223, the line 225, and the electrode 292 illustrated in Fig. 17. Also, the metal layer including the metal layer 333 and the metal layer 334 corresponds to the metal layer 293 illustrated in Fig. 17.

Thus, in the example illustrated in Fig. 22, the land electrode is configured by the electrode 361, the metal layer 333, and the metal layer 334. The top face of the land electrode is included in the same flat surface as the top face of the electrode 137 and the connection line 138. That is, there is no step between the land electrode, the electrode 137, and the connection line 138.

In this way, the land electrode is formed, and thereafter the insulating film 161 is formed on the part of the insulating film of the silicon substrate 123, the electrode 137, the connection line 138, the metal layer 334, as indicated by the arrow B68 of Fig. 22.

Further, the region of the pixel part in the insulating film 161 is etched in order to form a step, so that the layer stacked and provided on the upper side in the drawing of the silicon substrate 123 becomes the wiring layer 162. This wiring layer 162 corresponds to the wiring layer 216 in Fig. 17.

Then, the on-chip color filter 163 is formed for each pixel on the step part of the insulating film 161, and a resin is further applied to the on-chip color filter 163 part and the insulating film 161 part to form the on-chip lens 164.

In this case, in the example indicated by the arrow B68, the part of the electrode 137, the connection line 138, and the metal layer 334 are substantially planar, and therefore the step part of the insulating film formed at the upper side in the drawing, that is the step of the part indicated by the arrow Q11, is smaller than the step of the corresponding part in the example indicated by the arrow B40 of Fig. 15. Thus, the resin material is applied evenly, when forming the on-chip lens 164 and the on-chip color filter 163.

Thereafter, as indicated by the arrow B69 of Fig. 23, the land electrode part in the wiring layer 162 (i.e., the part of the metal layer 334) is opened so as to be exposed to form the opening 171, and each sensor semiconductor element is separated from the sensor wafer.

Then, as indicated by the arrow B70, the logic semiconductor element 172 is mounted in a flip chip structure, i.e., is stacked in a CoC structure on the metal layer 334 part, in the opening 171. When mounting the logic semiconductor element 172, the micro bump 185 and the metal layer 334 are diffusion bonded.

In this way, the logic semiconductor element is mounted on the sensor semiconductor element to form a solid-state image capturing device, when the manufacturing process ends.

As described above, the manufacturing device engraves a part of the silicon substrate in order to form a groove, and thereafter forms the shield metal and the land electrode. In this way, a resin material is applied evenly on the wiring layer when forming the on-chip lens, and a high quality solid-state image capturing device is obtained in a simple manner.

### <Second Embodiment. Not covered by the scope of the claims>

### <Exemplary Configuration of Solid-State Image Capturing Device>

In the meantime, in the above, an example has been described in which the size of the solid-state image capturing device is reduced, by providing a penetration via having a smaller pitch (width) and penetrating the silicon substrate in the sensor semiconductor element, and providing a land electrode of a larger pitch via the line on the penetration via, and mounting a logic semiconductor element on the sensor semiconductor element by the land electrode. However, a small solid-state image capturing device can be obtained simply, if the support member stacked and joined on the sensor semiconductor element is an interposer substrate on which a semiconductor element such as a logic semiconductor element is mounted.

When the semiconductor element is mounted on the interposer substrate as described above, the solid-state image capturing device is configured as illustrated in Fig. 24, for example.

In the example illustrated in Fig. 24, the solid-state image capturing device 391 is an image sensor of a back side illumination type, and the solid-state image capturing device 391 includes a housing 401, a sensor semiconductor element 402, an interposer substrate 403, a semiconductor element 404, and a cover glass 405.

That is, in the solid-state image capturing device 391, the interposer substrate 403 is stacked and joined with the sensor semiconductor element 402 which is a semiconductor element, and the semiconductor element 404 is mounted on the surface of the opposite side to the sensor semiconductor element 402 side in the interposer substrate 403. Here, the sensor semiconductor element 402 and the interposer substrate 403 are stacked and joined together by plasma bonding or the like, for example. The interposer substrate 403 is a semiconductor element that functions as a support member of the sensor semiconductor element 402, and the joining surfaces between the sensor semiconductor element 402 and the interposer substrate 403 have the same shape and the same area as each other.

Then, these sensor semiconductor element 402, interposer substrate 403, and semiconductor element 404 are fixed in the housing 401 inner portion. Also, the cover glass 405 is provided at the housing 401 upper portion to prevent the dust from outside from adhering to the sensor semiconductor element 402.

Further, in the solid-state image capturing device 391, the interposer substrate 403 and the housing 401 are connected electrically by wire bonding.

For example, a pad electrode 411-1 made of Al or the like is provided in the wiring layer closest to the sensor semiconductor element 402 in the interposer substrate 403, and the pad electrode 411-1 is exposed by an opening 412-1 provided in the sensor semiconductor element 402. Also, in the housing 401, a pad electrode 413-1 made of Al or the like is provided at the vicinity of the pad electrode 411-1, and these pad electrode 411-1 and pad electrode 413-1 are connected by a wire 414-1.

These pad electrode 411-1 and pad electrode 413-1 are a pad electrode for supplying power from the housing 401 to the interposer substrate 403, or a pad electrode for outputting a signal to the housing 401 from the interposer substrate 403.

Similarly, a pad electrode 411-2 made of Al or the like is provided in the wiring layer of the interposer substrate 403, and the pad electrode 411-2 is exposed by an opening 412-2 provided in the sensor semiconductor element 402. Also, in the housing 401, a pad electrode 413-2 made of Al or the like is provided at the vicinity of the pad electrode 411-2, and these pad electrode 411-2 and pad electrode 413-2 are connected by a wire 414-2.

Note that, in the following, when it is unnecessary to distinguish the pad electrode 411-1 from the pad electrode 411-2 particularly, they are also referred to as a pad electrode 411 simply, and when it is unnecessary to distinguish the opening 412-1 from the opening 412-2 particularly, they are also referred to as an opening 412 simply. Also, when it is unnecessary to distinguish the pad electrode 413-1 from the pad electrode 413-2 particularly, they are also referred to as a pad electrode 413 simply, and when it is unnecessary to distinguish the wire 414-1 from the wire 414-2 particularly, they are also referred to as a wire 414 simply.

In the solid-state image capturing device 391, a light from a subject enters into a pixel of the sensor semiconductor element 402 via the cover glass 405, and photoelectric conversion is performed by the photoelectric conversion element in the pixel.

### <Exemplary Configuration of Sensor Semiconductor Element and Interposer Substrate>

Also, in more detail, the sensor semiconductor element 402 and the interposer substrate 403 are configured as indicated by the arrow A31 of Fig. 25 for example. Note that, in Fig. 25, the corresponding parts to Fig. 24 are denoted with the same reference signs, and their description will be omitted as appropriate.

In the example indicated by the arrow A31 of Fig. 25, the sensor semiconductor element 402 includes a silicon substrate 441 and a wiring layer 442 stacked at the interposer substrate 403 side in the silicon substrate 441. Here, the wiring layer 442 includes one or a plurality of layers (wiring layers).

In the silicon substrate 441, a plurality of photoelectric conversion elements, such as a photoelectric conversion element 443, are provided, and an on-chip lens 444 is formed for each pixel at the light receiving surface side of the silicon substrate 441, that is, the upper side in the drawing of the photoelectric conversion element. In the silicon substrate 441 as well, each pixel includes a photoelectric conversion element that receives and photoelectrically converts a light from a subject, an electric charge accumulating section that accumulates an electric charge obtained by the photoelectric conversion element, and a pixel circuit including a plurality of field-effect transistors.

Also, the wiring layer 442 of the sensor semiconductor element 402 is provided with a line, such as a line 445 made of Cu or the like. For example, the line 445 is provided in the layer closest to the silicon substrate 441, which configures the wiring layer 442.

Further, the silicon substrate 441 is provided with a penetration via 446 that penetrates the silicon substrate 441 and connects the line 445 and the line provided on the surface (layer) at the light receiving surface side of the silicon substrate 441. Also, the sensor semiconductor element 402, is provided with a penetration via 447 that is connected to the penetration via 446 and penetrates the silicon substrate 441 and the wiring layer 442.

These penetration via 446 and penetration via 447 are made of Cu or the like for example, and is a via of a comparatively small diameter, i.e., a diameter (pitch) of approximately 2 to 10 µm. That is, the penetration via 446 and the penetration via 447 are comparatively narrow vias.

Also, the interposer substrate 403 includes a silicon substrate 451, and a wiring layer 452 and a wiring layer 453 provided on both surfaces of the silicon substrate 451. Here, the wiring layer 452 and the wiring layer 453 include one or a plurality of layers (wiring layers).

The wiring layer 452 provided at the sensor semiconductor element 402 side of the silicon substrate 451 is provided with the above pad electrode 411 and a line 454 made of Al or the like.

In this example, the penetration via 447 penetrates the silicon substrate 441 and the wiring layer 442 of the sensor semiconductor element 402, and reaches the line 454. Hence, the line 445 provided in the wiring layer 442 of the sensor semiconductor element 402 and the line 454 provided in the wiring layer 452 of the interposer substrate 403 are connected electrically to each other via the penetration via 446 and the penetration via 447. Note that the penetration via 446 and the penetration via 447 are connected electrically on the surface of the light receiving surface side of the silicon substrate 441.

Also, the silicon substrate 451 of the interposer substrate 403 is provided with a plurality of penetration vias, such as a penetration via 455, which electrically connect the wiring layer 452 and the wiring layer 453. For example, the penetration vias such as the penetration via 455 penetrating the silicon substrate 451 are formed of Cu or the like, and the diameters (pitches) of these penetration vias are 50 to 200 µm for example.

The wiring layer 453 is provided with a line 456 made of Cu or the like, and an electrode 457 and an electrode 458 made of Al or the like. In this example, the line 454 provided in the wiring layer 452 and the line 456 provided in the wiring layer 453 are connected electrically to each other by the penetration via 455.

Also, the electrode 457 and the electrode 458 provided in the wiring layer 453 are electrodes for mounting a semiconductor element. In this example, micro bumps are formed on a plurality of electrodes such as the electrode 457, and a logic semiconductor element 471 is mounted in a flip chip structure on the interposer substrate 403 by those micro bumps. For example, the logic semiconductor element 471 is mounted on the interposer substrate 403 by a micro bump 459 provided on the electrode 457.

In the same way, micro bumps are formed on a plurality of electrodes such as the electrode 458, and a dynamic random access memory (DRAM) semiconductor element 472 is mounted in a flip chip structure on the interposer substrate 403 by those micro bumps. For example, the DRAM semiconductor element 472 is mounted on the interposer substrate 403 by the micro bump 460 provided on the electrode 458.

Here, the logic semiconductor element 471 including a logic circuit to perform a signal processing and a DRAM semiconductor element 472 including a memory circuit to function as a memory correspond to the semiconductor element 404 illustrated in Fig. 24.

The logic semiconductor element 471 includes a silicon substrate 481 and a wiring layer 482. The wiring layer 482 includes one or a plurality of layers (wiring layers), and in this example the wiring layer 482 is provided with a line 483 made of Cu or the like, and an electrode 484 made of Al or the like. For example, the electrode 484 of the logic semiconductor element 471 and the electrode 457 of the interposer substrate 403 are connected in a flip chip structure by the micro bump 459.

The DRAM semiconductor element 472 includes a silicon substrate 485 and a wiring layer 486. The wiring layer 486 includes one or a plurality of layers (wiring layers), and in this example the wiring layer 486 is provided with a line 487 made of Cu or the like, and an electrode 489 made of Al or the like. For example, the electrode 489 of the DRAM semiconductor element 472 and the electrode 458 of the interposer substrate 403 are connected in a flip chip structure by the micro bump 460.

Here, the diameter (pitch) of each of the micro bump 459, the micro bump 460, the electrode 457, the electrode 484, the electrode 458, and the electrode 489 is 10 to 40 µm, for example. That is, the diameter (width) of each of the micro bump 459, the micro bump 460, the electrode 457, the electrode 484, the electrode 458, and the electrode 489 is larger (wider) than the pitches of the penetration via 446 and the penetration via 447, and is smaller (narrower) than the pitch of the penetration via 455.

When the sensor semiconductor element 402 indicated by the arrow A31 is seen in the downward direction from the above in the drawing, an effective pixel region 491 including a plurality of pixels arranged in matrix form is provided at the center of the sensor semiconductor element 402, and the region outside the effective pixel region 491 is a peripheral region 492, as indicated by the arrow A32 for example.

The region of the outer circumference side of the peripheral region 492 is provided with a plurality of openings, such as an opening 412 represented by a quadrangle in the drawing, are aligned. Then, in the part of those openings, pad electrodes such as the pad electrode 411 are provided, and the sensor semiconductor element 402 is connected electrically to the housing 401 by a wire connected to those pad electrodes.

Also, a plurality of paired penetration vias, such as the penetration via 446 and the penetration via 447, represented by circles in the drawing are provided between the effective pixel region 491 and openings such as the opening 412 in the peripheral region 492. The sensor semiconductor element 402 and the interposer substrate 403 are connected electrically by these penetration vias. That is, the sensor semiconductor element 402 and the interposer substrate 403 are connected electrically in a twin contact structure by the penetration via 446 and the penetration via 447.

Further, when the interposer substrate 403 indicated by the arrow A31 is seen in the downward direction from the above in the drawing, a plurality of penetration vias (such as the penetration via 455 represented by a circle in the drawing) of a larger pitch than penetration vias such as the penetration via 446 and the penetration via 447 are provided in the entire interposer substrate 403, as indicated by the arrow A33 for example.

Also, when the interposer substrate 403 indicated by the arrow A31 is seen in the upward direction from below in the drawing, a plurality of connection electrodes represented by circles in the drawing are provided in the region where the logic semiconductor element 471 and the DRAM semiconductor element 472 of the interposer substrate 403 are mounted, as indicated by the arrow A34 for example. For example, in the region of the mounting part of the logic semiconductor element 471, a plurality of electrodes, such as the electrode 457, of a small pitch than penetration vias such as the penetration via 455 are provided. In the same way, in the region of the mounting part of the DRAM semiconductor element 472, a plurality of electrodes, such as the electrode 458, of a small pitch than penetration vias such as the penetration via 455 are provided.

For example, when trying to mount the logic semiconductor element on the surface of the opposite side to the light receiving surface of the sensor semiconductor element, a sensor wafer including a plurality of sensor semiconductor elements formed thereon and a logic wafer including a plurality of logic semiconductor elements formed thereon are normally stacked and joined together. In this case, the sensor wafer and the logic wafer are to have the same area and the same shape, and therefore in some cases the logic semiconductor element is larger than necessary, for example when the sensor semiconductor element is large, and it is difficult to reduce the size of the solid-state image capturing device.

Also, stacking and joining the sensor wafer and the logic wafer together makes it not possible to select non-defective products of semiconductor elements before stacking and joining them together, and thus the yield is difficult to improve.

In contrast, the solid-state image capturing device 391 is configured such that the interposer substrate 403 that functions as the support substrate is stacked and joined on the sensor semiconductor element 402, and the logic semiconductor element 471 and the DRAM semiconductor element 472 are mounted in a flip chip structure on the surface of the opposite side to the sensor semiconductor element 402 in the interposer substrate 403.

In this way, sufficient strength is secured as the strength of the sensor semiconductor element 402. As a result, the size of the semiconductor element is not restricted, but the logic semiconductor element 471 and the DRAM semiconductor element 472 of any size can be mounted (equipped) on the sensor semiconductor element 402 via the interposer substrate 403, in order to reduce the size of the solid-state image capturing device 391. In the example of Fig. 25, the logic semiconductor element 471 and the DRAM semiconductor element 472 are semiconductor elements that are smaller than the sensor semiconductor element 402. In other words, the areas of the mounting parts of the logic semiconductor element 471 and the DRAM semiconductor element 472 are narrower than the entire surface area of the interposer substrate 403 on which those semiconductor elements are mounted.

Also, the regions for mounting the logic semiconductor element 471 and the DRAM semiconductor element 472 are needless to be provided in the sensor semiconductor element 402. That is, it is needless to provide an electrode of a comparatively large pitch such as the electrode 457 and the electrode 458 in the sensor semiconductor element 402, and the sensor semiconductor element 402 and the interposer substrate 403 are electrically connected by the penetration via 446 and the penetration via 447 of a small pitch (width), and therefore the area efficiency of the sensor semiconductor element 402 is improved. Thereby, the size of the solid-state image capturing device 391 is reduced.

Further, the interposer substrate 403 is stacked and joined on the sensor semiconductor element 402 to secure the sufficient strength, and the logic semiconductor element 471 and the DRAM semiconductor element 472 are stacked in a CoC structure on the sensor semiconductor element 402 via the interposer substrate 403. Thus, before stacked in a CoC structure, i.e., before joined, non-defective products of the sensor semiconductor element 402, the logic semiconductor element 471, and the DRAM semiconductor element 472 are selected to improve the yield in manufacturing the solid-state image capturing device 391.

Also, if the sensor semiconductor element 402 is stacked and joined on the interposer substrate 403 including the penetration via 455 formed therein, the solid-state image capturing device 391 can be obtained in a simpler manner than when the support substrate is stacked and joined on the sensor semiconductor element 402 and thereafter the penetration via for drawing out the inter-semiconductor-element connection electrode is formed on the support substrate.

### <Description of Manufacturing Process, not covered by the scope of the claims>

Subsequently, a manufacturing process in which a manufacturing device manufactures a solid-state image capturing device to which an embodiment of the present technology is applied will be described. That is, in the following, a manufacturing process by a manufacturing device will be described with reference to the flowchart of Fig. 26 and Figs. 27 to 29. Note that the corresponding parts in Figs. 27 to 29 are denoted with the same reference signs, and their description will be omitted as appropriate.

In step S131, the manufacturing device forms a pixel circuit, i.e., a pixel including a photoelectric conversion element and a field-effect transistor, and an embedded line for electrically connecting those pixels, in each region of a plurality of sensor semiconductor elements on the sensor wafer.

In step S132, the manufacturing device stacks and joins the sensor wafer on the interposer wafer provided with a plurality of interposer substrates. Then, in step S133, the manufacturing device thins the sensor wafer, and in step S134 the manufacturing device forms the penetration vias that electrically connects the sensor semiconductor element and the interposer substrate.

By the processes of these step S131 to step S134, the sensor wafer provided with the sensor semiconductor element 531 as illustrated in Fig. 27 and the interposer wafer provided with the interposer substrate 532 are stacked and joined together by wafer to wafer stacking (joining). Note that, in the sensor wafer and the interposer wafer, their joining surfaces have the same shape and the same area as each other. In this case, the joining surfaces between the sensor semiconductor element 531 and the interposer substrate 532 also have the same shape and the same area as each other.

For example, as indicated by the arrow B81 of Fig. 27, a part of the sensor wafer is the silicon substrate 541 part for configuring the one sensor semiconductor element 531, and the wiring layer 542 is formed on the silicon substrate 541.

For example, in the silicon substrate 541, a plurality of photoelectric conversion elements including the photoelectric conversion element 543 are formed to provide a plurality of pixels. Then, a plurality of lines and other elements, such as the Cu line 544 and the electrode 545, are formed on the silicon substrate 541 to provide the wiring layer 542.

The silicon substrate 541 and the wiring layer 542 of the sensor semiconductor element 531 correspond to the silicon substrate 441 and the wiring layer 442 of the sensor semiconductor element 402 illustrated in Fig. 25.

Also, a part of the interposer wafer is the silicon substrate 551 part for configuring one interposer substrate 532, and a wiring layer 552 and a wiring layer 553 provided with the embedded lines by stacking are formed on both surfaces of the silicon substrate 551 part.

For example, in the wiring layer 552, there are formed an Al line 554, a Cu line 555, an Al electrode 556, an Al pad electrode 557, etc, and in the wiring layer 553, there are formed a Cu electrode 558, an Al electrode 559, a Cu line 560, etc. Further, in the silicon substrate 551, there is formed a Cu penetration via 561 that penetrates the silicon substrate 551 and a part of the wiring layer 552 and the wiring layer 553.

The interposer wafer functions as the support substrate of the sensor wafer, and for example, the interposer wafer has a diameter of 300 µm and a thickness of 500 µm in order to secure the strength that can endure the wafer process.

Here, the silicon substrate 551 to the wiring layer 553 of the interposer substrate 532 correspond to the silicon substrate 451 to the wiring layer 453 of the interposer substrate 403 illustrated in Fig. 25, respectively. In particular, the penetration via 561 and the electrode 559 correspond to the penetration via 455 and the electrode 457 illustrated in Fig. 25.

In this way, the sensor semiconductor element 531 is formed in the sensor wafer, and the interposer substrate 532 is formed in the interposer wafer, and the sensor wafer and the interposer wafer are stacked and joined together as indicated by the arrow B82, and thereafter the silicon substrate 541 part of the sensor semiconductor element 531 is thinned (reduced in thickness).

Further, a groove penetrating the silicon substrate 541 and the wiring layer 542 and a part of the wiring layer 552, as well as a groove penetrating the silicon substrate 541 and a part of the wiring layer 542, is formed by etching, and a plating process is performed with Cu on the groove parts to form the penetration via.

Thereby, a Cu penetration via 572 that electrically connects a line 571 formed on the surface of the opposite side to the wiring layer 542 in the silicon substrate 541 and the electrode 556 of the interposer substrate 532 is formed. This penetration via 572 penetrates the silicon substrate 541 and the wiring layer 542. Also, a Cu penetration via 573 that penetrates the silicon substrate 541 and electrically connects the line 571 and the electrode 545 of the wiring layer 542 is formed. Thereby, the electrode 545 and the electrode 559 are electrically connected to each other by the penetration via 573, the penetration via 572, and the penetration via 561.

These penetration via 572 and penetration via 573 correspond to the penetration via 446 and the penetration via 447 illustrated in Fig. 25.

In step S135, the manufacturing device forms an on-chip color filter and an on-chip lens. Also, in step S136, the manufacturing device forms a micro bump on the connection electrode of the interposer substrate.

For example, as indicated by the arrow B83 of Fig. 28, resin is applied on the light receiving surface side of the silicon substrate 541, which is the surface of the opposite side to the wiring layer 542, and thereafter an on-chip color filter 581 is formed for each pixel, and further resin is applied on the on-chip color filter 581 part to form an on-chip lens 582.

Also, the silicon substrate 541, the wiring layer 542, and the wiring layer 552 are engraved and opened by etching or the like to the part of the pad electrode 557, in order to form an opening 583. The pad electrode 557 is exposed by the opening 583. Here, the pad electrode 557 corresponds to the pad electrode 411 of Fig. 25.

Further, as indicated by the arrow B84, a micro bump is formed by a solder such as SnAg on the connection electrode exposed by the opening part in the interposer substrate 532. In this example, a micro bump 601 is formed on the electrode 559 provided in the wiring layer 553 in the interposer substrate 532, for example.

In step S137, the manufacturing device mounts the logic semiconductor element on the interposer substrate to form a single semiconductor element, and in step S138 the manufacturing device dices the wafer including the sensor wafer and the interposer wafer into the semiconductor elements obtained in the process of step S137.

For example, as indicated by the arrow B85 of Fig. 29, a logic semiconductor element 611 is mounted in a flip chip structure on the interposer substrate 532 in order to form a single semiconductor element 612 including the sensor semiconductor element 531, the interposer substrate 532, and the logic semiconductor element 611. That is, the logic semiconductor element 611 diced in advance is connected in a chip on wafer (CoW) structure, to the part of the interposer substrate 532 of a single wafer formed by stacking and joining the interposer wafer including the interposer substrate 532 formed therein and the sensor wafer including the sensor semiconductor element 531 formed therein. Note that, in the present specification, connecting the diced element to the element on the wafer is referred to as CoW connection.

In this example, the logic semiconductor element 611 includes a silicon substrate 613 and a wiring layer 614, and a line 615 made of Cu or the like and a connection electrode 616 made of Al are formed in the wiring layer 614. Also, in the electrode 616, a micro bump 617 is formed of a solder such as SnAg, and the micro bump 617 and the micro bump 601 are connected with each other, and thereby the logic semiconductor element 611 is mounted in a flip chip structure (connected in a flip chip structure) on the interposer substrate 532. Thereby, the line 615 of the logic semiconductor element 611 is connected electrically to the electrode 559 of the interposer substrate 532. As a result, the penetration via 561 electrically connects the line 615 of the logic semiconductor element 611 and an undepicted line connected to the electrode 545 of the sensor semiconductor element 531.

Here, the logic semiconductor element 611 corresponds to the logic semiconductor element 471 of Fig. 25 for example, and the logic semiconductor element 611 is a semiconductor element that is smaller than the sensor semiconductor element 531.

Further, as indicated by the arrow B86, a single wafer 621 on which a plurality of semiconductor elements, such as the semiconductor element 612, are formed is diced into a plurality of semiconductor elements. Thereafter, each semiconductor element such as the semiconductor element 612 is connected to the housing 401 illustrated in Fig. 24, in order to form a solid-state image capturing device.

In this way, the semiconductor element obtained by dicing the wafer is installed in the housing to form a solid-state image capturing device, and the manufacturing process ends.

As described above, the manufacturing device stacks and joins the sensor semiconductor element and the interposer substrate together by wafer to wafer stacking, and mounts in a flip chip structure, the semiconductor element such as the logic semiconductor element, on the surface of the opposite side to the sensor semiconductor element in the interposer substrate.

In this way, the size of the semiconductor element is not restricted, and a semiconductor element of any size can be mounted on the sensor semiconductor element via the interposer substrate, in order to reduce the size of the solid-state image capturing device.

In particular, in the sensor semiconductor element, a region for mounting a semiconductor element such as the logic semiconductor element is needless, and the sensor semiconductor element and the interposer substrate are electrically connected by the penetration via of a small pitch (width), and therefore area efficiency is improved in order to reduce the size of the solid-state image capturing device.

Note that, in the above, as illustrated in Fig. 29, an example has been described in which micro bumps are formed on both of the interposer substrate 532 and the semiconductor element such as the logic semiconductor element 611 in order to connect the interposer substrate 532 and the semiconductor element.

However, as describe in the example of Fig. 2, a land electrode, which is an electrode of a solderless land structure, may be formed on the interposer substrate 532, and a micro bump may be formed only on the semiconductor element such as the logic semiconductor element 611, in order to connect the interposer substrate 532 and the semiconductor element. In this case, when the semiconductor element is mounted (connected) on the interposer substrate 532, a bump is unnecessary to be formed at the interposer substrate 532 side, and therefore dusts are prevented from adhering to the sensor semiconductor element 531 in order to improve the yield of the solid-state image capturing device.

### <Exemplary Variant 1 of Second Embodiment. Not covered by the scope of the claims>

### <Description of Manufacturing Process>

Also, in the above, an example has been described in which a semiconductor element such as a logic semiconductor element is mounted on a single wafer obtained by stacking and joining a sensor wafer and an interposer wafer together and is diced into each semiconductor element. However, it may be such that a single wafer obtained by stacking and joining a sensor wafer and an interposer wafer is diced into semiconductor elements, and thereafter a semiconductor element such as a logic semiconductor element is mounted on each semiconductor element.

In that case, the manufacturing device manufactures a solid-state image capturing device by performing the following process.

In the following, with reference to the flowchart of Fig. 30 and Figs. 31 to 33, a manufacturing process by a manufacturing device will be described. Note that the corresponding parts in Figs. 31 to 33 are denoted with the same reference signs, and their description will be omitted as appropriate. Also, in Figs. 31 to 33, the corresponding parts in one of Figs. 27 to 29 are denoted with the same reference signs, and their description will be omitted as appropriate.

In step S161 to step S166, the same processes as step S131 to step S136 of Fig. 26 are performed.

That is, as indicated by the arrow B91 of Fig. 31, a part of the sensor wafer is the silicon substrate 541 part for configuring the one sensor semiconductor element 531, and the wiring layer 542 is formed on the silicon substrate 541.

Also, a part of the interposer wafer is the silicon substrate 551 part for configuring one interposer substrate 532, and a wiring layer 552 and a wiring layer 553 provided with the embedded lines by stacking are formed on both surfaces of the silicon substrate 551 part.

Thereafter, as indicated by the arrow B92, those sensor wafer and interposer wafer are stacked and joined together, and the silicon substrate 541 part of the sensor semiconductor element 531 is thinned (reduced in thickness).

Further, a groove is formed by etching, and a plating process is performed with Cu on the groove part in order to form the penetration via 572 and the penetration via 573.

Also, as indicated by the arrow B93 of Fig. 32, the on-chip color filter 581, the on-chip lens 582, and the opening 583 are formed at the light receiving surface side of the silicon substrate 541.

Thereafter, as indicated by the arrow B94, a micro bump is formed by a solder, such as SnAg, on the connection electrode exposed by the opening part in the interposer substrate 532. For example, a micro bump 601 is formed on the electrode 559 provided in the wiring layer 553.

In step S167, the manufacturing device dices a single wafer obtained by stacking and joining the sensor wafer and the interposer wafer together, in order to obtain a semiconductor element including a sensor semiconductor element and an interposer substrate.

In step S168, the manufacturing device stacks and mounts, in a CoC structure, the semiconductor element such as the logic semiconductor element on the semiconductor element obtained in the process of step S167, and then installs the semiconductor element in the housing in order to form a solid-state image capturing device, and the manufacturing process ends.

For example, in step S167 and step S168, as indicated by the arrow B95 of Fig. 33, the wafer 652 including a plurality of semiconductor elements formed therein, such as the semiconductor element 651 including the sensor semiconductor element 531 and the interposer substrate 532, are diced into a plurality of semiconductor elements.

Then, as indicated by the arrow B96, the logic semiconductor element 611 is mounted in a flip chip structure on the interposer substrate 532 of the semiconductor element 651, in order to form a semiconductor element including the sensor semiconductor element 531, the interposer substrate 532, and the logic semiconductor element 611. Thereafter, this semiconductor element is installed in the housing, in order to form a solid-state image capturing device.

As described above, the manufacturing device stacks and joins the sensor semiconductor element and the interposer substrate together by wafer to wafer stacking, and dices them, and mounts a semiconductor element such as a logic semiconductor element on the interposer substrate. In this case as well, a semiconductor element, such as a logic semiconductor element, of any size is mounted on the interposer substrate.

### <Exemplary Variant 2 of Second Embodiment. Not covered by the scope of the claims.>

### <Exemplary Configuration of Solid-State Image Capturing Device>

Also, in the above, an example has been described in which the electrical connection between the sensor semiconductor element 402 and the interposer substrate 403 is achieved by a twin contact structure using paired two penetration vias such as the penetration via 446 and the penetration via 447, as illustrated in Fig. 25 for example.

However, the electrical connection between the sensor semiconductor element and the interposer substrate is not limited to the connection by the twin contact structure, but may be achieved by what is called Cu-Cu connection in which Cu electrodes are joined (connected) with each other, as illustrated in Fig. 34 for example.

In Fig. 34, the solid-state image capturing device 691 includes a sensor semiconductor element 701, an interposer substrate 702, a logic semiconductor element 703, and a logic semiconductor element 704.

In this example, the sensor semiconductor element 701 and the interposer substrate 702 correspond to the sensor semiconductor element 402 and the interposer substrate 403 illustrated in Fig. 24, and the logic semiconductor element 703 and the logic semiconductor element 704 correspond to the semiconductor element 404 illustrated in Fig. 24.

Also, the sensor semiconductor element 701 includes a silicon substrate 711 provided with a photoelectric conversion element, and the surface of the upper side in the drawing of the silicon substrate 711 is a light receiving surface, and an on-chip color filter and an on-chip lens are formed on the light receiving surface. Further, a wiring layer 712 is provided on the surface of the lower side in the drawing of the silicon substrate 711.

The interposer substrate 702 includes a silicon substrate 713 including a plurality of penetration vias corresponding to the penetration via 455 illustrated in Fig. 25, and a wiring layer 714 and a wiring layer 715 formed on both surfaces of the silicon substrate 713. The wiring layer 714 and the wiring layer 715 each include one or a plurality of layers (wiring layers).

A plurality of connection electrodes made of Cu, such as an electrode 716, are formed on the most front layer, which is the surface closest to the interposer substrate 702, of the wiring layer 712 at the interposer substrate 702 side in the sensor semiconductor element 701. A part or all of a plurality of connection electrodes, such as the electrode 716, are connected to another line in the wiring layer 712.

In the same way, a plurality of connection electrodes made of Cu, such as an electrode 717, are formed on the most front layer, which is the surface closest to the sensor semiconductor element 701, of the wiring layer 714 provided at the sensor semiconductor element 701 side in the interposer substrate 702. A part or all of a plurality of connection electrodes, such as the electrode 717, are connected to another line in the wiring layer 714. In this example, the electrode 717 is connected to a Cu line 718 in the wiring layer 714.

Also, the connection electrode provided in the interposer substrate 702 and the connection electrode provided in the sensor semiconductor element 701 are located to face each other with their joining surfaces of the same shape and the same area, and those electrodes are stacked and joined with each other, so that the sensor semiconductor element 701 and the interposer substrate 702 are connected (joined) electrically and physically with each other.

For example, the electrode 716 of the sensor semiconductor element 701 and the electrode 717 of the interposer substrate 702 are provided to face each other, and the connection parts between those electrode 716 and electrode 717 have the same shape and the same area as each other.

As described above, when the sensor wafer and the interposer wafer are joined together, the sensor semiconductor element 701 and the interposer substrate 702 are connected by Cu-Cu connection that joins Cu electrodes with each other, so that the sensor semiconductor element 701 and the interposer substrate 702 are connected electrically without providing a penetration via for twin contact in the sensor semiconductor element 701. Also, when the sensor semiconductor element 701 and the interposer substrate 702 are connected by Cu-Cu connection, the pitch (width) of the connection electrode is made smaller than the twin contact structure. Thereby, the area efficiency of the sensor semiconductor element 701 is further improved, and the size of the solid-state image capturing device 691 is reduced.

Also, in this example as well, in the same way as the example illustrated in Fig. 24, the logic semiconductor element 703 and the logic semiconductor element 704 are stacked in a CoC structure, in other words is mounted in a flip chip structure, by the micro bump in the interposer substrate 702. Note that, instead of stacking in a CoC structure the logic semiconductor element 703 and the logic semiconductor element 704 on the interposer substrate 702 after dicing the wafer, the logic semiconductor element 703 and the logic semiconductor element 704 may be stacked in a Wafer on Chip structure before dicing the wafer.

### <Exemplary Variant 3 of Second Embodiment. Not covered by the scope of the claims.>

### <Exemplary Configuration of Solid-State Image Capturing Device>

Further, as illustrated in Fig. 35 for example, the installed part of the semiconductor element may be planarized by a resin or the like in order to fix the sensor semiconductor element, the interposer substrate, the semiconductor element such as the logic semiconductor element to the housing of the solid-state image capturing device. Note that, in Fig. 35, the corresponding parts in Fig. 24 are denoted with the same reference signs, and their description will be omitted as appropriate.

In this example, a resin 741 is applied to the surface of the semiconductor element 404 side of the interposer substrate 403, and the semiconductor element 404 is covered by the resin 741 to planarize the surface of the lower side in the drawing of the resin 741. In other words, the resin 741 is filled in the space between the interposer substrate 403 and the housing 401.

As described above, the planarization by the resin 741 is performed, so that a large load is less likely to be exerted locally on the sensor semiconductor element 402 and the interposer substrate 403, when connecting the pad electrode 411 and the pad electrode 413 by wire bonding after fixing the sensor semiconductor element 402, the interposer substrate 403, and the semiconductor element 404 to the housing 401. Thereby, a crack or the like is prevented from generating in the sensor semiconductor element 402 and the interposer substrate 403, in order to improve the yield of the solid-state image capturing device 391.

### <Exemplary Configuration of Sensor Semiconductor Element and Interposer Substrate>

Also, in more detail, the configuration of the part of the sensor semiconductor element 402, the interposer substrate 403, and the semiconductor element 404 illustrated in Fig. 35 is configured as illustrated in Fig. 36 for example. Note that, in Fig. 36, the corresponding parts in Fig. 25 or Fig. 35 are denoted with the same reference signs, and their description will be omitted as appropriate.

In the example illustrated in Fig. 36, the logic semiconductor element 471 and the DRAM semiconductor element 472 corresponding to the semiconductor element 404 of Fig. 35 are mounted in a flip chip structure on the interposer substrate 403. Then, these logic semiconductor element 471 and the DRAM semiconductor element 472 are covered by the resin 741 for planarization, in order to planarize the part on which the semiconductor element of the interposer substrate 403 is mounted.

### <Description of Manufacturing Process>

Next, the manufacturing process performed by the manufacturing device when the mounting part of the semiconductor element is planarized by the resin will be described.

In the following, with reference to the flowchart of Fig. 37 and Figs. 38 to 40, a manufacturing process by a manufacturing device will be described. Note that the corresponding parts in Figs. 38 to 40 are denoted with the same reference signs, and their description will be omitted as appropriate. Also, in Figs. 38 to 40, the corresponding parts in one of Figs. 27 to 29 are denoted with the same reference signs, and their description will be omitted as appropriate.

In step S191 to step S194, the same processes as step S131 to step S134 of Fig. 26 are performed.

That is, as indicated by the arrow B101 of Fig. 38, a part of the sensor wafer is the silicon substrate 541 part for configuring the one sensor semiconductor element 531, and the wiring layer 542 is formed on the silicon substrate 541.

Also, a part of the interposer wafer is the silicon substrate 551 part for configuring one interposer substrate 532, and a wiring layer 552 and a wiring layer 553 provided with the embedded lines by stacking are formed on both surfaces of the silicon substrate 551 part.

Thereafter, as indicated by the arrow B102, those sensor wafer and interposer wafer are stacked and joined together, and the silicon substrate 541 part of the sensor semiconductor element 531 is thinned (reduced in thickness).

Further, a groove is formed by etching, and a plating process is performed with Cu on the groove part in order to form the penetration via 572 and the penetration via 573.

In step S195, the manufacturing device forms a micro bump on the connection electrode of the interposer substrate. Also, in step S196, the manufacturing device mounts the logic semiconductor element on the interposer substrate.

For example, as indicated by the arrow B 103 of Fig. 39, a micro bump is formed by a solder, such as SnAg, on the connection electrode exposed by the opening part in the interposer substrate 532. For example, a micro bump 601 is formed on the electrode 559 provided in the wiring layer 553.

Further, as indicated by the arrow B104, a logic semiconductor element 611 is mounted in a flip chip structure on the interposer substrate 532 in order to form a single semiconductor element including the sensor semiconductor element 531, the interposer substrate 532, and the logic semiconductor element 611. That is, the logic semiconductor element 611 diced in advance is connected in a CoW structure, to the part of the interposer substrate 532 of a single wafer formed by stacking and joining the interposer wafer including the interposer substrate 532 formed therein and the sensor wafer including the sensor semiconductor element 531 formed therein.

In this example, the micro bump 601 formed in the electrode 559 of the interposer substrate 532 and the micro bump 617 formed in the electrode 616 of the logic semiconductor element 611 are connected with each other, so that the logic semiconductor element 611 is mounted in a flip chip structure (connected in a flip chip structure) on the interposer substrate 532.

In step S197, the manufacturing device planarizes the logic semiconductor element part of the interposer substrate with the resin, and in step S198 the manufacturing device forms an on-chip color filter and an on-chip lens.

Further, in step S199, the manufacturing device dices the wafer obtained in the process of step S198, and the manufacturing process ends.

For example, as indicated by the arrow B105 of Fig. 40, a resin 771 is applied to the logic semiconductor element 611 side of the interposer substrate 532, which is the mounting part of the logic semiconductor element 611, for the purpose of planarization.

Then, as indicated by the arrow B106, the on-chip color filter 581, the on-chip lens 582, and the opening 583 are formed at the light receiving surface side of the silicon substrate 541. Then, a single semiconductor element including the sensor semiconductor element 531, the interposer substrate 532, and the logic semiconductor element 611, which is obtained in this way, is a semiconductor element 772.

Further, as indicated by the arrow B107, a single wafer 773 on which a plurality of semiconductor elements, such as the semiconductor element 772, are formed is diced into a plurality of semiconductor elements. Thereafter, each semiconductor element such as the semiconductor element 772 is connected to the housing 401 illustrated in Fig. 35, in order to form a solid-state image capturing device.

In this way, the wafer is diced into semiconductor elements, which are each installed in the housing, in order to form a solid-state image capturing device, and then the manufacturing process ends.

As described above, the manufacturing device stacks and joins the sensor semiconductor element and the interposer substrate together by wafer to wafer stacking, and mounts in a flip chip structure, the semiconductor element such as the logic semiconductor element, on the surface of the opposite side to the sensor semiconductor element in the interposer substrate. In this case, manufacturing device planarizes the mounting part of the semiconductor element with the resin.

In this way, a crack or the like is prevented from generating in the sensor semiconductor element and the interposer substrate, in order to improve the yield of the solid-state image capturing device.

### <Exemplary Variant 4 of Second Embodiment. Not covered by the scope of the claims.>

### <Exemplary Configuration of Solid-State Image Capturing Device>

Also, in the example illustrated in Fig. 24, an example has been described in which the pad electrode 411 is provided at the sensor semiconductor element 402 side of the interposer substrate 403 in order to form an electrical connection by wire bonding, but the pad electrode may be provided at the semiconductor element 404 side.

In that case, the solid-state image capturing device 391 is configured as illustrated in Fig. 41, for example. Note that, in Fig. 41, the corresponding parts in Fig. 24 are denoted with the same reference signs, and their description will be omitted as appropriate.

In the example illustrated in Fig. 41, the solid-state image capturing device 391 includes a housing 801, a sensor semiconductor element 402, an interposer substrate 403, a semiconductor element 404, and a cover glass 405.

In this example, the sensor semiconductor element 402 is fixed to the housing 801, so that the sensor semiconductor element 402, the interposer substrate 403, and the semiconductor element 404 are mounted on the housing 801. Also, undepicted pad electrodes are provided at the semiconductor element 404 side of the interposer substrate 403, so that those pad electrodes and the pad electrodes provided in the housing 801 are connected electrically by a wire 802-1 and a wire 802-2.

Note that, in the following, when it is unnecessary to distinguish the wire 802-1 from the wire 802-2 particularly, they are also referred to as the wire 802 simply.

In the solid-state image capturing device 391, the power is supplied from the housing 801 to the interposer substrate 403 via these wires 802, and a signal is output from the interposer substrate 403 to the housing 801.

When the solid-state image capturing device 391 is configured as above, the interposer substrate 403 is configured as illustrated in Fig. 42 for example, in more detail. Note that, in Fig. 42, the corresponding parts to Fig. 25 are denoted with the same reference signs, and their description will be omitted as appropriate.

In the example illustrated in Fig. 42, a pad electrode 831 made of Al or the like is provided in the layer closest to the logic semiconductor element 471 in the wiring layer 453 of the interposer substrate 403, and the pad electrode 831 is exposed by the opening 832 provided in the wiring layer 453. In the solid-state image capturing device 391, the wire 802 described above is connected to the pad electrode 831 by wire bonding, and thereby the interposer substrate 403 and the housing 801 are electrically connected to each other.

### <Third Embodiment. Not covered by the scope of the claims.>

### <Exemplary Configuration of Solid-State Image Capturing Device>

In the meantime, in the back-side illuminated solid-state image capturing device, a light receiving section including pixels that receive a light that enters from the outside is provided on the surface of the opposite side to the wiring layer surface, the sensor semiconductor element is to be thinned, and the thinning necessitates a support substrate for securing strength.

Thus, there is proposed a back-side illuminated solid-state image capturing device of a stacked type in which the support substrate is replaced by the logic semiconductor element, and the sensor semiconductor element and the logic semiconductor element are stacked and joined together, and the sensor semiconductor element is electrically connected to the logic semiconductor element, in order to reduce the size (for example, refer to JP 2014-220370 A). In this back-side illuminated solid-state image capturing device, a sensor semiconductor element surface provided with a light receiving section having a pixel circuit is electrically connected to a diced logic semiconductor element surface having a logic circuit.

Also, there is proposed a back-side illuminated solid-state image capturing device in which a groove is formed at a part of the joining surface side with the sensor semiconductor element in the support substrate stacked and joined on the sensor semiconductor element, and a built-in chip is stacked at the part in the groove, in order to reduce the module size (for example JP 2012-204403 A the reference).

However, in an embodiment of the technology described above, it is difficult to secure a sufficient strength.

For example, in the back-side illuminated solid-state image capturing device of a stacked type, each of the sensor semiconductor element and the logic semiconductor element stacked at the back surface side thereof has a thin thickness of 1 µm or less, and has a low strength without a support substrate, and therefore it is highly possible that stress concentration occurs. As a result, it is concerned that white spots and dark current increase in the back-side illuminated solid-state image capturing device. Also, the back-side illuminated solid-state image capturing device has an insufficient strength, and therefore, if a plurality of semiconductor elements are stacked, the warpage amount of the back-side illuminated solid-state image capturing device itself increases, and the image capturing characteristics decrease.

Further, in the back-side illuminated solid-state image capturing device in which a groove is provided at a part of the support substrate, the sensor semiconductor element has a thin thickness of several µm, and therefore there is no support substrate practically in the groove part where a built-in chip is embedded. Thus, the sufficient strength is unable to be secured in the groove part, and therefore it is highly possible that stress is concentrated at the groove part, and as a result, it is concerned that white spots and dark current increase in the back-side illuminated solid-state image capturing device.

Also, when a plurality of semiconductor elements are stacked, many grooves for embedding a built-in chip is to be created at the support substrate side. This narrows the area of the part that practically functions as the support substrate in the support substrate, and therefore it is concerned that the warpage amount of the back-side illuminated solid-state image capturing device itself increases, and the image capturing characteristics decreases.

An embodiment of the present technology is made in view of the above situation, and secures the sufficient strength.

Specifically, in an embodiment of the present technology, in the back-side illuminated solid-state image capturing device, the glass member formed mainly by a glass and the sensor semiconductor element are closely attached to each other with a high heat resistance transparent resin, to cause the glass member to function as the support substrate in order to secure the sufficient strength.

In the following, a specific embodiment to which the present technology is applied will be described.

Fig. 43 is a diagram illustrating an exemplary configuration of one embodiment of the back-side illuminated solid-state image capturing device to which the present technology is applied.

The solid-state image capturing device 871 illustrated in Fig. 43 includes a sensor semiconductor element 881 that provides an image capturing function, a semiconductor element 882 which is a support material that enables an electrical connection, and a plate-like cover glass 883 which is a glass member and functions as a support substrate.

Also, the sensor semiconductor element 881 and the cover glass 883 are bonded (joined) by a high heat resistance transparent resin 884 of a transparent adhesive agent. Further, in the semiconductor element 882, a semiconductor element 885-1 and a semiconductor element 885-2, which are smaller than the sensor semiconductor element 881, are mounted in a diced state. Note that, in the following, when the semiconductor element 885-1 and the semiconductor element 885-2 are unnecessary to be distinguished from each other particularly, they are also referred to as a semiconductor element 885 simply.

The sensor semiconductor element 881 includes a silicon substrate 891 made of silicon and a wiring layer 892 stacked on the silicon substrate 891.

In the silicon substrate 891, an undepicted photoelectric conversion element that photoelectrically converts a light that enters from the outside and the field-effect transistor are provided, and the on-chip color filter and the on-chip lens are formed on the surface of the cover glass 883 side in the silicon substrate 891. Then, for example, these photoelectric conversion element, field-effect transistor, on-chip color filter, and on-chip lens form one pixel, and a plurality of pixels form a pixel section 893 which is a light receiving section.

In the sensor semiconductor element 881, the light receiving surface is the surface of the side provided with the pixel section 893, which is the surface of the cover glass 883 side.

Also, the wiring layer 892 is provided on the surface of the opposite side to the cover glass 883 in the silicon substrate 891, which is the surface of the semiconductor element 882 side, and a line made of Cu (copper), Al (aluminium), or the like is formed in the wiring layer 892, for example. For example, in this example, a line 894-1 and a line 894-2 are provided in the wiring layer 892. Note that, in the following, when the line 894-1 and the line 894-2 are unnecessary to be distinguished from each other particularly, they are also referred to as a line 894 simply.

The cover glass 883 bonded at the light receiving surface side of the sensor semiconductor element 881 functions as a cover glass for protecting the pixel section 893, and functions as a support substrate for strength reinforcement of the solid-state image capturing device 871.

For example, the cover glass 883 includes a transparent glass member that transmits a light that enters into the pixel section 893 from the outside. The cover glass 883 is stacked and joined on the sensor semiconductor element 881, and therefore it is desirable that the glass member for making the cover glass 883 exhibits the same linear expansion behavior, relative to temperature, as the behavior of silicon for making the sensor semiconductor element 881 as much as possible, in order to reduce the warpage of the solid-state image capturing device 871.

Thus, for example, the cover glass 883 may be formed of quartz glass, borosilicate glass, or the like. As described above, the glass member for making the cover glass 883 exhibits linear expansion behavior that is close to silicon relative to temperature, in order to reduce the warpage amount of the solid-state image capturing device 871.

Also, the high heat resistance transparent resin 884 is a transparent adhesive agent that has a heat resistance property, a chemical resistance property, and a light resistance property sufficiently in the process and the reliability test after stacking and joining the sensor semiconductor element 881 and the cover glass 883 together for example and does not affect image capturing characteristics of the solid-state image capturing device 871. For example, the high heat resistance transparent resin 884 is a transparent adhesive agent having the characteristics of transmitting a light of the wavelength equal to or larger than 400nm at 99% or more.

Further, specifically, an adhesive agent material as the high heat resistance transparent resin 884 is a silicon resin, an acrylic resin, an epoxy resin, a dendrimer, or a copolymer thereof, for example.

Also, it is desirable that the high heat resistance transparent resin 884 is a transparent resin that is applied or laminated on the cover glass 883 side to form a resin film, in order to bond the cover glass 883 on the pixel section 893 of the sensor semiconductor element 881 in a partially cured state. Further, it is desirable that the high heat resistance transparent resin 884 is curable by heat or ultraviolet (UV) radiation after stacking and joining the cover glass 883 and the sensor semiconductor element 881 together.

The semiconductor element 882 includes a silicon substrate 901 made of silicon and a wiring layer 902 including one or a plurality of layers stacked on the silicon substrate 901, and is utilized as a support material.

In the silicon substrate 901, there is formed a penetration electrode for electrically connecting the wiring layer 892 adjacent to the silicon substrate 901 and the wiring layer 902 provided on the surface of the opposite side to the wiring layer 892 in the silicon substrate 901. The penetration electrode is an electrode penetrating at least a part of layers of the semiconductor element 882, which is the silicon substrate 901 in this example.

For example, a penetration electrode 903-1 and a penetration electrode 903-2 are formed in the silicon substrate 901 in this example. In the following, when the penetration electrode 903-1 and the penetration electrode 903-2 are unnecessary to be distinguished from each other particularly, they are also referred to as a penetration electrode 903 simply.

These penetration electrodes 903 are electrical connection sections of a high-aspect ratio, which is made of Cu or the like for example and penetrates the silicon substrate 901, and a plurality of penetration electrodes 903 are formed at a tight pitch in the silicon substrate 901. That is, the penetration electrode 903 is a fine electrical connection section, of which the length in the normal direction of the silicon substrate 901 is much longer than the length in the perpendicular direction to the normal direction, which is the diameter of the penetration electrode 903. Also, in a predetermined region of the silicon substrate 901, the number of the penetration electrodes 903 formed per unit area is more than other regions.

In the wiring layer 902, a line made of Cu, Al, or the like is provided. For example, in the wiring layer 902, lines 904-1 to 904-4 are provided. In the following, when the lines 904-1 to 904-4 are unnecessary to be distinguished from each other particularly, they are also referred to as a line 904 simply.

Further, on a part of lines 904 among these lines 904, there is formed an electrode for electrically connecting to the semiconductor element 885, an external element, or the like.

For example, two electrodes 905-1 and 905-2 are formed on the line 904-2. The semiconductor element 885-1 mounted at the opposite side to the sensor semiconductor element 881 side of the semiconductor element 882 is connected electrically to the sensor semiconductor element 881, by these electrodes 905-1 and 905-2.

That is, two electrodes 906-1 and 906-2 are provided in the semiconductor element 885-1, and an electrode 905-1 and an electrode 905-2 are connected to the electrode 906-1 and the electrode 906-2 by a micro bump 907-1 and a micro bump 907-2 which are made of a solder, respectively.

In the following, when the electrode 905-1 and the electrode 905-2 are unnecessary to be distinguished from each other particularly, they are also referred to as an electrode 905 simply. When the electrode 906-1 and the electrode 906-2 are unnecessary to be distinguished from each other particularly, they are also referred to as an electrode 906 simply. Also, in the following, when the micro bump 907-1 and the micro bump 907-2 are unnecessary to be distinguished from each other particularly, they are referred to as a micro bump 907 simply.

In the example illustrated in Fig. 43, the sensor semiconductor element 881 and the semiconductor element 885-1 are connected electrically to each other via the electrode 905, the line 904, and the penetration electrode 903.

In the solid-state image capturing device 871, the semiconductor element 885 mounted on the semiconductor element 882 is a logic semiconductor element including a logic circuit that performs signal processing, or a memory semiconductor element that includes a memory circuit to function as a memory.

In this example, the sensor semiconductor element 881 and the semiconductor element 882 have joining surfaces of the same shape and the same area, whereas the area of the joint part between each semiconductor element 885 and the semiconductor element 882 is smaller than the area of the entire surface of the side where the semiconductor element 885 is located in the semiconductor element 882.

Also, an electrode 908 is formed on the line 904-4 provided in the wiring layer 902, and further a solder ball 909 made of a solder is formed on the electrode 908. An undepicted external element is connected to the solder ball 909, and for example the electrode 908 is utilized as a terminal for supplying electric power or a terminal for outputting data to the outside. In this case, the external element is connected electrically to the sensor semiconductor element 881 via the electrode 908, the line 904, and the penetration electrode 903.

For example, considering the solid-state image capturing device 871 mounted on the external element by the solder ball 909, the semiconductor element 885 is to be thinned to prevent the interference with the height of the solder ball 909.

That is, it is desirable that the height from the surface of the lower side in the drawing of the semiconductor element 882 to the surface of the lower side in the drawing of the semiconductor element 885 is lower than the height from the surface of the lower side in the drawing of the semiconductor element 882 to the end of the lower side in the drawing of the solder ball 909. Thus, for example it is desirable that the thickness of the semiconductor element 885 is equal to or smaller than 100 µm.

In the solid-state image capturing device 871, the semiconductor element 882 utilized as the support material and the sensor semiconductor element 881 are stacked and joined together in the form of wafers. Also, the cover glass 883, which functions as the support substrate for reinforcing the strength, is bonded with the sensor semiconductor element 881. Hence, in the solid-state image capturing device 871, the cover glass 883 provides sufficient strength, and the sensor semiconductor element 881 and the semiconductor element 882 are thinned sufficiently in a simple manner.

If the semiconductor element 882 is thinned sufficiently as described above, the process for forming the penetration electrode 903 of a high-aspect ratio in the semiconductor element 882, which is to be done in order to mount (join) the diced semiconductor element 885 on the semiconductor element 882, is simplified more. In other words, the line of the wiring layer 892 is easily drawn to the side where the semiconductor element 885 is located in the solid-state image capturing device 871.

For example, it is desirable that the thickness of the semiconductor element 882 is 100 µm or less, in order to facilitate the process for forming the penetration electrode 903 sufficiently. As described above, according to an embodiment of the present technology, a plurality of penetration electrodes 903 are formed highly densely, and thereby the size of the solid-state image capturing device 871 is reduced.

Also, in the solid-state image capturing device 871, the cover glass 883 made of glass material having the same linear expansion behavior, relative to temperature, as silicon is bonded with the sensor semiconductor element 881 and function as the support substrate, in order to secure the sufficient strength and prevent the generation of warpage. Thereby, the image capturing characteristics of the solid-state image capturing device 871 is improved.

Further, in the solid-state image capturing device 871, the diced semiconductor element 885 is connected (joined) with the semiconductor element 882 easily. That is, the semiconductor element 885 and the semiconductor element 882 are needless to be stacked and joined together in the form of wafer.

Thus, the semiconductor element 885 of any size can be mounted (installed) on the solid-state image capturing device 871, regardless of the size of the sensor semiconductor element 881, so that the size of the solid-state image capturing device 871 is reduced. In addition, when mounting the semiconductor element 885, only non-defective products, which are determined in a preliminary test, are selected and mounted on the solid-state image capturing device 871, and therefore the yield in manufacturing the solid-state image capturing device 871 is improved.

### <Description of Manufacturing Process. Not covered by the scope of the claims.>

Thereafter, with reference to the flowchart of Fig. 44 and Figs. 45 to 49, the manufacturing process performed by the manufacturing device for manufacturing the solid-state image capturing device 871 illustrated in Fig. 43 will be described. Note that, in Figs. 45 to 49, the corresponding parts in Fig. 43 are denoted with the same reference signs, and their description will be omitted as appropriate.

In step S221, the manufacturing device stacks and joins together the sensor semiconductor element 881 and the semiconductor element 882, which is in more detail the silicon substrate 901 for configuring the semiconductor element 882.

For example, as indicated by the arrow B121 of Fig. 45, the silicon substrate 901 and the surface of the wiring layer 892 side of the sensor semiconductor element 881 are stacked and joined together in the form of wafers.

In step S222, the manufacturing device thins the sensor semiconductor element 881. That is, as indicated by the arrow B122 of Fig. 45 for example, the silicon substrate 891 of the sensor semiconductor element 881 is thinned by polishing.

Then, in step S223, the manufacturing device forms the on-chip color filter and the on-chip lens at the part of the silicon substrate 891 of the sensor semiconductor element 881, in order to form the pixel section 893. For example, as indicated by the arrow B123 of Fig. 46, the on-chip color filter and the on-chip lens are formed for each pixel to form the pixel section 893.

In step S224, the manufacturing device stacks and joins the sensor semiconductor element 881 and the cover glass 883 together. For example, as indicated by the arrow B124 of Fig. 46, the sensor semiconductor element 881 and the cover glass 883 are stacked and joined together by the high heat resistance transparent resin 884.

In step S225, the manufacturing device thins the semiconductor element 882, and forms the penetration electrode. Further, in step S226, the manufacturing device rewires by forming lines in the semiconductor element 882, and forms electrodes for connection to the semiconductor element 885 and connection to the outside.

For example, as illustrated in Fig. 47, after the silicon substrate 901 for configuring the semiconductor element 882 is thinned, a plurality of penetration electrodes, such as the penetration electrode 903, are formed in the silicon substrate 901. Then, the wiring layer 902 including the organic or inorganic oxide film is formed on the silicon substrate 901, and the line such as the line 904 is formed in the wiring layer 902, and further the electrodes such as the electrode 905 and the electrode 908 are formed on the surface of the opposite side to the pixel section 893 of the wiring layer 902.

In step S227, the manufacturing device mounts the semiconductor element 885, which is diced in advance, on the semiconductor element 882.

For example, as illustrated in Fig. 48, the electrode 905 and the electrode 906 of the semiconductor element 885 are connected (joined together) by a solder by the micro bump 907, in order to mount the semiconductor element 885 on the semiconductor element 882. Thereby, the sensor semiconductor element 881 and the semiconductor element 885 are connected electrically to each other.

In step S228, the manufacturing device forms solder balls for connecting to the external element, on the electrode formed in the semiconductor element 882. For example, as illustrated in Fig. 49, the solder ball 909 is formed on the electrode 908. Thereby, a plurality of solid-state image capturing devices 871 are formed on the wafer.

In this example, the connection of the semiconductor element 885 and the formation of the solder ball 909 are performed on a wafer, and therefore the solid-state image capturing device 871 is manufactured more promptly than when the connection of the semiconductor element 885 and the formation of the solder ball 909 are performed after dicing the wafer. That is, the speed of the manufacturing process of the solid-state image capturing device 871 is improved.

In step S229, the manufacturing device dices the wafer into a plurality of solid-state image capturing devices 871, and the manufacturing process ends.

As described above, the manufacturing device stacks and joins the sensor semiconductor element 881 and the semiconductor element 882 together in the form of wafers, and stacks and joins the cover glass 883, which functions as the support substrate, on the sensor semiconductor element 881, and thereafter performs the penetration electrode formation and the rewiring in order to mount the semiconductor element 885 which is diced in advance. Thereby, the sufficient strength is secured and the generation of the warpage is prevented, in order to improve the image capturing characteristics of the solid-state image capturing device 871.

### <Exemplary Variant 1 of Third Embodiment. Not covered by the scope of the claims.>

### <Exemplary Configuration of Solid-State Image Capturing Device>

Note that, in the solid-state image capturing device 871 illustrated in Fig. 43, an example has been described in which the semiconductor element 882 and the semiconductor element 885 are connected by a solder by the micro bump 907, but the semiconductor element 882 and the semiconductor element 885 may be Cu-Cu connected by utilizing a Cu electrode.

In that case, the solid-state image capturing device 871 is configured as illustrated in Fig. 50, for example. Note that, in Fig. 50, the corresponding parts in Fig. 43 are denoted with the same reference signs, and their description will be omitted as appropriate.

In the solid-state image capturing device 871 illustrated in Fig. 50, the Cu electrode 931-1 and the Cu electrode 931-2 made of Cu are formed on the line 904-2 in the wiring layer 902 of the semiconductor element 882. Note that, in the following, when the Cu electrode 931-1 and the Cu electrode 931-2 are unnecessary to be distinguished from each other particularly, they are also referred to as a Cu electrode 931 simply.

Also, the Cu electrode 932-1 and the Cu electrode 932-2 made of Cu are formed in the semiconductor element 885-1. Note that, in the following, when the Cu electrode 932-1 and the Cu electrode 932-2 are unnecessary to be distinguished from each other particularly, they are also referred to as a Cu electrode 932 simply.

In the solid-state image capturing device 871, the semiconductor element 882 and the semiconductor element 885-1 are connected electrically, by connecting the Cu electrode 931 formed in the wiring layer 902 and the Cu electrode 932 formed in the semiconductor element 885-1 to each other, in other words, by stacking and joining the Cu electrodes together. That is, the semiconductor element 885-1 is mounted on the semiconductor element 882.

Here, as a method for connecting (joining) Cu electrodes, i.e., the Cu electrode 931 and the Cu electrode 932, thermocompression bonding, ultrasonic wave connection, formic acid reduction connection, or the like may be utilized. Also, the on-chip color filter and the on-chip lens for configuring the pixel section 893 have a poor heat resistance property, and therefore it is desirable that the connection temperature of the Cu electrode is equal to or smaller than 260 °C.

As described above, when connecting the semiconductor element 882 and the semiconductor element 885 by utilizing the Cu electrode, the miniaturization of the Cu electrode 931 and the Cu electrode 932 is easier than the miniaturization of the micro bump 907, and therefore the size of the semiconductor element 885 can be reduced. In addition, as the Cu electrode 931 and the Cu electrode 932 become small, the capacities of those Cu electrodes become small, and therefore the transmission loss in the data exchange is reduced, and the high-speed transmission of the data is easily achieved.

### <Fourth Embodiment. Not covered by the scope of the claims.>

### <Exemplary Configuration of Solid-State Image Capturing Device>

Also, in the solid-state image capturing device 871 illustrated in Fig. 43, an example has been described in which the semiconductor element 882 of the support material is connected (joined) on the sensor semiconductor element 881, but the semiconductor element including the logic circuit and the memory circuit formed therein may be connected on the sensor semiconductor element 881.

In that case, the solid-state image capturing device 391 is configured as illustrated in Fig. 51, for example. Note that, in Fig. 51, the corresponding parts in Fig. 43 are denoted with the same reference signs, and their description will be omitted as appropriate.

The back-side illuminated solid-state image capturing device 961 illustrated in Fig. 51 includes a sensor semiconductor element 881, a semiconductor element 971 including a logic circuit or a memory circuit made of embedded lines, and a cover glass 883.

In the same way as the solid-state image capturing device 871 in the solid-state image capturing device 961, the sensor semiconductor element 881 and the cover glass 883 are bonded by the high heat resistance transparent resin 884, and the cover glass 883 functions as a support substrate.

Also, the semiconductor element 971 includes a silicon substrate 981 made of silicon, a wiring layer 982 stacked on the sensor semiconductor element 881 side of the silicon substrate 981, and a wiring layer 983 including one or a plurality of layers stacked on the opposite side to the sensor semiconductor element 881 side of the silicon substrate 981. Further, on the semiconductor element 971, the semiconductor element 885-1 and the semiconductor element 885-2, which are smaller than the sensor semiconductor element 881, are mounted in a diced state.

The line made of Cu, Al, or the like is formed in the wiring layer 892 of the sensor semiconductor element 881. For example, a line 991 is provided in the wiring layer 892 in this example.

Also, a plurality of penetration electrodes penetrating the silicon substrate 891 and the wiring layer 892 are provided in the sensor semiconductor element 881. For example, in this example, a penetration electrode 992 for electrically connecting the line 991 in the wiring layer 892 and the wiring layer 982 for configuring the semiconductor element 971 is provided. This penetration electrode 992 is an electrode that transiently rises up to the inside of the silicon substrate 891 from the line 991 in the wiring layer 892 and thereafter penetrates the silicon substrate 891 and the wiring layer 892 to connect with the wiring layer 982.

A plurality of embedded lines made of Cu, Al, or the like are formed in the wiring layer 982 for configuring the semiconductor element 971. For example, in this example, the lines 993-1 to 993-3 are formed in the wiring layer 982. Here, the line 993-1 is connected to the line 991 via the penetration electrode 992.

In the silicon substrate 981, there is formed a penetration electrode for electrically connecting the wiring layer 982 adjacent to the silicon substrate 981 and the wiring layer 982 provided on the surface of the opposite side to the wiring layer 982 in the silicon substrate 981. The penetration electrode is an electrode penetrating at least a part of layers of the semiconductor element 971, which is the silicon substrate 981 in this example.

For example, a penetration electrode 994-1 and a penetration electrode 994-2 are formed in the silicon substrate 981 in this example. In the following, when the penetration electrode 994-1 and the penetration electrode 994-2 are unnecessary to be distinguished from each other particularly, they are also referred to as a penetration electrode 994 simply.

These penetration electrodes 994 is an electrical connection section of a high-aspect ratio which is made of Cu or the like for example and penetrates the silicon substrate 981, and a plurality of penetration electrodes 994 are formed at a tight pitch in the silicon substrate 981.

The embedded lines made of Cu, Al, or the like are provided in the wiring layer 983. For example, lines 995-1 to 995-4 are provided in the wiring layer 983. In the following, when the lines 995-1 to 995-4 are unnecessary to be distinguished from each other particularly, they are also referred to as a line 995 simply.

In this example, the line 995-1 is connected to the line 993-2 via the penetration electrode 994-1, and the line 995-3 is connected to the line 993-3 via the penetration electrode 994-2.

Further, on a part of lines 995 among these lines 995, there is formed an electrode for electrically connecting to the semiconductor element 885, an external element, or the like.

For example, two electrodes 996-1 and 996-2 are formed on the line 995-2. The semiconductor element 885-1 mounted at the opposite side to the sensor semiconductor element 881 side of the semiconductor element 971 is connected electrically to the sensor semiconductor element 881, by these electrodes 996-1 and 996-2.

That is, the electrode 906-1 and the electrode 906-2 of the semiconductor element 885-1 are connected to an electrode 996-1 and an electrode 996-2 by the micro bump 907-1 and the micro bump 907-2, respectively.

In the following, when the electrode 996-1 and the electrode 996-2 are unnecessary to be distinguished from each other particularly, they are also referred to as an electrode 996 simply.

In the example illustrated in Fig. 51, the sensor semiconductor element 881 and the semiconductor element 885-1 are connected electrically to each other via the electrode 996, the line 995, the penetration electrode 994, and the line 993. For example, the line 993 and the line in the sensor semiconductor element 881 are connected electrically to each other by the penetration electrode 992.

In this example, the sensor semiconductor element 881 and the semiconductor element 971 have joining surfaces of the same shape and the same area, whereas the area of the joint part between each semiconductor element 885 and the semiconductor element 971 is smaller than the area of the entire surface of the side where the semiconductor element 885 is located in the semiconductor element 971.

Also, an electrode 997 is formed on the line 995-4 provided in the wiring layer 983, and further a solder ball 909 is formed on the electrode 997. An undepicted external element is connected to the solder ball 909, and for example the electrode 908 is utilized as a terminal for supplying electric power or a terminal for outputting data to the outside. In this case, the external element is connected electrically to the sensor semiconductor element 881 via the electrode 997, the line 995, the penetration electrode 994, the lines 993, and the like.

For example, considering the solid-state image capturing device 961 mounted on an external element by the solder ball 909, the semiconductor element 885 is to be thinned in order to prevent the interference with the height of the solder ball 909, in the same way as the solid-state image capturing device 871. Specifically, it is desirable that the thickness of the semiconductor element 885 is equal to or smaller than 100 µm, for example.

In the solid-state image capturing device 961, the semiconductor element 971 and the sensor semiconductor element 881 are stacked and joined together in the form of wafers. Also, the cover glass 883, which functions as the support substrate for reinforcing the strength, is bonded with the sensor semiconductor element 881. Hence, in the solid-state image capturing device 961, the cover glass 883 provides sufficient strength, and the sensor semiconductor element 881 and the semiconductor element 971 are thinned sufficiently in a simple manner.

Thus, the process for forming the penetration electrode 994 of a high-aspect ratio is simplified more. Also, the penetration electrode 994 is formed highly densely, and therefore the size of the solid-state image capturing device 961 is reduced.

Further, in the solid-state image capturing device 961, the cover glass 883 made of glass material having the same linear expansion behavior, relative to temperature, as silicon is bonded with the sensor semiconductor element 881, in order to secure the sufficient strength and prevent the generation of warpage, so as to improve the image capturing characteristics.

Further, in the solid-state image capturing device 961, the semiconductor element 885 of any size can be mounted on the solid-state image capturing device 961, regardless of the size of the sensor semiconductor element 881, in the same way as the solid-state image capturing device 871, and therefore the size of the solid-state image capturing device 961 is reduced. In addition, when mounting the semiconductor element 885, only non-defective products, which are determined in a preliminary test, are selected and mounted on the solid-state image capturing device 961, and therefore the yield in manufacturing is improved.

### <Description of Manufacturing Process. Not covered by the scope of the claims.>

Thereafter, with reference to the flowchart of Fig. 52 and Figs. 53 to 57, the manufacturing process performed by the manufacturing device for manufacturing the solid-state image capturing device 961 illustrated in Fig. 51 will be described. Note that, in Figs. 53 to 57, the corresponding parts in Fig. 51 are denoted with the same reference signs, and their description will be omitted as appropriate.

In step S251, the manufacturing device stacks and joins together the sensor semiconductor element 881 and the semiconductor element 971, which is in more detail the silicon substrate 981 and the wiring layer 982 for configuring the semiconductor element 971.

For example, as indicated by the arrow B141 of Fig. 53, the surface of the wiring layer 892 side of the sensor semiconductor element 881 and the wiring layer 982 stacked on the silicon substrate 981 are stacked and joined together in the form of wafers.

In step S252, the manufacturing device thins the sensor semiconductor element 881. That is, as indicated by the arrow B142 of Fig. 53 for example, the silicon substrate 891 of the sensor semiconductor element 881 is thinned by polishing.

Then, in step S253, the manufacturing device forms a plurality of penetration electrodes, such as the penetration electrode 992, in the silicon substrate 891 of the sensor semiconductor element 881 and the part of the wiring layer 982. Also, in step S254, the manufacturing device forms the on-chip color filter and the on-chip lens on the part of the silicon substrate 891 of the sensor semiconductor element 881, in order to form the pixel section 893.

Through these process, the penetration electrode 992 for electrically connecting the sensor semiconductor element 881 and the wiring layer 982 of the semiconductor element 971 is formed, as indicated by the arrow B143 of Fig. 54 for example. Also, the on-chip color filter and the on-chip lens are formed for each pixel, in order to form the pixel section 893.

In step S255, the manufacturing device stacks and joins the sensor semiconductor element 881 and the cover glass 883 together. For example, as indicated by the arrow B144 of Fig. 54, the sensor semiconductor element 881 and the cover glass 883 are stacked and joined together by the high heat resistance transparent resin 884.

In step S256, the manufacturing device thins the silicon substrate 981 for configuring the semiconductor element 971, and forms the penetration electrode. Further, in step S257, the manufacturing device rewires by forming lines in the semiconductor element 971, and forms electrodes for connection to the semiconductor element 885 and connection to the outside.

For example, as illustrated in Fig. 55, after the silicon substrate 981 for configuring the semiconductor element 971 is thinned, a plurality of penetration electrodes, such as the penetration electrode 994, are formed in the silicon substrate 981. Then, the wiring layer 983 including the organic or inorganic oxide film is formed on the silicon substrate 981, and the line such as the line 995 is formed in the wiring layer 983, and further the electrodes such as the electrode 996 and the electrode 997 are formed on the surface of the opposite side to the pixel section 893 of the wiring layer 983.

In step S258, the manufacturing device mounts the semiconductor element 971, which is diced in advance, on the semiconductor element 882.

For example, as illustrated in Fig. 56, the electrode 996 and the electrode 906 of the semiconductor element 885 are connected by a solder by the micro bump 907, in order to mount (join together) the semiconductor element 885 on the semiconductor element 971. That is, the sensor semiconductor element 971 and the semiconductor element 885 are connected electrically to each other.

In step S259, the manufacturing device forms solder balls for connecting to the external element, on the electrode formed in the semiconductor element 971. For example, as illustrated in Fig. 57, the solder ball 909 is formed on the electrode 997. Thereby, a plurality of solid-state image capturing devices 961 are formed on the wafer.

In this example, the connection of the semiconductor element 885 and the formation of the solder ball 909 are performed on a wafer, and therefore the solid-state image capturing device 961 is manufactured more promptly than when the connection of the semiconductor element 885 and the formation of the solder ball 909 are performed after dicing the wafer. That is, the speed of the manufacturing process of the solid-state image capturing device 961 is improved.

In step S260, the manufacturing device dices the wafer into a plurality of solid-state image capturing devices 961, and the manufacturing process ends.

As described above, the manufacturing device stacks and joins the sensor semiconductor element 881 and the semiconductor element 971 together in the form of wafers, and stacks and joins the cover glass 883, which functions as the support substrate, on the sensor semiconductor element 881, and thereafter performs the penetration electrode formation and the rewiring in order to mount the semiconductor element 885 which is diced in advance. Thereby, the sufficient strength is secured and the generation of the warpage is prevented, in order to improve the image capturing characteristics of the solid-state image capturing device 961.

### <Exemplary Variant 1 of Fourth Embodiment. Not covered by the scope of the claims. >

### <Exemplary Configuration of Solid-State Image Capturing Device>

Note that, in the solid-state image capturing device 961, the sensor semiconductor element 881 and the semiconductor element 971 may be joined by Cu-Cu connection utilizing Cu electrodes.

In that case, the solid-state image capturing device 961 is configured as illustrated in Fig. 58, for example. Note that, in Fig. 58, the corresponding parts in Fig. 51 are denoted with the same reference signs, and their description will be omitted as appropriate.

In the solid-state image capturing device 961 illustrated in Fig. 58, a plurality of Cu electrodes made of Cu are formed on the surface of the semiconductor element 971 side in the wiring layer 892 of the sensor semiconductor element 881. For example, a Cu electrode 1021-1 and a Cu electrode 1021-2 are formed in the wiring layer 892.

Note that, in the following, when the Cu electrode 1021-1 and the Cu electrode 1021-2 are unnecessary to be distinguished from each other particularly, they are also referred to as a Cu electrode 1021 simply.

Also, a plurality of Cu electrodes made of Cu are formed on the surface of the sensor semiconductor element 881 side in the wiring layer 982 for configuring the semiconductor element 971. For example, a Cu electrode 1022-1 and a Cu electrode 1022-2 are formed in the wiring layer 982.

Note that, in the following, when the Cu electrode 1022-1 and the Cu electrode 1022-2 are unnecessary to be distinguished from each other particularly, they are also referred to as a Cu electrode 1022 simply.

In the solid-state image capturing device 961, the Cu electrode 1021 formed in the wiring layer 892 of the sensor semiconductor element 881 and the Cu electrode 1022 formed in the wiring layer 982 of the semiconductor element 971 are connected to each other, in other words, the Cu electrodes are stacked and joined together, so that the sensor semiconductor element 881 and the semiconductor element 971 are connected to each other electrically. That is, the sensor semiconductor element 881 and the semiconductor element 971 are joined together.

Here, as the method for connecting Cu electrodes, i.e., the Cu electrode 1021 and the Cu electrode 1022 to each other, the method for connecting the surface of the wiring layer 892 of the sensor semiconductor element 881 and the oxide film formed on the surface of the wiring layer 982 of the semiconductor element 971 to each other may be utilized.

As described above, the sensor semiconductor element 881 and the semiconductor element 971 are connected electrically by Cu-Cu connection, so that the Cu electrode is provided as the connection part over the entire wafer, i.e., the entire surface of the sensor semiconductor element 881 and the semiconductor element 971. For example, the pixel section 893 of the sensor semiconductor element 881 is electrically connected to the semiconductor element 971 directly via the Cu electrode or the like, in order to reduce the transmission loss of data and improve the performance of the solid-state image capturing device 961.

### <Exemplary Variant 2 of Fourth Embodiment. Not covered by the scope of the claims. >

### <Exemplary Configuration of Solid-State Image Capturing Device>

Further, in the solid-state image capturing device 961, the semiconductor element 971 and the semiconductor element 885 may be connected to each other by Cu-Cu connection utilizing Cu electrodes.

In that case, the solid-state image capturing device 961 is configured as illustrated in Fig. 59, for example. Note that, in Fig. 59, the corresponding parts in Fig. 51 are denoted with the same reference signs, and their description will be omitted as appropriate.

In the solid-state image capturing device 961 illustrated in Fig. 59, the Cu electrode 1051-1 and the Cu electrode 1051-2 made of Cu are formed on the line 995-2 in the wiring layer 983 of the semiconductor element 971. Note that, in the following, when the Cu electrode 1051-1 and the Cu electrode 1051-2 are unnecessary to be distinguished from each other particularly, they are also referred to as a Cu electrode 1051 simply.

Also, the Cu electrode 1052-1 and the Cu electrode 1052-2 made of Cu are formed in the semiconductor element 885-1. Note that, in the following, when the Cu electrode 1052-1 and the Cu electrode 1052-2 are unnecessary to be distinguished from each other particularly, they are also referred to as a Cu electrode 1052 simply.

In the solid-state image capturing device 961, the semiconductor element 971 and the semiconductor element 885-1 are connected electrically, by connecting the Cu electrode 1051 formed in the wiring layer 983 and the Cu electrode 1052 formed in the semiconductor element 885-1 to each other, in other words, by stacking and joining the Cu electrodes together. That is, the semiconductor element 885-1 is mounted (joined) on the semiconductor element 971.

Here, as a method for connecting Cu electrodes, i.e., the Cu electrode 1051 and the Cu electrode 1052, thermocompression bonding, ultrasonic wave connection, formic acid reduction connection, or the like may be utilized. Also, the on-chip color filter and the on-chip lens for configuring the pixel section 893 have a poor heat resistance property, and therefore it is desirable that the connection temperature of the Cu electrode is equal to or smaller than 260 °C.

As described above, when connecting the semiconductor element 971 and the semiconductor element 885 by utilizing the Cu electrode, the miniaturization of the Cu electrode 1051 and the Cu electrode 1052 is easier than the miniaturization of the micro bump 907, and therefore the size of the semiconductor element 885 can be reduced. In addition, as the Cu electrode 1051 and the Cu electrode 1052 become small, the capacities of those Cu electrodes become small, and therefore the high-speed transmission of the data is easily achieved.

### <Exemplary Configuration of Image Capturing Device>

Further, an embodiment of the present technology is applicable generally to electronic devices using the solid-state image capturing device in the photoelectric conversion section, such as an image capturing device such as a digital still camera and a video camera, a portable terminal device having an image capturing function, and a copy machine using the solid-state image capturing device as an image reading unit. The solid-state image capturing device may be formed as one substrate, or may be formed as a module having an image capturing function and including an imaging unit and a signal processing unit or an optical system packaged therein.

Fig. 60 is a diagram illustrating an exemplary configuration of the image capturing device as an electronic device to which an embodiment of the present technology is applied.

The image capturing device 2001 of Fig. 60 includes an optical unit 2011 including a group of lenses, a solid-state image capturing device (an imaging device) 2012, and a digital signal processor (DSP) circuit 2013 which is a camera signal processing circuit. Also, the image capturing device 2001 includes a frame memory 2014, a display unit 2015, a recording unit 2016, an operation unit 2017, and a power supply unit 2018. The DSP circuit 2013, the frame memory 2014, the display unit 2015, the recording unit 2016, the operation unit 2017, and the power supply unit 2018 are connected to each other via a bus line 2019.

The optical unit 2011 receives an incoming light (an image light) from the subject and forms an image on the image capturing surface of the solid-state image capturing device 2012. The solid-state image capturing device 2012 converts the light amount of the incoming light, with which an image is formed on the image capturing surface by the optical unit 2011, to electrical signals for each pixel, and outputs them as pixel signals. This solid-state image capturing device 2012 corresponds to the solid-state image capturing devices described above, such as the solid-state image capturing device 11, the solid-state image capturing device 211, the solid-state image capturing device 391, the solid-state image capturing device 871, and the solid-state image capturing device 961.

The display unit 2015 includes panel display devices, such as a liquid crystal panel and an organic electro luminescence (EL) panel for example, and displays a moving image or a still image captured by the solid-state image capturing device 2012. The recording unit 2016 records a moving image or a still image captured by the solid-state image capturing device 2012 in a recording medium such as a video tape and a digital versatile disk (DVD).

The operation unit 2017 issues an operation command with respect to various functions of the image capturing device 2001, under the operation by the user. The power supply unit 2018 supplies various types of power supplies to supply targets, such as the DSP circuit 2013, the frame memory 2014, the display unit 2015, the recording unit 2016, and the operation unit 2017 as the operating power supplies thereof, as appropriate.

Note that, in the above embodiment, an example has been described in which an embodiment of the present technology is applied to a CMOS image sensor including pixels arranged in a matrix form for detecting a signal electric charge according to a light amount of a visible light as the physical quantity. However, the present technology is not limited to the application to the CMOS image sensor, but is applicable to solid-state image capturing devices generally.

### <Use Example of Solid-State Image Capturing Device>

Fig. 61 is a diagram illustrating a use example in which the above solid-state image capturing device (the image sensor) is used.

The above solid-state image capturing device may be used in various cases that senses a light, such as a visible light, an infrared light, an ultraviolet light, an X-ray for example, as in the following.
- A device that captures an image provided for viewing, such as a digital camera and a portable device with a camera function
- A device provided for traffic, such as an in-vehicle sensor for capturing an image of the front area, back area, surrounding area, and interior of a vehicle, a monitoring camera for monitoring running vehicles and roads, and a distance measuring sensor for measuring the distance between vehicles, for the purpose of safe driving such as automatic stop and recognition of driver's state
- A device provided for a home electrical appliance, such as a television, a refrigerator, and an air conditioner, which captures an image of the gesture of the user and performs a device operation in accordance with the gesture
- A device provided for medical care and healthcare, such as an endoscope and a device for capturing an image of blood vessels by receiving an infrared light
- A device provided for security, such as a monitoring camera for use in crime prevention, and a camera for use in person authentication
- A device provided for beauty care, such as a skin measuring device for capturing an image of skin and a microscope for capturing an image of scalp
- A device provided for sport, such as an action camera and a wearable camera for use in sport
- A device provided for agriculture, such as a camera for monitoring the state of farm and crop

### Reference Signs List

11 solid-state image capturing device
21 sensor semiconductor element
51 penetration via
53 land electrode
54 electrode
57 perpendicular signal line
71 logic semiconductor element
231 shield metal
291 shield metal
391 solid-state image capturing device
402 sensor semiconductor element
403 interposer substrate
404 semiconductor element
446 penetration via
447 penetration via
455 penetration via
881 sensor semiconductor element
882 semiconductor element
883 cover glass
885-1, 885-2, 885 semiconductor element
903-1, 903-2, 903 penetration electrode

## Claims

1. A back-side illuminated solid-state image capturing device comprising:
a first semiconductor substrate (21, 214) and a second semiconductor substrate (81), wherein the first
semiconductor substrate includes:
a first region (22, R11) having a photoelectric conversion section (67, 222), and a via portion (51, 224);
a second region (R12) adjacent to the first region (22, R11);
**characterized in that**
the first semiconductor substrate further includes
a connection portion (53) disposed on the surface of the second region (R12) that receives light,
and electrically couples the first semiconductor substrate to the second semiconductor substrate (81) in a stacked configuration, wherein the connection portion (53) is an electrode of a land structure including a first electrode (54, 226, 292) and a metal layer (55, 227, 293) provided in an upper portion of the first electrode between the first electrode and the second semiconductor substrate (81);
and **in that** a width of the connection portion (53) is greater than a width of the via portion.

2. The back-side illuminated solid-state image capturing device according to claim 1, wherein the first semiconductor substrate (21, 214) further includes a wiring layer (63, 64, 215, 216) provided on a surface of the first semiconductor substrate, and the via portion (51, 224) penetrates the first semiconductor substrate and is connected to a wiring provided in the wiring layer, and wherein a cross-section area of a portion of the via portion connected to the wiring in the wiring layer is less than a cross-section area of the connection portion that electrically couples the first semiconductor substrate to the second semiconductor substrate (81).

3. The back-side illuminated solid-state image capturing device according to claim 1 or claim 2, wherein a total area of the second semiconductor substrate (81) is less than a total area of the first semiconductor substrate (81), and wherein
a length and width of the second semiconductor substrate (81) is less than a respective length and width of the first semiconductor substrate (21; 214).

4. The back-side illuminated solid-state image capturing device according to claims 1 to 3, wherein the second semiconductor substrate (81) is mounted on the first semiconductor substrate (214) by connecting the connection portion (53) and a micro bump (85) provided on the second semiconductor substrate (81), and wherein a second electrode (223), the connection portion (53), and a connection wiring (225) connected to the first electrode (226) and the second electrode (223), wherein the second electrode is provided at an end of a surface side of the via portion (224), are formed in a wiring layer (216) provided at a surface side of the first semiconductor substrate (214) that receives light, and a groove that eliminates a step of the connection portion (53) relative to the connection wiring (225) and the second electrode is formed in a region directly below the connection portion in the first semiconductor substrate (214).

5. A method of manufacturing a back-side illuminated solid-state image capturing device according to claims 1-4, the method of manufacturing comprising:
forming the via portion (51,224) in the first semiconductor substrate (21, 214); and
mounting the second semiconductor substrate (81) on the first semiconductor substrate.

## Patentansprüche

1. Rückwärtig belichtete Festkörperbilderfassungsvorrichtung, die Folgendes umfasst:
ein erstes Halbleitersubstrat (21, 214) und ein zweites Halbleitersubstrat (81), wobei das erste Halbleitersubstrat Folgendes beinhaltet:
ein erstes Gebiet (22, R11) mit einem fotoelektrischen Umwandlungsabschnitt (67, 222) und einem Via-Teil (51, 224) ;
ein zweites Gebiet (R12) angrenzend an das erste Gebiet (22, R11),
**dadurch gekennzeichnet, dass**
das erste Halbleitersubstrat ferner Folgendes beinhaltet:
einen Verbindungsteil (53), der auf der Oberfläche des zweiten Gebiets (R12) angeordnet ist, das Licht empfängt, und das erste Halbleitersubstrat elektrisch mit dem zweiten Halbleitersubstrat (81) in einer gestapelten Konfiguration koppelt, wobei der Verbindungsteil (53) eine Elektrode einer Kontaktfleckstruktur einschließlich einer ersten Elektrode (54, 226, 292) und einer Metallschicht (55, 227, 293) ist, die in einem oberen Teil der ersten Elektrode zwischen der ersten Elektrode und dem zweiten Halbleitersubstrat (81) bereitgestellt ist;
und dadurch, dass eine Breite des Verbindungsteils (53) größer als eine Breite des Via-Teils ist.

2. Rückwärtig belichtete Festkörperbilderfassungsvorrichtung nach Anspruch 1, wobei
das erste Halbleitersubstrat (21, 214) ferner eine Verdrahtungsschicht (63, 64, 215, 216) beinhaltet, die auf einer Oberfläche des ersten Halbleitersubstrats bereitgestellt ist, und
der Via-Teil (51, 224) das erste Halbleitersubstrat durchdringt und mit einer Verdrahtung verbunden ist, die in der Verdrahtungsschicht bereitgestellt ist, und wobei eine Querschnittsfläche eines Teils des Via-Teils, der mit der Verdrahtung in der Verdrahtungsschicht verbunden ist, kleiner als eine Querschnittsfläche des Verbindungsteils ist, der das erste Halbleitersubstrat elektrisch mit dem zweiten Halbleitersubstrat (81) koppelt.

3. Rückwärtig belichtete Festkörperbilderfassungsvorrichtung nach Anspruch 1 oder Anspruch 2, wobei eine Gesamtfläche des zweiten Halbleitersubstrats (81) kleiner als eine Gesamtfläche des ersten Halbleitersubstrats (81) ist, und wobei
eine Länge und Breite des zweiten Halbleitersubstrats (81) kleiner als eine jeweilige Länge und Breite des ersten Halbleitersubstrats (21; 214) sind.

4. Rückwärtig belichtete Festkörperbilderfassungsvorrichtung nach Ansprüchen 1 bis 3, wobei das zweite Halbleitersubstrat (81) an dem ersten Halbleitersubstrat (214) durch den Verbindungsteil (53) und einen Mikrokontakthügel (85), der auf dem zweiten Halbleitersubstrat (81) bereitgestellt ist, montiert ist, und wobei
eine zweite Elektrode (223), der Verbindungsteil (53) und eine Verbindungsverdrahtung (225), die mit der ersten Elektrode (226)und der zweiten Elektrode (223) verbunden ist, wobei die zweite Elektrode auf einem Ende einer Oberflächenseite des Via-Teils (224) bereitgestellt ist, in einer Verdrahtungsschicht (216) gebildet sind, die auf einer Oberflächenseite des ersten Halbleitersubstrats (214) bereitgestellt ist, die Licht empfängt, und
eine Kerbe, die eine Stufe des Verbindungsteils (53) relativ zu der Verbindungsverdrahtung (225) und der zweiten Elektrode beseitigt, in einem Gebiet direkt unterhalb des Verbindungsteils in dem ersten Halbleitersubstrat (214) gebildet ist.

5. Verfahren zum Herstellen einer rückwärtig belichteten Festkörperbilderfassungsvorrichtung nach Ansprüchen 1-4,
wobei das Verfahren zum Herstellen Folgendes umfasst:
Bilden des Via-Teils (51, 224) in dem ersten Halbleitersubstrat (21, 214); und
Montieren des zweiten Halbleitersubstrats (81) auf dem ersten Halbleitersubstrat.

## Revendications

1. Dispositif de capture d'images à semi-conducteurs éclairé par l'arrière comprenant :
un premier substrat semi-conducteur (21, 214) et un deuxième substrat semi-conducteur (81), le premier substrat semi-conducteur comportant :
une première région (22, R11) ayant une section de conversion photoélectrique (67, 222), et une partie trou d'interconnexion (51, 224) ;
une deuxième région (R12) adjacente à la première région (22, R11) ;
**caractérisé en ce que**
le premier substrat semi-conducteur comporte en outre
une partie connexion (53) disposée sur la surface de la deuxième région (R12) qui reçoit la lumière, et couple électriquement le premier substrat semi-conducteur au deuxième substrat semi-conducteur (81) dans une configuration empilée, la partie connexion (53) étant une électrode d'une structure de plage d'accueil comportant une première électrode (54, 226, 292) et une couche métallique (55, 227, 293) disposée dans une partie supérieure de la première électrode entre la première électrode et le deuxième substrat semi-conducteur (81) ;
et **en ce qu'**une largeur de la partie connexion (53) est supérieure à une largeur de la partie trou d'interconnexion.

2. Dispositif de capture d'images à semi-conducteurs éclairé par l'arrière selon la revendication 1, dans lequel
le premier substrat semi-conducteur (21, 214) comporte en outre une couche de câblage (63, 64, 215, 216) disposée sur une surface du premier substrat semi-conducteur, et
la partie trou d'interconnexion (51, 224) pénètre dans le premier substrat semi-conducteur et est connectée à un câblage disposé dans la couche de câblage, et dans lequel
une aire de section transversale d'une partie de la partie trou d'interconnexion connectée au câblage dans la couche de câblage est inférieure à une aire de section transversale de la partie connexion qui couple électriquement le premier substrat semi-conducteur au deuxième substrat semi-conducteur (81).

3. Dispositif de capture d'images à semi-conducteurs éclairé par l'arrière selon la revendication 1 ou la revendication 2, dans lequel une aire totale du deuxième substrat semi-conducteur (81) est inférieure à une aire totale du premier substrat semi-conducteur (81), et dans lequel
une longueur et une largeur du deuxième substrat semi-conducteur (81) sont inférieures à une longueur et une largeur respectives du premier substrat semi-conducteur (21, 214).

4. Dispositif de capture d'images à semi-conducteurs éclairé par l'arrière selon les revendications 1 à 3, dans lequel
le deuxième substrat semi-conducteur (81) est monté sur le premier substrat semi-conducteur (214) par connexion de la partie connexion (53) et d'une microbosse (85) disposée sur le deuxième substrat semi-conducteur (81), et dans lequel
une deuxième électrode (223), la partie connexion (53) et un câblage de connexion (225) connecté à la première électrode (226) et la deuxième électrode (223), la deuxième électrode étant disposée à une extrémité du côté d'une surface de la partie trou d'interconnexion (224), sont formés dans une couche de câblage (216) disposée du côté d'une surface du premier substrat semi-conducteur (214) qui reçoit la lumière, et une rainure qui élimine une marche de la partie connexion (53) par rapport au câblage de connexion (225) et à la deuxième électrode est formée dans une région juste au-dessous de la partie connexion dans le premier substrat semi-conducteur (214).

5. Procédé de fabrication d'un dispositif de capture d'images à semi-conducteurs éclairé par l'arrière selon les revendications 1 à 4, le procédé de fabrication comprenant :
la formation de la partie trou d'interconnexion (51, 224) dans le premier substrat semi-conducteur (21, 214) ; et
le montage du deuxième substrat semi-conducteur (81) sur le premier substrat semi-conducteur.
